(19) Europäisches Patentamt
European Patent Office
Office européen des brevets

(11) **EP 4 598 319 A2**

(12) **EUROPEAN PATENT APPLICATION**

(43) Date of publication:
**06.08.2025 Bulletin 2025/32**

(21) Application number: **25153884.9**

(22) Date of filing: **24.01.2025**

(51) International Patent Classification (IPC):
**H10K 59/12** (2023.01)   **H10K 59/121** (2023.01)
**H10K 59/131** (2023.01)

(52) Cooperative Patent Classification (CPC):
**H10K 59/1315; H10K 59/1201; H10K 59/121;**
H10K 59/352; H10K 59/353; H10K 71/20;
H10K 71/231

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.01.2024  US 202418428136**

(71) Applicant: **Samsung Display Co., Ltd.
Gyeonggi-Do (KR)**

(72) Inventors:
• **LEE, Seho**
  **Yongin-si (KR)**
• **KIM, Taehyung**
  **Yongin-si (KR)**
• **LEE, Wonjun**
  **Yongin-si (KR)**
• **KIM, Cholho**
  **Yongin-si (KR)**

(74) Representative: **Marks & Clerk LLP
15 Fetter Lane
London EC4A 1BW (GB)**

(54) **DISPLAY DEVICE AND MANUFACTURING METHOD THEREOF**

(57)     A display device includes a substrate; a plurality of common voltage lines on the substrate; a plurality of connection electrodes on the plurality of common voltage lines; a plurality of pixel electrode sets spaced from the plurality of connection electrodes, each of the pixel electrode sets comprising a first pixel electrode, and a second pixel electrode, and a third pixel electrode to realize a full color pixel; an emission layer on the plurality of connection electrodes and the plurality of pixel electrode sets, the emission layer having a plurality of openings, each of the plurality of openings corresponding to a different respective one of the plurality of connection electrodes, a total number of the openings being 25% or less of a total number of the pixel electrode sets; and a common electrode on the emission layer, and electrically connected to the connection electrodes through the plurality of openings.

FIG. 2

**Description**

**BACKGROUND**

**1. Field**

The present disclosure relates to a display device, and to a manufacturing method thereof.

**2. Description of the Related Art**

A display device includes a display area including a plurality of pixels. Each pixel includes a pixel electrode (e.g., an anode), a plurality of transistors (e.g., a switching transistor and a driving transistor), a capacitor for storing a voltage corresponding to a data signal, and a common electrode (e.g., a cathode) opposite the pixel electrode. At least one layer (e.g., an emission layer) is positioned between the pixel electrode and the common electrode.

The common electrode may be formed as one electrode (e.g., a single continuous electrode) over the plurality of pixels and is coupled to a voltage source (e.g., a common voltage source having a constant voltage). When the pixels are current driven, a pixel current from a driving transistor is provided through a pixel from the pixel electrode to the common electrode of the pixel, whereby light corresponding to the data signal is emitted by an emission layer of the pixel.

The above information disclosed in this Background section is only for enhancement of understanding of the background of the present disclosure, and therefore it may contain information that does not form the prior art that is already known to a person of ordinary skill in the art.

**SUMMARY**

A common electrode formed over a plurality of pixels may be electrically connected to an underlying auxiliary electrode through an opening formed in an emission layer positioned between the common electrode and the auxiliary electrode.

Embodiments of the present disclosure may reduce an IR-drop associated with the common electrode while reducing a manufacturing process time (e.g., a takt time) and improving a uniformity of luminance of the display area to such an extent that irregularities (e.g., mura) are either less visible or not visible.

According to one or more embodiments of the present disclosure, a display device includes: a substrate; a plurality of common voltage lines on the substrate; a plurality of connection electrodes on the plurality of common voltage lines, at least one of the plurality of connection electrodes being electrically connected to a corresponding one of the plurality of common voltage lines; a plurality of pixel electrode sets spaced from the plurality of connection electrodes, each of the pixel electrode sets including a first pixel electrode, a second pixel electrode, and a third pixel electrode to realize a full color pixel; an emission layer on the plurality of connection electrodes and the plurality of pixel electrode sets, the emission layer having a plurality of openings, each of the plurality of openings corresponding to a different respective one of the plurality of connection electrodes, a total number of the openings being 25% or less of a total number of the pixel electrode sets; and a common electrode on the emission layer, and electrically connected to the connection electrodes through the plurality of openings.

According to one or more embodiments, the plurality of openings may include laser drilled holes (i.e., laser drill holes, LD holes, or LD openings).

According to one or more embodiments, the total number of the openings may be in a range of 700 to 3,700,000.

According to one or more embodiments, the total number of the openings may be in a range of 57,000 to 920,000.

According to one or more embodiments, a distance between nearest ones of the openings may be in a range of about 1.1 mm to about 20 mm.

According to one or more embodiments, the plurality of pixel electrode sets may include a plurality of groups of pixel electrode sets. Each of the plurality of groups of pixel electrode sets may include a plurality of subgroups of pixel electrode sets. In some examples, only one of the subgroups in one of the groups may have corresponding ones of the openings.

According to one or more embodiments, the subgroups in the plurality of groups of pixel electrode sets having corresponding ones of the openings may define hole-forming areas, and a width of one of the hole-forming areas may be equal to a distance between two nearest ones of the hole-forming areas.

According to one or more embodiments, a number of the plurality of subgroups in one of the groups of pixel electrode sets may be in a range of 4 to 64.

According to one or more embodiments, a ratio between a total number of pixel electrode sets and a total number of openings in one of the subgroups may be in a range of 1 to 64.

According to one or more embodiments, the plurality of groups of pixel electrode sets may be arranged in a matrix.

According to one or more embodiments, the plurality of subgroups of the pixel electrode sets in each of the plurality of groups may be arranged in a matrix.

According to one or more embodiments, the display device may include a 65-inch display panel, and the total number of the openings may be in a range of 57,000 to 920,000.

According to one or more embodiments, a ratio between the total number of the pixel electrode sets and the total number of the openings may be in a range of 4 to 5,184.

According to one or more embodiments, a ratio between the total number of the openings and the total number of the pixel electrode sets may be in a range of 1/144 to 1/9.

According to one or more embodiments, a largest width of one of the openings may be in a range of about 1 $\mu$m to about 30 $\mu$m. The largest width of the one of the openings may be at least about 3 $\mu$m. The largest width of the one of the openings may be a range of about 4 $\mu$m to about 7 $\mu$m. The largest width of the one of the openings may be in a range of about 4 $\mu$m to about 5 $\mu$m. The largest width of the one of the openings may be in a range of about 3 $\mu$m to about 20 $\mu$m.

According to one or more embodiments, a contact resistance of one of the openings may be in a range of about 1 $\Omega$ to about 1,000 $\Omega$.

According to one or more embodiments, a thickness of the common electrode may be in a range of about 40 Å to about 200 Å. The thickness of the common electrode may be in a range of about 50 Å to about 140 Å.

According to one or more embodiments, the common electrode may include Yb Ag:Mg.

According to one or more embodiments, the common electrode may have a sheet resistance of about 9.7 $\Omega/\square$ (Ohms per square) to about 50 $\Omega/\square$. The common electrode may have a thickness in a range of about 40 Å to about 140 Å.

According to one or more embodiments, the common electrode may have a sheet resistance of less than about 32 $\Omega/\square$.

According to one or more embodiments, a resistance of one of the common voltage lines from one end to an opposite end of the display device may be in a range of about 0.03 $\Omega$ to about 0.4 $\Omega$.

According to one or more embodiments, one of the common voltage lines may include a plurality of layers of metals.

According to one or more embodiments of the present disclosure, a display device includes: a substrate; a plurality of common voltage lines on the substrate; a plurality of connection electrodes on the plurality of common voltage lines, at least one of the plurality of connection electrodes being electrically connected to a corresponding one of the plurality of common voltage lines; a plurality of pixel electrode sets spaced from the plurality of connection electrodes, each of the pixel electrode sets including a first pixel electrode, a second pixel electrode, and a third pixel electrode to realize a full color pixel; an emission layer on the plurality of connection electrodes and the plurality of pixel electrode sets, the emission layer having a plurality of openings; and a common electrode on the emission layer, and electrically connected to the connection electrodes through the plurality of openings, wherein an IR-drop of the display device is less than or equal to about 0.80 volts.

According to one or more embodiments, the IR-drop of the display device may be in a range of about 0.40 volts to about 0.80 volts. The IR-drop of the display device may be in a range of about 0.4567 volts to about 0.7920 volts. The IR-drop of the display device may be in a range of about 0.50 volts to about 0.75 volts. The IR-drop of the display device may be in a range of about 0.60 volts to about 0.70 volts.

According to one or more embodiments, the IR-drop may conform with an output of an equation, where IR-drop = $((2.083 * x4) - (7.1e^{-03} * x3) - (4.94e^{-05} * x2) + (1.758e^{-05} * x2 * x3) + (4.3e^{-03} * x1 * x4) + 0.266 + (3.544e^{-04} * x3^2) - (0.18 * x4^2)) * I / (1\mu * $ Horizontal Resolution $*$ Vertical Resolution), wherein: I is a panel current; x1 is a resistance through one of the plurality of openings; x2 is a sheet resistance of the common electrode; x3 is an interval between nearest ones of the plurality of openings; and x4 is a resistance of one of the common voltage lines.

According to one or more embodiments, a display device includes: a substrate; a plurality of common voltage lines on the substrate; a plurality of connection electrodes on the plurality of common voltage lines, at least one of the plurality of connection electrodes being electrically connected to a corresponding one of the plurality of common voltage lines; a plurality of pixel electrode sets spaced from the plurality of connection electrodes, each of the pixel electrode sets including a first pixel electrode, a second pixel electrode, and a third pixel electrode to realize a full color pixel; an emission layer on the plurality of connection electrodes and the plurality of pixel electrode sets, the emission layer having a plurality of openings, a largest width of one of the openings being in a range of about 1 $\mu$m to about 30 $\mu$m; and a common electrode on the emission layer, and electrically connected to the connection electrodes through the plurality of openings.

According to one or more embodiments, the plurality of openings may include laser drilled holes (i.e., laser drill holes, LD holes, or LD openings).

According to one or more embodiments, the largest width of the one of the openings may be at least about 3 $\mu$m. The largest width of the one of the openings may be in a range of about 4 $\mu$m to about 7 $\mu$m. The largest width of the one of the openings may be in a range of about 4 $\mu$m to about 5 $\mu$m. The largest width of the one of the openings may be in a range of about 3 $\mu$m to about 20 $\mu$m.

According to one or more embodiments of the present disclosure, a display device includes: a substrate; a plurality of common voltage lines on the substrate; a plurality of connection electrodes on the plurality of common voltage lines, at least one of the plurality of connection electrodes being electrically connected to a corresponding one of the plurality of common voltage lines; a plurality of pixel electrode sets spaced from the plurality of connection electrodes, each of the pixel electrode sets including a first pixel electrode, a second pixel electrode, and a third pixel electrode to realize a full color pixel; an emission layer on the plurality of connection electrodes and the plurality of pixel electrode sets, the emission layer having a plurality of openings; and a common electrode on the emission layer, and electrically connected to the connection electrodes through the plurality of openings, the common electrode having a thickness in a range of about 60 Å to about 140 Å.

According to one or more embodiments, a thickness of the common electrode may be in a range of about 70 Å to about 140 Å.

According to one or more embodiments, the common electrode may have a sheet resistance of about 9.7 $\Omega/\square$ to about 50 $\Omega/\square$.

According to one or more embodiments, the common electrode may have a sheet resistance of less than about 32 $\Omega/\square$.

According to one or more embodiments of the present disclosure, a display device includes: a substrate; a plurality of auxiliary voltage lines on the substrate, a resistance of one of the auxiliary voltage lines from one end to an opposite end of the display device being in a range of about 0.003 $\Omega$ to about 0.4 $\Omega$; a plurality of connection electrodes on the plurality of auxiliary voltage lines, at least one of the plurality of connection electrodes being electrically connected to a corresponding one of the plurality of auxiliary voltage lines; a plurality of pixel electrode sets spaced from the plurality of connection electrodes, each of the pixel electrode sets including a first pixel electrode, a second pixel electrode, and a third pixel electrode to realize a full color pixel; an emission layer on the plurality of connection electrodes and the plurality of pixel electrode sets, the emission layer having a plurality of openings; and a common electrode on the emission layer, and electrically connected to the plurality of connection electrodes through the plurality of openings.

According to one or more embodiments, the resistance of the one of the auxiliary voltage lines may be in a range of about 0.03 $\Omega$ to about 0.4 $\Omega$.

According to one or more embodiments, the plurality of auxiliary voltage lines may include a plurality of first common voltage lines and a plurality of backplane metal lines extending in a same direction as the plurality of first common voltage lines, one of the plurality of backplane metal lines being electrically connected to a corresponding one of the plurality of first common voltage lines via openings in a first insulation layer located therebetween.

According to one or more embodiments, the plurality of auxiliary voltage lines may further include a plurality of second common voltage lines located between the plurality of first common voltages lines and the plurality of connection electrodes in a thickness direction of the substrate, one of the plurality of second common voltage lines being electrically connected to a corresponding one of the plurality of first common voltage lines via openings in a second insulation layer located therebetween.

According to one or more embodiments, one of the plurality of auxiliary voltage lines may include a plurality of overlapping common voltages lines spaced from each other in a thickness direction of the substrate, the display device further including an insulation layer between two adjacent ones of the plurality of overlapping common voltage lines in the thickness direction, the two adjacent ones of the plurality of overlapping common voltage lines being electrically connected with each other via openings in the insulation layer.

According to one or more embodiments, the plurality of overlapping common voltage lines may include at least three overlapping common voltage lines that are overlapped with and electrically connected with each other in the thickness direction of the substrate. At least some of the above and other features of the invention are set out in the claims.

## BRIEF DESCRIPTION OF THE DRAWINGS

FIG. 1A is a schematic top plan view depicting one pixel including one pixel electrode set (each including three pixel electrodes) and common voltage lines, according to one or more embodiments of the present disclosure.

FIG. 1B is a schematic top plan view of a plurality of pixels, each including a corresponding one of a plurality of pixel electrode sets (each including three pixel electrodes), according to one or more embodiments of the present disclosure.

FIG. 2 is a schematic cross-sectional view along the line I-I' of the pixel of a display panel shown in FIG. 1A, according to one or more embodiments of the present disclosure.

FIGS. 3A-3D are graphs depicting how different parameters affect IR-drop characteristics, based on simulations performed according to one or more embodiments of the present disclosure.

FIGS. 4A-4D are graphs depicting normalized versions of the graphs of FIGS. 3A-3D.

FIG. 5A is a graph depicting a change in sheet resistances of a common-electrode material including ytterbium (Yb) and silver-magnesium (Ag:Mg) based on a range of common electrode thicknesses from 40 angstroms (Å) to 140 angstroms (Å), according to one or more embodiments of the present disclosure.

FIG. 5B is a chart depicting differences in efficiencies associated with red, green, blue, and white light based on different common electrode thicknesses.

FIG. 5C is a picture depicting a luminance of a display having a common electrode thickness of about 60 angstroms (Å).

FIG. 5D is a picture depicting a luminance of a display having a common electrode thickness of about 80 angstroms (Å).

FIG. 6A is a graph depicting common electrode sheet resistances for different materials and thicknesses, according to some embodiments of the present disclosure.

FIG. 6B is a graph depicting common electrode sheet resistances for different materials and thicknesses, according to some embodiments of the present disclosure.

FIG. 7A is a schematic plan view of an emission-layer opening formed in an emission layer, according to one or more embodiments of the present disclosure.

FIG. 7B is a schematic cross-sectional view of the emission-layer opening formed in the emission layer depicted in FIG. 7A, according to one or more embodiments of the present disclosure.

FIG. 7C is three focused ion beam (FIB) images of outer widths and inner widths associated with three different emission-layer openings of experimental examples, in accordance with one or more embodiments of the present disclosure.

FIG. 8A and FIG. 8B are schematic diagrams depicting a display having holes drilled (e.g., laser drilled) at a substantially constant interval throughout a display area of the display, according to one or more embodiments of the present disclosure.

FIG. 8C and FIG. 8D are schematic diagrams depicting a display having holes drilled according to a pattern (e.g., a chess pattern) associated with subgroups of pixel electrode sets, according to one or more embodiments of the present disclosure.

FIG. 8E, FIG. 8F, and FIG. 8G schematically depict variations of the pattern (e.g., the chess pattern) associated with subgroups of pixel electrode sets, according to one or more embodiments of the present disclosure.

FIG. 8H is a chart of pixel and hole parameters corresponding to a 65-inch display, according to one or more embodiments of the present disclosure.

FIG. 9 is a chart of pixel and hole parameters corresponding to different sizes and types of displays, according to one or more embodiments of the present disclosure.

FIGS. 10A-10E are schematic top views of layers of a display device, according to one or more embodiments of the present disclosure.

FIG. 11A is a schematic cross-sectional view of a display device including a common voltage line on one layer, according to one or more embodiments of the present disclosure.

FIG. 11B is a schematic cross-sectional view of a display device including common voltage lines on two layers, according to one or more embodiments of the present disclosure.

FIG. 11C is a schematic cross-sectional view of a display device including common voltage lines on three layers, a first common voltage line being connected to a backplane-metal layer, according to one or more embodiments of the present disclosure.

FIG. 11D is a schematic cross-sectional view of a display device including common voltage lines on three layers, a first common voltage line being unconnected with respect to a backplane-metal layer, according to one or more embodiments of the present disclosure.

FIG. 12A is a schematic top plan view of some of the layers of a display device, according to one or more embodiments of the present disclosure.

FIG. 12B is a schematic cross-sectional view of some of the layers of the display device shown in FIG. 12A taken along the line A-A', according to one or more embodiments of the present disclosure.

FIG. 13A is a schematic top plan view of the layers of a display device, according to one or more embodiments of the present disclosure.

FIG. 13B is a schematic cross-sectional view of some of the layers of the display device shown in FIG. 13A taken along the line B-B', according to one or more embodiments of the present disclosure.

FIG. 14 is a schematic diagram depicting components of a display panel associated with measuring backplane wiring resistance, according to one or more embodiments of the present disclosure.

FIG. 15 is a graph depicting an IR-drop scatter plot, according to one or more embodiments of the present disclosure.

FIG. 16 is a table illustrating a relationship between four parameters and an IR-drop, according to one or more embodiments of the present disclosure.

FIG. 17 depicts example operations of a method for manufacturing a display panel, according to one or more embodiments of the present disclosure.

FIG. 18A and FIG. 18B illustrate display panels configured for measuring luminance and/or color coordinates to determine IR-drop, according to one or more embodiments of the present disclosure.

FIGS. 19A-19D are graphs of luminance and color coordinates with respect to ELVDD, according to one or more embodiments of the present disclosure.

FIG. 20 is a table of results from luminance measurements taken at 9 points on a display panel to determine Long Range Uniformity (LRU), according to one or more embodiments of the present disclosure.

FIG. 21 is a schematic diagram of a display panel showing 9 points where the luminance measurements of FIG. 20 are taken, according to one or more embodiments of the present disclosure.

FIG. 22 is a contour map of luminance measurements, according to one or more embodiments of the present disclosure.

## DETAILED DESCRIPTION

Aspects of one or more embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in various different forms, and should not be construed as being limited to only the illustrated embodiments herein. Rather, these embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form in order to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XY, YZ, and XZ, or any variation thereof. Similarly, the expression such as "at least one of A and B" may include A, B, or A and B. As used herein, "or" generally means "and/or," and the term "and/or" includes any and all combinations of one or more of the associated listed items. For example, the expression such as "A and/or B" may include A, B, or A and B.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

In the examples, the X-axis, the Y-axis, and/or the Z-axis are not limited to three axes of a rectangular coordinate system, and may be interpreted in a broader sense. For example, the X-axis, the Y-axis, and the Z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value. Further, the use of "may" when describing embodiments of the present disclosure refers to "one or more embodiments of the present disclosure."

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would have basis in the present application as filed.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Because every conductor at room temperature has a non-zero resistance R, when current I passes through the conductor, voltage drop (i.e., IR-drop) occurs. In a display device, because a driving voltage (or driving voltages) is usually provided from one or more of the edges, pixels that are located further from the edges (e.g., pixels that are near a central region) are affected by higher voltage drop (i.e., IR-drop) than pixels that are closer to the edges (or to a source or drain of the driving current). As such, non-uniformity of brightness may result due to different respective IR-drops experienced by different pixels located at different locations on the display device. In the manufacturing of mid- to large-sized display devices (e.g., top emission organic light-emitting diode (OLED) display devices), it may be difficult to increase the size of the display device due to IR-drop issues over a display area (e.g., IR-drop associated with a cathode electrode (also referred to as a "common electrode")), which is generally formed across an entire display area of the display device and shared by the pixels of the display device. The IR-drop issues may result in visible irregularities (e.g., "mura"), and a reduction in long range uniformity (LRU). The common electrode may be formed as a thin cathode electrode to serve as a conduction electrode over an area (e.g., a very large area or an entire display area) corresponding to the pixels of the display device. The cathode electrode may have a transmittance that is suitable for transmitting light through the cathode electrode for top emission applications. The cathode electrode may have transparent or semi-transparent qualities resulting from its dimensions and from the materials from which it is formed.

To address the IR-drop issues, the cathode electrode may be made (e.g., formed) to contact auxiliary wiring (e.g., common voltage lines), to which a power source voltage (e.g., an ELVSS voltage) is applied, at multiple locations in a display area of the display device. The auxiliary wiring (e.g., common voltage lines) may be connected to a backplane wiring (e.g., a backplane metal layer (BML)) of the display device through one or more insulation layers located therebetween. To allow for contact between the cathode electrode and the auxiliary wiring, openings may be formed in an emission layer (e.g., an emitting layer, a luminous evaporation layer, or an organic emission layer) that is formed between the auxiliary wiring and the cathode electrode. The emission layer openings may be formed by removing portions of the emission layer with a laser (e.g., with laser drilling (LD) technology).

While the emission layer will be described herein primarily as a single layer, the emission layer may also be referred to as an intermediate layer (e.g., a layer or layers between a cathode and an anode) and may include one or more of layers such as, for example, but not limited to, a hole injection layer (HIL), a hole transport layer (HTL), an organic light emission layer, an electron transport layer (ETL), and/or an electron injection layer (EIL). In one or more embodiments, the emission layer may have a tandem structure, in which a plurality of light emission layers and/or other layers are stacked between a cathode and an anode.

Aspects of one or more embodiments of the present disclosure provide for improvements to LD hole to improve takt time (e.g., an amount of time during which a product is assembled to meet a demand for the product). For example, by reducing the number of LD holes in manufacturing a display device, the amount of time for product assembly may be reduced, which, in turn, may improve takt time.

Aspects of one or more embodiments of the present disclosure provide suitable conditions or values (e.g., optimal conditions or values) for each of four parameters (e.g., cathode electrode sheet resistance, laser drilled (LD) hole contact resistance, LD hole distance, and backplane (BP) wiring resistance) that affect an IR-drop and that affect display characteristics of display devices. One or more embodiments of the present disclosure also provide an equation that defines relationships between the four parameters and the IR-drop.

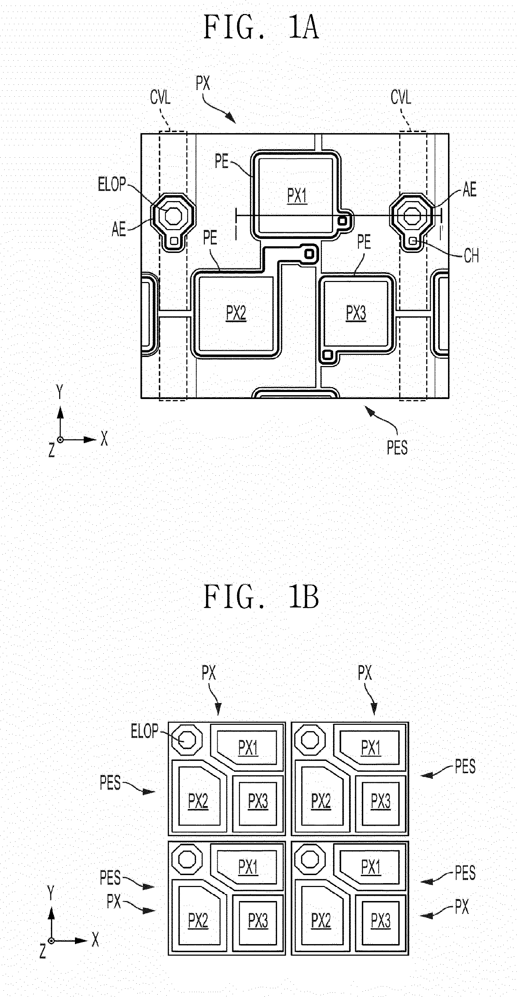

FIG. 1A is a schematic top plan view depicting one pixel including one pixel electrode set (each including three pixel electrodes) and common voltage lines, according to one or more embodiments of the present disclosure.

FIG. 1B is a schematic top plan view of a plurality of pixels, each including a corresponding one of a plurality of pixel electrode sets (each including three pixel electrodes), according to one or more embodiments of the present disclosure.

Referring to FIGS. 1A and 1B, a display device (e.g., a display panel) may include a plurality of pixels PX capable of displaying (i.e., configured to display) an image. As used herein, the terms display device and the display may be used interchangeably, and may be or may be included in a television, a computer, a computer monitor, a mobile phone, a portable device, a tablet, a game console, a navigation device, and/or the like. According to one or more embodiments, a display panel may be a component of a display device, which may include other components such as a memory, input/output devices, one or more processors, and one or more communication modules, and any other suitable components as a person of ordinary skill in the art would appreciate. Alternatively, the terms "display device" and "display panel" may be used interchangeably.

The plurality of pixels PX may be approximately arranged in a matrix form (e.g., may be arranged in rows and columns), but is not limited thereto, and may be repeatedly arranged according to a certain rule (e.g., according to a corresponding suitable layout scheme). The display device may include any suitable electronic device having the ability to display an image. For example, televisions, computers, computer monitors, mobile phones, portable devices, tablets, game consoles, navigation devices, and/or the like may include a display panel for displaying an image.

In one or more embodiments, each pixel PX may include a plurality of sub-pixels PX1, PX2, and PX3. The sub-pixels PX1, PX2, and PX3 included in each pixel PX may display lights of different colors. For example, the sub-pixels PX1, PX2, and PX3 may display primary colors, such as red (R), green (G), and blue (B). The sub-pixels PX1, PX2, and PX3 together may display (or express) various colors by combining various luminances of different primary colors. In one or more embodiments, each pixel PX may include four or more sub-pixels, which may correspond to red (R), green (G), blue (B), and white (W) sub-pixels, and or any other suitable combinations of red (R), green (G), blue (B), and white (W) sub-pixels, which may include more than one sub-pixel having a same color.

The sub-pixels PX1, PX2, and PX3 may include respective pixel electrodes PE (e.g., anodes) to which driving currents from respective driving transistors are applied. When a desired data signal corresponding to a gray level to be represented is applied to the sub-pixel PX1, PX2, or PX3, a capacitor in the sub-pixel stores a voltage corresponding to the desired data signal, and the driving transistor provides a corresponding driving current through the sub-pixel from the pixel electrode PE to a common electrode (e.g., a cathode electrode) in accordance with the stored voltage, whereby light is generated and emitted by an emission layer interposed between the pixel electrode PE and the common electrode. By emitting respective color lights from the three sub-pixels PX1, PX2, and PX3, a full color display may be realized. The pixel electrodes PE may be positioned on (or at) the same layer. The pixel electrodes PE may include the same material. The pixel electrodes PE corresponding to a same pixel PX together may be referred to as a pixel electrode set PES. By way of example, each pixel PX may include an emission layer located (or formed) between a common electrode and one pixel electrode set PES including three pixel electrodes PE corresponding to three color sub-pixels that are configured to emit red (R), green (G), and blue (B) color lights, respectively. The display device may include a plurality of pixel electrode sets PES. While the term "emission layer" is generally used in reference to an emission layer located at each sub-pixel, according to one or more embodiments, the emission layers located at different sub-pixels of each pixel may be configured to emit respective color lights (e.g., red (R), green (G), blue (B) and/or white (W) color lights) to realize a full color display.

The display device according to one or more embodiments includes a plurality of common voltage lines CVL, which may also be referred to as auxiliary lines or ELVSS lines, and a plurality of auxiliary electrodes AE (e.g., a plurality of connection electrodes) for transmitting a common voltage (e.g., ELVSS voltage).

The common voltage line CVL may extend lengthwise (e.g., in the Y direction). The common voltage line CVL may be arranged one by one, at least, for each pixel PX (e.g., along the X direction). FIG. 1A shows an example in which one common voltage line CVL is positioned for every pixel PX along the X direction (e.g., there may be one common voltage line CVL for multiple pixels PX arranged in the Y direction). According to one or more embodiments, the display device may include a plurality of common voltage lines that are located on (or at) different layers with one or more insulation layers located therebetween. The common voltage lines located on (or at) different layers may extend in the same direction and may at least partially overlap each other (e.g., at least partially overlap in a thickness direction of the display device or a substrate thereof), and may be electrically connected to each other through one or more openings formed in the one or more insulation layers located therebetween.

In one or more embodiments, there may be at least one auxiliary electrode AE for each pixel PX in the X direction or the Y direction. FIG. 1A and FIG. 1B show examples in which one auxiliary electrode AE is formed for each pixel PX in each of the X direction and the Y direction. However, the present disclosure is not limited thereto.

The auxiliary electrode AE may be located in a conductive layer that is different from that of the common voltage line CVL. At least a portion of each auxiliary electrode AE may overlap a corresponding common voltage line CVL in the Z direction (e.g., in the thickness direction of the display device) that is substantially perpendicular to the X and Y directions. The portion of the auxiliary electrode AE overlapping the common voltage line CVL may be electrically connected to the common voltage line CVL through an opening of at least one insulation layer positioned between the common voltage line CVL and the auxiliary electrode AE. As discussed in further detail below, the auxiliary electrode AE may overlap with an emission-layer opening ELOP in an emission layer associated with each pixel PX.

The emission-layer openings ELOP may be positioned on, or may overlap, a portion of a plurality of auxiliary electrodes AE. According to one or more embodiments, one emission-layer opening ELOP (i.e., laser drill hole or laser drilled hole) is provided for each pixel, a column of emission-layer openings ELOP is provided for each common voltage line CVL, and a column of auxiliary electrodes AE electrically connects each common voltage line CVL to the common electrode. However, the present disclosure is not limited thereto. As discussed in further detail below, the pitches of the emission layer openings ELOP in the X and the Y directions (e.g., the distance between respective emission layer openings in the X and the Y directions) may be greater than the pitch of the pixels PX in the X and Y directions, respectively. The pitch of the emission-layer openings ELOP (e.g., the number of pixels between nearest emission-layer openings ELOP) in the X direction may be the same as, or different from, the pitch of the emission-layer openings ELOP (e.g., the number of pixels between nearest emission-layer openings ELOP) in the Y direction.

In one or more embodiments, the X-direction pitch (e.g., in millimeters (mm)) of the emission layer openings ELOP may be greater than the pitch in the X-direction of a plurality of common voltage lines CVL, and, for example, may be an integer multiple thereof. In addition, the X-direction pitch (e.g., in mm) of the emission layer openings ELOP may be greater than the pitch of a plurality of auxiliary electrodes AE in the X-direction, and, for example, may be an integer multiple thereof.

In one or more embodiments, some columns of auxiliary electrodes AE may not correspond to (e.g., may not overlap with) any emission-layer openings ELOP. In one or more embodiments, common voltage lines CVL may not be formed at one or more columns that are not aligned (e.g., overlapping) with emission layer openings ELOP. Furthermore, the common voltage lines CVL may be formed to have the same pitch as the emission layer openings ELOP in the X direction.

In one or more embodiments, at least some of the auxiliary electrodes AE that are not electrically connected to the common voltage line CVL, or the auxiliary electrodes AE that do not overlap with the emission layer opening ELOP, may be omitted. The planar shape of the emission-layer openings ELOP may vary. For example, the planar shapes of the emission-layer openings ELOP may be circular shapes, elliptical shapes, polygonal shapes, and/or the like. Also, as can be seen in FIGS 1A and 1B, the shape of the auxiliary electrode AE and sub-pixels (e.g., pixel electrodes PE) may be different in different embodiments. In FIG. 1A, the auxiliary electrode AE includes an extension portion, which may be used for electrical connection with a common voltage line CVL located below. In FIG. 1B, the auxiliary electrode does not include an extension portion, and may be electrically connected to a common voltage line CVL at a location below the emission layer opening ELOP. In various embodiments, arrangements, sizes, and shapes of pixels, sub-pixels, pixel electrodes, and/or the like may be different in a suitable manner as a person of ordinary skill in the art would appreciate.

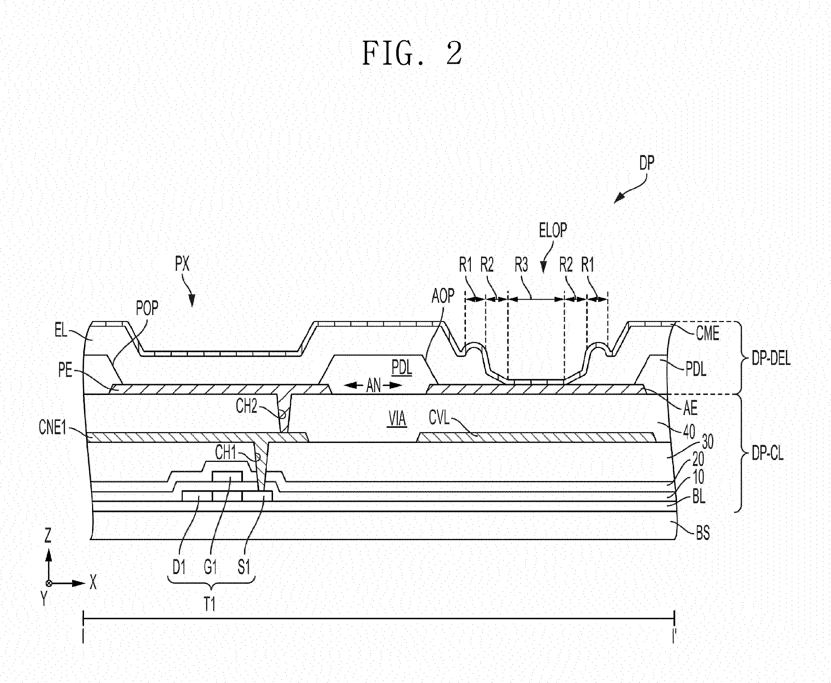

FIG. 2 is a schematic cross-sectional view along the line I-I' of the pixel PX of a display panel (or a display device) shown in FIG. 1A, according to one or more embodiments of the present disclosure.

Referring to FIG. 2, in one or more embodiments, the display panel DP may include a base substrate BS, a circuit layer DP-CL, and a display element layer DP-DEL. The circuit layer DP-CL may be formed on the base substrate BS.

The circuit layer DP-CL may include a buffer layer BL, a transistor T1 (e.g., a driving transistor), a first connection electrode CNE1, and a common voltage line CVL (e.g., auxiliary wiring or power source wiring), and a plurality of insulation layers (e.g., a first insulation layer 10, a second insulation layer 20, a third insulation layer 30, and a fourth insulation layer 40). In one or more embodiments, the fourth insulation layer 40 may include a via layer VIA. The transistor T1 may include a gate electrode G1, a drain D1, and a source S1.

The display element layer DP-DEL may include a pixel electrode PE, and an auxiliary electrode AE (e.g., a second connection electrode). The pixel electrode PE and the auxiliary electrode AE may be on (or at) a same layer and may correspond to an anode layer AN of the display panel DP. The display element layer DP-DEL may also include a pixel defining layer PDL, an emission layer EL, and a common electrode CME (e.g., a cathode layer, which is shared by a plurality of the pixels). The pixel electrode PE may be located at a pixel opening POP of the pixel defining layer PDL, along with a portion of the emission layer EL and a portion of the common electrode CME. The pixel electrode PE, the emission layer EL and the common electrode CME may work in conjunction to emit light from the pixel PX.

The auxiliary electrode AE may be located at (e.g., may overlap in a thickness direction of the base substrate BS and may be located below) an auxiliary opening AOP of the pixel defining layer PDL. The auxiliary electrode AE may work in conjunction with the common voltage line CVL to provide a power source voltage ELVSS to the common electrode CME. The emission-layer opening ELOP may be formed in the emission layer EL. The emission-layer opening ELOP may be formed with a laser (e.g., a Gaussian laser) using laser drilling (LD) technology, and may be referred to as a laser drill hole, a laser drilled hole, or an LD hole. In one or more embodiments, the emission layer EL may be completely ablated in (or at) a center region (e.g., a third region R3). The laser may have a Gaussian beam shape, wherein the intensity (or strength) of the laser is not as strong in (or at) an edge or peripheral area of the beam as it is in the center of the beam. The emission-layer opening ELOP may, thus, be surrounded by a first region R1 and a second region R2, which are sloped due to the intensity variance of the beam. It can be seen in FIG. 2 that the first region R1 has a bump shape (e.g., a sloping shoulder shape or a shoulder shape), such that its height is greater than that of an immediately surrounding region of the first region R1. Such bump or height difference is created because an emission layer material (e.g., an emission layer material from the second region R2) is pushed out toward an edge or periphery of the emission-layer opening ELOP by the power of the laser rather than being ablated. While not shown in the cross-sectional view of FIG. 2, the auxiliary electrode AE may be connected to the common voltage line CVL through a contact hole CH of FIG. 1A, for example. The common electrode CME may be formed over the emission layer EL. Multiple holes may be drilled at the same time using a single laser beam that has a Gaussian beam shape that is split multiple ways.

A UV laser may be used to form the emission-layer openings ELOP. For example, the laser may be a Q-switched (DPSS) neodymium-doped yttrium aluminum garnet (Nd:YAG) laser. However, the present disclosure is not limited thereto, and any other suitable laser or lasers may be used as a person of ordinary skill in the art would appreciate.

The common electrode CME may contact the auxiliary electrode AE through the emission-layer opening ELOP. The contact between the common electrode CME and auxiliary electrodes AE at multiple positions may cause an IR-drop (e.g., an IR-drop across the common electrode CME) to be reduced. By reducing the IR-drop, a uniformity of luminance of the display area may be improved. As discussed in further detail below, parameters associated with the emission-layer opening ELOP and the contact between the common electrode CME and the auxiliary electrode AE may be selected (e.g., implemented in the display panel DP) to improve (e.g., to optimize) the display characteristics of the display panel DP.

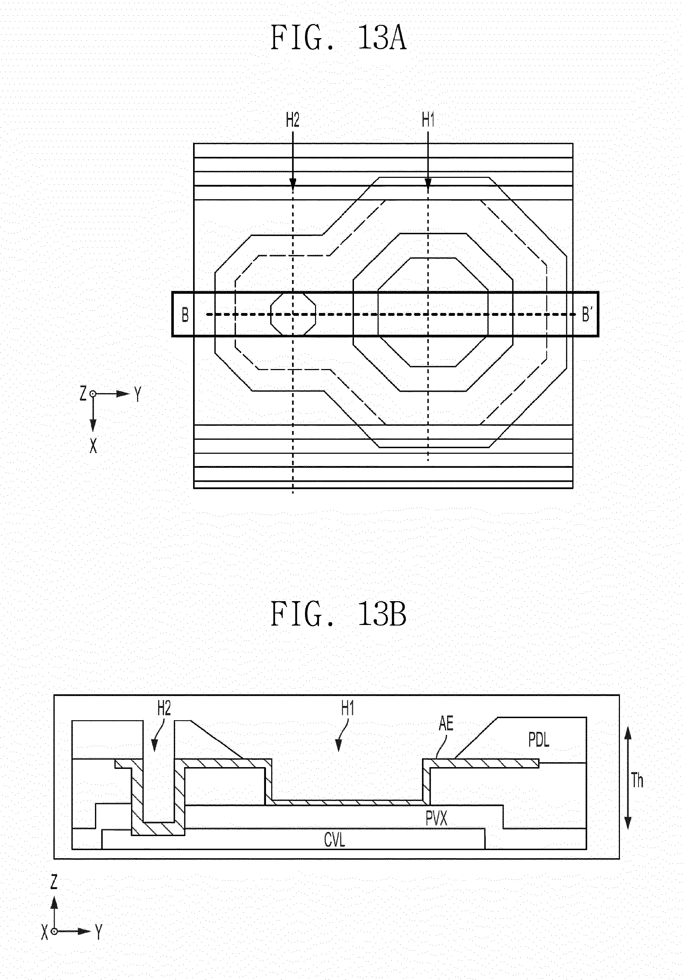

In one or more embodiments the pixel electrode PE may be connected to the transistor T1 through a first contact hole CH1 (e.g., through a contact hole in a third insulation layer 30), the first connection electrode CNE1, and a second contact hole CH2 (e.g., through a contact hole in the fourth insulation layer 40). In one or more embodiments, the auxiliary electrode AE may be connected to the common voltage line CVL through a third contact hole (e.g., through another contact hole in the fourth insulation layer 40). By way of example, according to one or more embodiments of the present disclosure, the third contact hole may be offset from the emission-layer opening ELOP in the Y-direction, for example, in a similar manner as how the second hole H2 is offset from the first hole H1 in FIG. 13B. Alternatively, the third contact hole in one or more other embodiments may be aligned in the thickness direction (Z-direction) of the base substrate with the third region R3, at which the emission layer EL has been completely ablated.

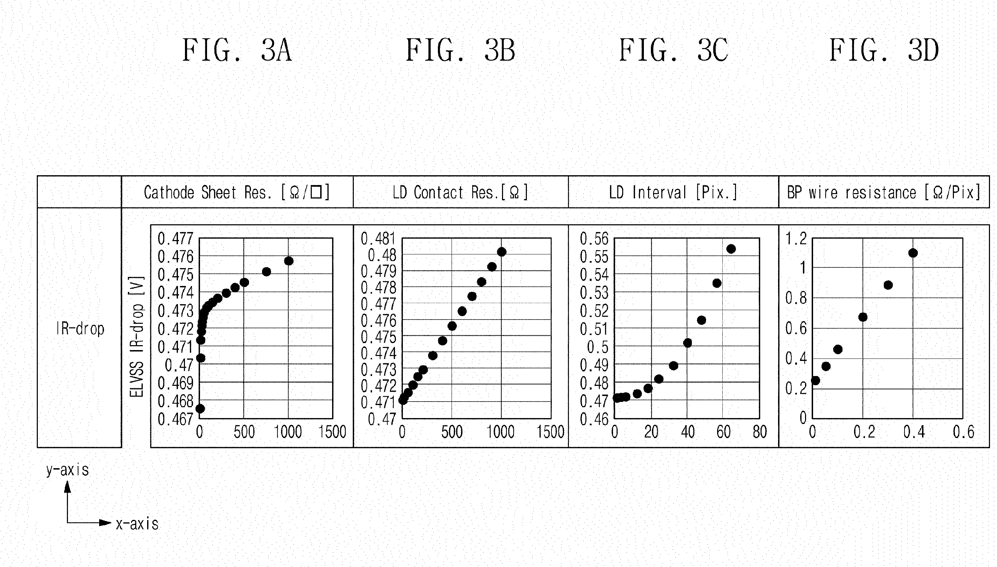

FIGS. 3A-3D are graphs depicting how different parameters affect IR-drop characteristics, based on simulations performed according to one or more embodiments of the present disclosure.

By way of example, low (or relatively low) backplane (e.g., a common voltage line) resistance was used in obtaining the simulation results provided in FIGS. 3A-3C.

Referring to FIG. 3A, a cathode electrode sheet resistance (also referred to as a "common electrode sheet resistance") may be decreased to reduce IR-drop. As used herein, the cathode electrode sheet resistance is a measurement of resistance across a surface of the cathode electrode between electrodes (or probes). By way of example, as a person of ordinary skill in the art would appreciate, a sheet resistance may be measured using a four-point probe system, in which a square is defined with four probes on a sheet of material (e.g., the cathode electrode) and a resistance between opposite sides of the square is measured. Therefore, the sheet resistance is generally given in units of ohms per square ($\Omega/\square$). For example, the x-axis of FIG. 3A depicts a range of common electrode sheet resistance values from 0 ohms per square ($\Omega/\square$) to about 1,000 ohms per square ($\Omega/\square$). The y-axis of FIG. 3A depicts corresponding IR-drops in volts (V), which range from about 0.467 V to about 0.476 V.

Referring to FIG. 3B, an LD (e.g., a laser drill hole, a laser drilled hole, an LD hole, or an emission-layer opening ELOP) contact resistance (which corresponds to a resistance of the contact through the emission-layer opening ELOP between the common electrode CME and the auxiliary electrode AE) may be decreased to reduce IR-drop. For example, the x-axis of FIG. 3B depicts a range of LD contact resistance values from about 0 ohms ($\Omega$) to about 1,000 ohms ($\Omega$). The y-axis of FIG. 3B depicts resulting IR-drops in volts (V), which range from about 0.471 V to about 0.48 V.

Referring to FIG. 3C, a laser drill (LD) interval per pixel (Pix.) (which corresponds to one emission-layer opening ELOP per a given number of pixels) may be changed to reduce IR-drop. For example, the x-axis of FIG. 3C depicts a range of LD interval ratios from about one emission-layer opening ELOP per pixel to about one emission-layer opening ELOP per 70 pixels. The y-axis of FIG. 3C depicts resulting IR-drops in volts (V), which range from about 0.47 V to about 0.55 V.

Referring to FIG. 3D, a backplane (BP) wire resistance (which corresponds to a resistance measured at a common voltage line CVL across the display panel) may be decreased to reduce IR-drop. For example, the x-axis of FIG. 3D depicts a range of BP wire resistance values from about 0 ohms per pixel to about 0.4 ohms per pixel. The y-axis of FIG. 3D depicts resulting IR-drops in volts (V), which range from about 0.2 V to about 1.1 V.

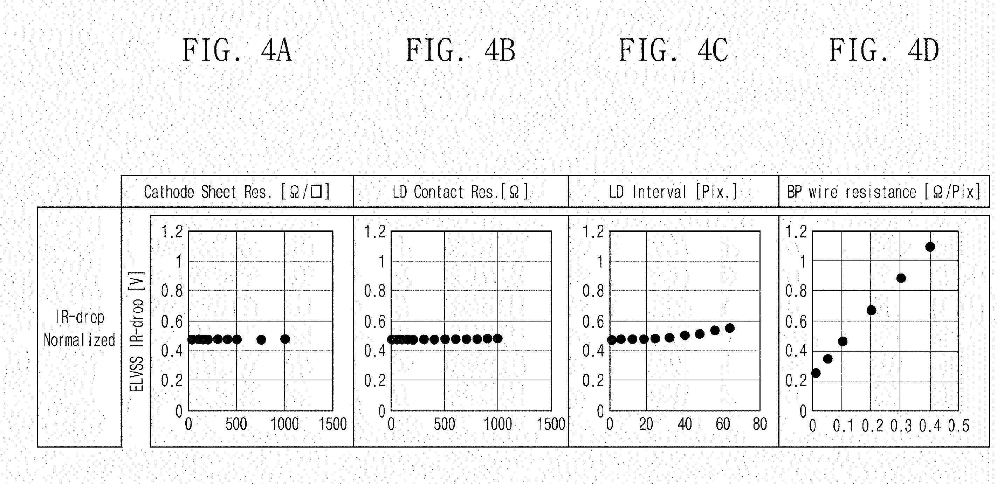

FIGS. 4A-4D are graphs depicting normalized versions of the graphs of FIGS. 3A-3D.

Referring to FIGS. 4A-4C, the IR-drop values of the y-axis have been scaled to depict a range from about 0 V to about 1.2 V. In other words, the scale of the y-axis in FIGS. 4A, 4B and 4C has been adjusted or normalized to conform to that of FIG. 3D. As can be seen, by comparing the degree of change between each of FIGS. 4A-4D, changes in BP wire resistance (FIG. 4D) and changes in LD interval (FIG. 4C) may have a greater effect on IR-drop than changes in cathode sheet resistance (FIG. 4A) or in LD contact resistance (see FIG. 4B).

**Parameter 1 (which corresponds to x2 of Equation 1 below): Common Electrode Sheet Resistance**

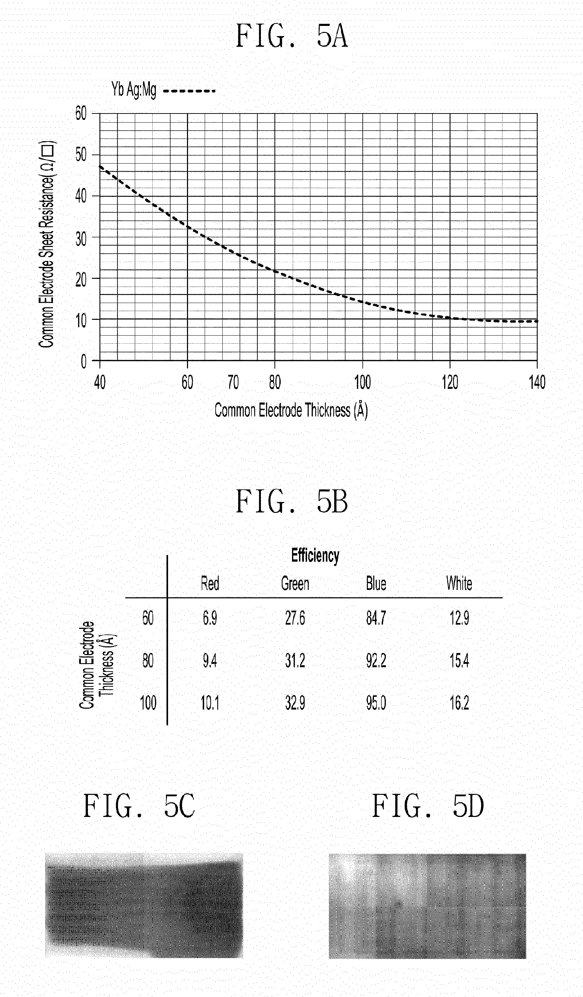

FIG. 5A is a graph depicting a change in sheet resistances of a common-electrode material including ytterbium (Yb) and silver-magnesium (Ag:Mg) based on a range of common electrode thicknesses from about 40 angstroms (Å) to about 140 angstroms (Å), according to one or more embodiments of the present disclosure. As a person of ordinary skill in the art would appreciate, the sheet resistance may be measured using the four-point probe system, which has been described above.

Common electrode sheet resistance (also referred to as "cathode sheet resistance" or "cathode electrode sheet resistance") affects the IR-drop of the display device. Common electrode sheet resistance may be determined (e.g., may be approximated) and/or modified based on a thickness and type of materials used in forming the common electrode CME (see FIG. 2, for example). For example, a thinner common electrode CME may have a higher resistance than a thicker common electrode CME. While the thicker common electrode may be more suitable due to its lower resistance, thereby resulting in lower IR-drop, the thickness of the common electrode may affect light transmittance, and therefore a thinner common electrode may be more suitable when considering light output efficiencies. According to one or more embodiments, when the common electrode includes ytterbium (Yb) and silver-magnesium (Ag:Mg) and has a thickness of about 60 angstroms (Å), a sheet resistance of greater than about 32 ohms per square ($\Omega/\square$) may result. When ytterbium (Yb) and silver-magnesium (Ag:Mg) are used as the material for the common electrode, about 70 angstroms (Å) to about 140 angstroms (Å) may be a suitable range of thickness. When the thickness is about 70 angstroms (Å) or less, there might be little or no significant contribution to IR-drop, and when the thickness is about 140 angstroms (Å) or more, the light transmittance may be reduced. In the display device according to one or more embodiments, the thickness of the cathode electrode may not be uniform across the entire display panel and may vary as a person of ordinary skill in the art would appreciate. A common electrode may be formed to have a low sheet resistance (e.g., a low surface resistance). If the sheet resistance is too high, IR-drop issues may not be sufficiently reduced. In one or more embodiments, the common electrode may be formed with materials and a thickness to provide a sheet resistance in the range of about 1 ohm ($\Omega$) to about 50 ohms ($\Omega$). In one or more embodiments, the common electrode may be formed with materials and a thickness to provide a sheet resistance in the range of about 32 ohms ($\Omega$) or less.

Referring to FIG. 5A, a common electrode thickness of about 40 angstroms (Å) may result in a sheet resistance of about 50 ohms per square ($\Omega/\square$), a common electrode thickness of about 60 angstroms (Å) may result in a sheet resistance of about 32 ohms per square ($\Omega/\square$), a common electrode thickness of about 80 angstroms (Å) may result in a sheet resistance of about 22 ohms per square ($\Omega/\square$), a common electrode thickness of about 100 angstroms (Å) may result in a sheet resistance of about 14 ohms per square ($\Omega/\square$), a common electrode thickness of about 120 angstroms (Å) may result in a sheet resistance of about 10 ohms per square ($\Omega/\square$), and a common electrode thickness of about 140 angstroms (Å) may result in a sheet resistance of about 9.5 ohms per square ($\Omega/\square$).

FIG. 5B is a chart depicting differences in efficiencies associated with red, green, blue, and white light based on different common electrode thicknesses.

Referring to FIG. 5B, a common electrode thickness of about 60 angstroms (Å) may result in a red efficiency (e.g., a red-light output efficiency) of about 6.9 Candelas/Ampere, a green efficiency of about 27.6 Candelas/Ampere, a blue efficiency of about 84.7 Candelas/Ampere, and a white efficiency of about 12.9 Candelas/Ampere (also referred to as "W efficiency"). As used herein, "white efficiency" may refer to an efficiency of white light from a display (e.g., when red, green, and blue sub-pixels are all emitting light). For example, a common electrode thickness of about 80 angstroms (Å) may result in a red efficiency of about 9.4 Candelas/Ampere, a green efficiency of about 31.2 Candelas/Ampere, a blue efficiency of about 92.2 Candelas/Ampere, and a white efficiency of about 15.4 Candelas/Ampere. A common electrode thickness of about 100 angstroms (Å) may result in a red efficiency of about 10.1 Candelas/Ampere, a green efficiency of about 32.9 Candelas/Ampere, a blue efficiency of about 95.0 Candelas/Ampere, and a white efficiency of about 16.2 Candelas/Ampere.

Additionally, a display panel may have degraded efficiency based on the common electrode being too thin. For example, a common electrode thickness of about 60 angstroms (Å) may result in a relatively higher IR-drop, and also may have a greater risk of a portion of the common electrode being burnt through too much current flowing per unit area (e.g., a unit cross-sectional area) of the common electrode, while common electrode thicknesses of about 80 angstroms (Å) and about 100 angstroms (Å) may result in a relatively lower IR-drop, and also may reduce the risk of a portion of the common electrode being burnt.

FIG. 5C is a picture depicting a luminance of a display having a common electrode thickness of about 60 angstroms.

FIG. 5D is a picture depicting a luminance of a display having a common electrode thickness of about 80 angstroms.

As can be seen by comparing FIG. 5C with FIG. 5D, the luminance of the display having a common electrode thickness of about 60 angstroms (Å) may have a relatively poorer quality (e.g., less uniformity) than the display having a common electrode thickness of about 80 angstroms (Å). For example, the display having a common electrode thickness of about 60 angstroms (Å) may exhibit irregularities, such that mura may be shown. Contrastingly, the display having a common electrode thickness of about 80 angstroms (Å) may exhibit an improved uniformity, such that mura may be relatively reduced (e.g., may be less visible or eliminated).

An upper limit to a range of acceptable common electrode thicknesses may be determined (e.g., may be selected) based on a decrease in a front (or top) luminous transmittance of a display panel as the thickness of the common electrode increases.

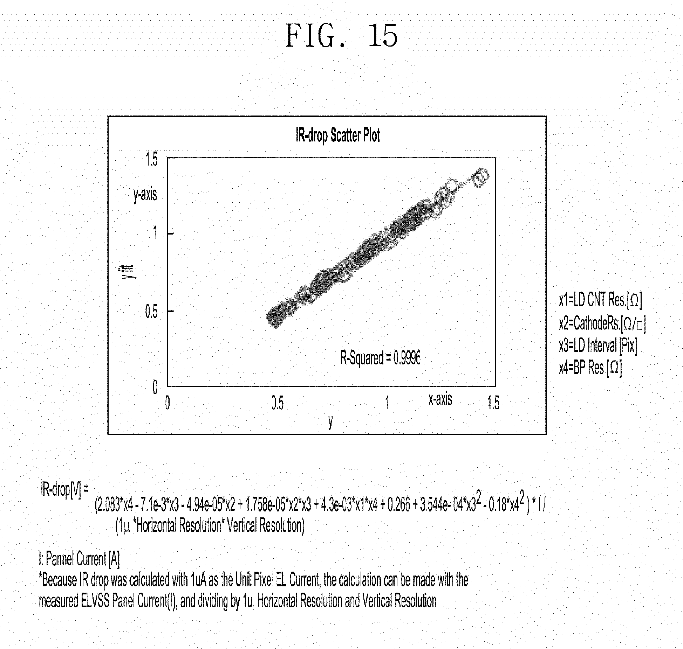

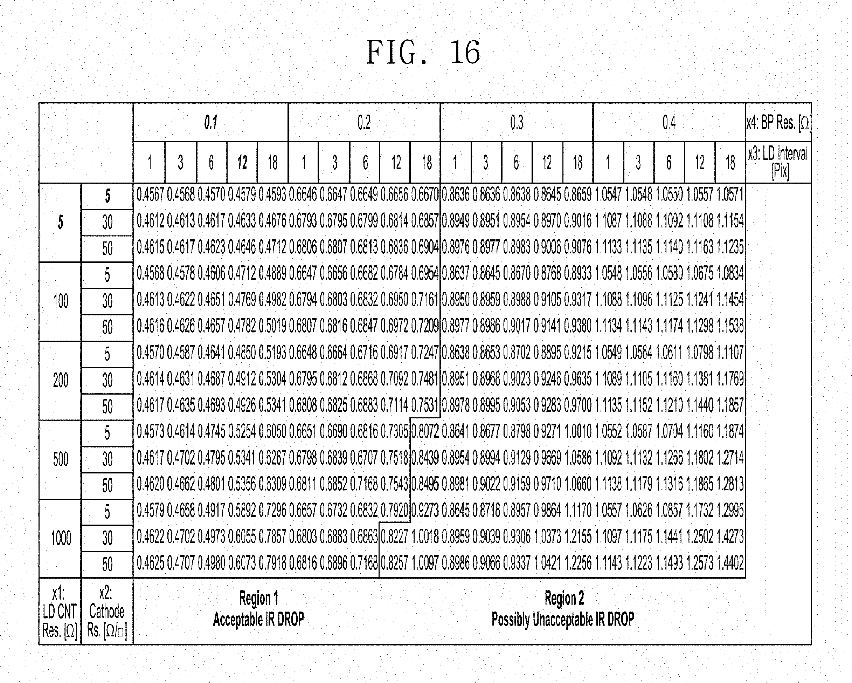

It should be understood, as discussed below with respect to FIG. 15 and FIG. 16, that changes to one or more of the other parameters may affect the results discussed above with respect to FIGS. 5A-5D. That is, the effects of the parameters discussed herein are interdependent.

The common electrode may be formed from different materials and different thicknesses to reduce (e.g., to eliminate) an associated IR-drop. The common electrode may be formed from different materials and different thicknesses to increase light transmittance, which, in turn, may increase light output efficiencies of corresponding light-emitting elements. The common electrode may be deposited thinly to provide light transmittance. If the common electrode is too thin, the contact between the common electrode CME and the auxiliary electrode AE (see FIG. 2) may not be effective or may be less effective in reducing (e.g., in preventing) IR-drop issues. On the other hand, if the common electrode is too thick, the transmittance may decrease, and corresponding light output efficiencies of the light elements may also decrease. In one or more embodiments, a common electrode may be formed to have a thickness in a range of about 40-200 angstroms (Å). In one or more embodiments, a common electrode may be formed to have a thickness in a range of about 50-140 angstroms (Å). In one or more embodiments, a common electrode may be formed to have a thickness in a range of about 70-140 angstroms (Å).

The common electrode may be formed of materials that are suited for a given transmission type (e.g., transmissive types, transflective types, or reflective types) associated with a display. For example, in transmissive embodiments, the common electrode may include one or more transparent metal oxides. Some example metal oxides for a transmissive common electrode include indium tin oxide (ITO), indium zinc oxide (IZO), zinc oxide (ZnO), indium tin zinc oxide (ITZO), and/or the like. In transmissive embodiments or reflective embodiments, the common electrode may include one or more of silver (Ag), magnesium (Mg), copper (Cu), aluminum (Al), platinum (Pt), palladium (Pd), gold (Au), nickel (Ni), neodymium (Nd), iridium (Ir), chromium (Cr), lithium (Li), calcium (Ca), lithium fluoride/calcium (LiF/Ca), lithium fluoride/aluminum (LiF/Al), molybdenum (Mo), titanium (Ti), ytterbium (Yb), tungsten (W), indium (In), zinc (Zn), tin (Sn), and/or the like or a compound or a mixture thereof (e.g., AgMg, AgYb, MgAg, and/or the like). However, the present disclosure is not limited thereto. For example, the common electrode may include other elements that are known to be suitable to a person of ordinary skill in the art. Additionally, in one or more embodiments, the common electrode may include a multi-layered structure including one or more layers including elements associated with transmissive types and/or one or more layers including elements associated with transflective and/or reflective types.

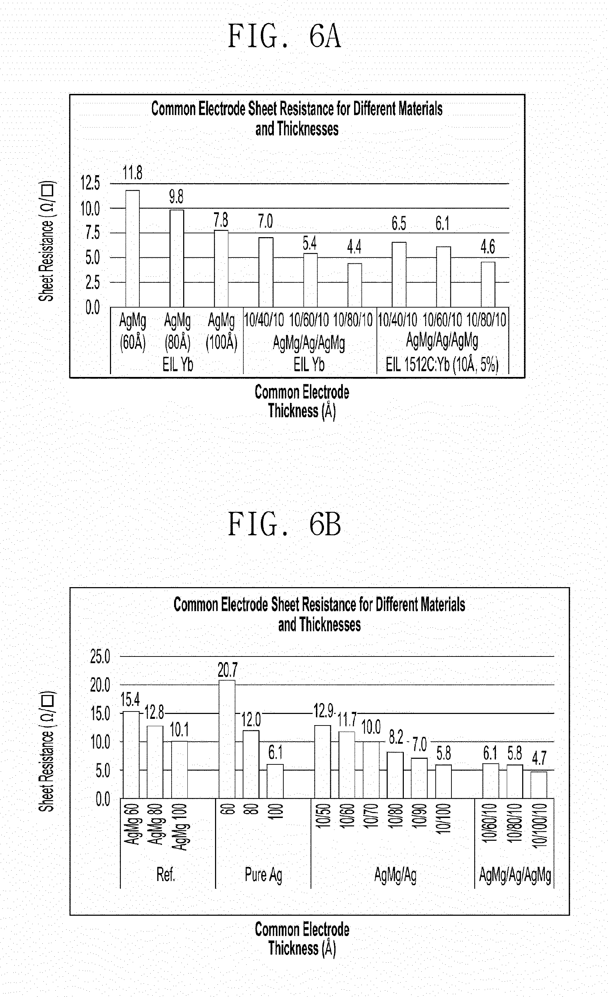

FIG. 6A is a graph depicting common electrode sheet resistances for different materials and thicknesses, according to the present disclosure.

Referring to FIG. 6A, measurements from nine different embodiments of common electrodes are shown to demonstrate how materials and thicknesses may affect a resulting sheet resistance of the common electrode. Each of the common electrodes described below with respect to FIG. 6A is located (or formed) on an electron injection layer (EIL) including ytterbium (Yb). However, the present disclosure is not limited thereto. Further, the last three common electrodes described below with respect to FIG. 6A are located (or formed) on an EIL including 1512C:Yb (10Å, 5%).

For example, a common electrode that includes AgMg and has a thickness of about 60 angstroms (Å), may result in a sheet resistance of about 11.8 ohms per square ($\Omega/\square$); a common electrode that includes AgMg and has a thickness of about 80 angstroms (Å) may result in a sheet resistance of about 9.8 ohms per square ($\Omega/\square$); and a common electrode that includes AgMg and has a thickness of about 100 angstroms (Å) may result in a sheet resistance of about 7.8 ohms per square ($\Omega/\square$).

A common electrode that includes a first layer of AgMg having a thickness of about 10 angstroms (Å), a second layer of Ag having a thickness of about 40 angstroms (Å), and a third layer of AgMg having a thickness of about 10 angstroms (Å) may result in a sheet resistance of about 7.0 ohms per square ($\Omega/\square$); a common electrode that includes a first layer of AgMg having a thickness of about 10 angstroms (Å), a second layer of Ag having a thickness of about 60 angstroms (Å), and a third layer of AgMg having a thickness of about 10 angstroms (Å) may result in a sheet resistance of about 5.4 ohms per square ($\Omega/\square$); and a common electrode that includes a first layer of AgMg having a thickness of about 10 angstroms (Å), a second layer of Ag having a thickness of about 80 angstroms (Å), and a third layer of AgMg having a thickness of about 10 angstroms (Å) may result in a sheet resistance of about 4.4 ohms per square ($\Omega/\square$).

A common electrode that includes a first layer of AgMg having a thickness of about 10 angstroms (Å), a second layer of Ag having a thickness of about 40 angstroms (Å), and a third layer of AgMg having a thickness of about 10 angstroms (Å) may result in a sheet resistance of about 6.5 ohms per square ($\Omega/\square$); a common electrode that includes a first layer of AgMg having a thickness of about 10 angstroms (Å), a second layer of Ag having a thickness of about 60 angstroms (Å), and a third layer of AgMg having a thickness of about 10 angstroms (Å) may result in a sheet resistance of about 6.1 ohms per square ($\Omega/\square$); and a common electrode that includes a first layer of AgMg having a thickness of about 10 angstroms (Å), a second layer of Ag having a thickness of about 80 angstroms (Å), and a third layer of AgMg having a thickness of about 10 angstroms (Å) may result in a sheet resistance of about 4.6 ohms per square ($\Omega/\square$).

FIG. 6B is a graph depicting common electrode sheet resistances for different materials and thicknesses, according to some embodiments of the present disclosure.

Referring to FIG. 6B, three different embodiments of common electrodes including different thicknesses of AgMg are used as a reference ("Ref.") as to how different materials may affect common electrode sheet resistances. For example, a common electrode that includes AgMg and has a thickness of about 60 angstroms (Å), may result in a sheet resistance of about 15.4 ohms per square ($\Omega/\square$); a common electrode that includes AgMg and has a thickness of about 80 angstroms (Å), may result in a sheet resistance of about 12.8 ohms per square ($\Omega/\square$); and a common electrode that includes AgMg and has a thickness of about 100 angstroms (Å), may result in a sheet resistance of about 10.1 ohms per square ($\Omega/\square$). These sheet resistance values are different from the sheet resistance values for common electrodes that include AgMg and having same thicknesses in the graph of FIG. 6A. This is because the sheet resistance of a common electrode also depends on other factors such as materials and configurations for a layer on which the common electrode is formed. Similarly, other sheet resistances may be realized by changing materials and/or configurations of the underlying layer that is in contact with the common electrode.

According to some embodiments, a common electrode that includes pure Ag and has a thickness of about 60 angstroms (Å), may result in a sheet resistance of about 20.7 ohms per square ($\Omega/\square$); a common electrode that includes pure Ag and has a thickness of about 80 angstroms(Å), may result in a sheet resistance of about 12.0 ohms per square ($\Omega/\square$); and a common electrode that includes pure Ag and has a thickness of about 100 angstroms (Å), may result in a sheet resistance of about 6.1 ohms per square ($\Omega/\square$).

According to some embodiments, a common electrode that includes a first layer of AgMg having a thickness of about 10 angstroms (Å) and a second layer of Ag having a thickness of about 50 angstroms (Å), may result in a sheet resistance of about 12.9 ohms per square ($\Omega/\square$); a common electrode that includes a first layer of AgMg having a thickness of about 10 angstroms (Å) and a second layer of Ag having a thickness of about 60 angstroms (Å), may result in a sheet resistance of about 11.7 ohms per square ($\Omega/\square$); a common electrode that includes a first layer of AgMg having a thickness of about 10 angstroms (Å) and a second layer of Ag having a thickness of about 70 angstroms (Å), may result in a sheet resistance of about 10.0 ohms per square; a common electrode that includes a first layer of AgMg having a thickness of about 10 angstroms (Å) and a second layer of Ag having a thickness of about 80 angstroms (Å), may result in a sheet resistance of about 8.2 ohms per square ($\Omega/\square$); a common electrode that includes a first layer of AgMg having a thickness of about 10 angstroms (Å) and a second layer of Ag having a thickness of about 90 angstroms (Å), may result in a sheet resistance of about 7.0 ohms per square ($\Omega/\square$); and a common electrode that includes a first layer of AgMg having a thickness of about 10 angstroms (Å) and a second layer of Ag having a thickness of about 100 angstroms (Å), may result in a sheet resistance of about 5.8 ohms per square ($\Omega/\square$).

According to some embodiments, a common electrode that includes a first layer of AgMg having a thickness of about 10 angstroms (Å), a second layer of Ag having a thickness of about 60 angstroms (Å), and a third layer of AgMg having a thickness of about 10 angstroms (Å), may result in a sheet resistance of about 6.1 ohms per square ($\Omega/\square$); a common electrode that includes a first layer of AgMg having a thickness of about 10 angstroms (Å), a second layer of Ag having a thickness of about 80 angstroms (Å), and a third layer of AgMg having a thickness of about 10 angstroms (Å), may result in a sheet resistance of about 5.8 ohms per square ($\Omega/\square$); and a common electrode that includes a first layer of AgMg having a thickness of about 10 angstroms (Å), a second layer of Ag having a thickness of about 100 angstroms (Å), and a third layer of AgMg having a thickness of about 10 angstroms (Å), may result in a sheet resistance of about 4.7 ohms per square ($\Omega/\square$).

According to one or more embodiments, a thickness of the common electrode (CME) (e.g., a cathode electrode) is in a range of about 40 angstroms (Å) to about 200 angstroms (Å). According to one or more embodiments, the cathode electrode has a thickness in a range of about 40 angstroms (Å) to about 140 angstroms (Å). According to one or more embodiments, the thickness of the common electrode is in a range of about 50 angstroms (Å) to about 140 angstroms (Å). According to one or more embodiments, a thickness of the common electrode CME is in a range of about 70 angstroms (Å) to about 140 angstroms (Å). According to one or more embodiments, the common electrode CME includes (e.g., is formed of) a metal or a combination of metals. According to one or more embodiments, the common electrode includes (e.g., is formed of) one or more layers including at least one of ITO, IZO, ZnO, ITZO, Yb, Ag, Mg, Cu, Al, Pt, Pd, Au, Ni, Nd, Lr, Cr, Li, Ca, LiF/Ca, LiF/Al, Mo, Ti, Sn, W, In, Zn, or a combination thereof. According to one or more embodiments, the common electrode includes Yb Ag:Mg. According to one or more embodiments, the common electrode CME has a sheet resistance in a range of about 9.7 ohms per square ($\Omega/\square$) to about 50 ohms per square ($\Omega/\square$). According to one or more embodiments, the cathode electrode CME has a sheet resistance of less than about 32 ohms per square ($\Omega/\square$).

**Parameter 2 (which corresponds to x1 of Equation 1 below): Contact Resistance**

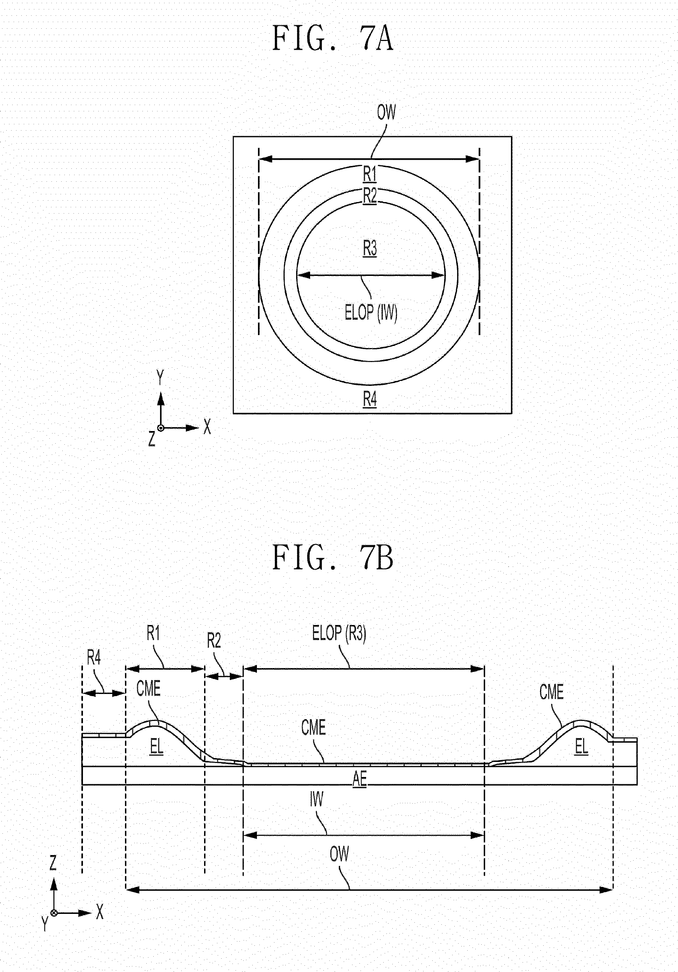

FIG. 7A is a schematic plan view of an emission-layer opening formed in an emission layer, according to one or more embodiments of the present disclosure.

FIG. 7B is a schematic cross-sectional view of the emission-layer opening formed in the emission layer depicted in FIG. 7A, according to one or more embodiments of the present disclosure.

Contact resistance conditions affect IR-drop. Contact resistance may be determined (e.g., may be approximated) and/or may be modified based on an area of a contact hole (e.g., an area corresponding to the emission-layer opening ELOP). Such contact resistance (also referred to as "LD contact resistance") refers to a resistance corresponding to an area of contact (e.g., an amount of contact) between a portion of the common electrode CME and a portion of the auxiliary electrode AE at the emission-layer opening ELOP. In one or more embodiments, an emission-layer removal range may be observed to improve or optimize the LD contact resistance conditions for reducing IR-drop. For example, a smaller emission-layer opening ELOP, which allows for a smaller area of contact between the common electrode CME and the auxiliary electrode AE, may result in a higher resistance than a larger emission-layer opening ELOP, which allows for a larger area of contact between the common electrode CME and the auxiliary electrode AE. In other words, the LD contact resistance is generally inversely related to a size of the emission-layer opening ELOP. IR-drop increases with increased resistance.

There are multiple alternate systems and methods that can be used for measurement of LD contact resistance as a person of ordinary skill in the art would appreciate. Further, a person of ordinary skill in the art should be able to devise, without undue experimentation, a system and/or a method for measuring and/or determining LD contact resistance in a display device (or a display panel). Therefore, embodiments of the present disclosure do not require and are not associated with any particular method or system for LD contact resistance measurement.

Referring to FIGS. 7A and 7B, an area of the emission layer EL may be completely removed, such that the common electrode CME on one side of the emission layer EL may contact the auxiliary electrode AE on the other side of the emission layer EL. As discussed above, a laser may be used to form the emission-layer opening ELOP. In one or more embodiments, a Gaussian beam laser may be used to drill the laser drill hole and form the emission-layer opening ELOP. The Gaussian beam may be most intense at a center portion and may become gradually less intense outwardly from the center portion. Accordingly, the emission-layer opening may be surrounded by a sloped region, wherein some, but not all, of the emission layer has been removed.

For example, a first region R1 may correspond to a portion of the sloped region including a sloping shoulder-shaped portion of the emission layer EL, having a higher emission-layer thickness that is greater than a typical thickness (e.g., an average thickness) of the emission layer EL. The higher emission-layer thickness in the first region R1 may be shaped based on portions of the emission layer EL being pushed outward to form a burr (e.g., a bump or a region where the emission layer EL has a greater height than adjacent regions). The outside of the first region R1 may have an outer width OW (e.g., an outer diameter) associated with the emission-layer opening ELOP. The outer width OW may correspond to portions of the emission layer EL that have been directly or indirectly affected by laser processing. The first region R1 may surround (e.g., may immediately surround) a second region R2. The second region R2 may include remaining portions of the emission layer, which are thinner than a typical thickness of the emission layer EL. The second region R2 may surround (e.g., may immediately surround) a third region R3. The third region R3 may correspond to the emission-layer opening ELOP. The third region R3 may be a hole formed through (e.g., completely through) the emission layer EL, wherein the emission layer EL has been completely removed (e.g., completely ablated). The third region R3 (and the emission-layer opening ELOP) may have an inner width IW (e.g., an inner diameter). The inner width IW may be inferred (e.g., may be estimated) based on the outer width OW of the first region R1 in cases where it is easier (e.g., where it is quicker or more suitable) to measure the outer width OW than to measure the inner width IW. For example, in one or more embodiments, if the outer width OW is considered to be 100 (arbitrary units), the inner width IW may be inferred to be 60 +/-20. The third region R3 may correspond to the position of the most intense portions of the Gaussian laser beam during laser processing. A fourth region R4 may surround (e.g., may immediately surround) the first region R1. The fourth region R4 may include an emission-layer thickness that is closer to the typical thickness of the emission layer EL than the emission-layer thickness of the first region R1 and/or the second region R2.

Although FIG. 7A depicts regions R1 through R3 to be circular in shape, the present disclosure is not limited thereto. For example, the regions may have a polygonal shape (e.g., an octagonal shape), wherein the inner width IW and the outer width OW respectively correspond to maximum distances between opposite sides of the polygonal shape. The shape of the regions R1 through R3 may be any suitable shape known to a person of ordinary skill in the art. This maximum distance may be referred to as a largest width, which term may also refer to a largest dimension of a closed non-polygonal curve, such as a circle. For example, the largest width of the circle is its diameter.

In one or more embodiments, the inner width IW may be in a range of about 1 micrometer ($\mu$m) to about 30 micrometers ($\mu$m). In one or more embodiments, the inner width IW may be determined based on a corresponding (e.g., a resulting) LRU percentage. For example, an emission-layer opening ELOP may be formed to have in inner width IW at a range that prevents the long range uniformity (LRU) from being less than 70%. For example, a display having a LRU of less than 70% may exhibit irregularities (e.g., mura), such as a stain (e.g., a discoloration). In some cases, an inner width IW of about 3 micrometers ($\mu$m) may result in a white efficiency of about 13.0 Candelas/Ampere, an LRU of about 60.1%, and a mura rendering the display defective. Further, an inner width IW of about 5 micrometers ($\mu$m) may result in a white efficiency of about 13.2 Candelas/Ampere, an LRU of about 93.8%, and no mura (e.g., rendering the display acceptable). In one or more embodiments, the inner width IW may be at least about 4 micrometers ($\mu$m), such that an LRU is at least 70%. In one or more embodiments, the inner width IW may be in the range of about 4 micrometers ($\mu$m) to about 7 micrometers ($\mu$m). The white efficiency may be 13.2 Candelas/Ampere when the inner width IW is about 7 micrometers ($\mu$m). In one or more embodiments of the present disclosure, the display device may have a white efficiency of about 13.8 Candelas/Ampere and an LRU of about 80%, and no mura may be visible.

In one or more embodiments, the outer width OW may be in the range of about 1 micrometers ($\mu$m) to about 30 micrometers ($\mu$m). In one or more embodiments, the outer width OW may be about 10 micrometers ($\mu$m). Based on the ratio of 100 to 60 +/-20 discussed above, an outer width OW in the range of about 1 micrometer ($\mu$m) to about 30 micrometer ($\mu$m) may be used to estimate an inner width IW of about 0.4 micrometers ($\mu$m) to about 24 micrometers ($\mu$m) (e.g., 0.6 $\mu$m +/-0.2 $\mu$m to 18 $\mu$m +/-6 $\mu$m). Additionally, an outer width OW of about 10 micrometers ($\mu$m) may be used to estimate an inner width IW of about 4 micrometers ($\mu$m) to about 8 micrometers ($\mu$m).

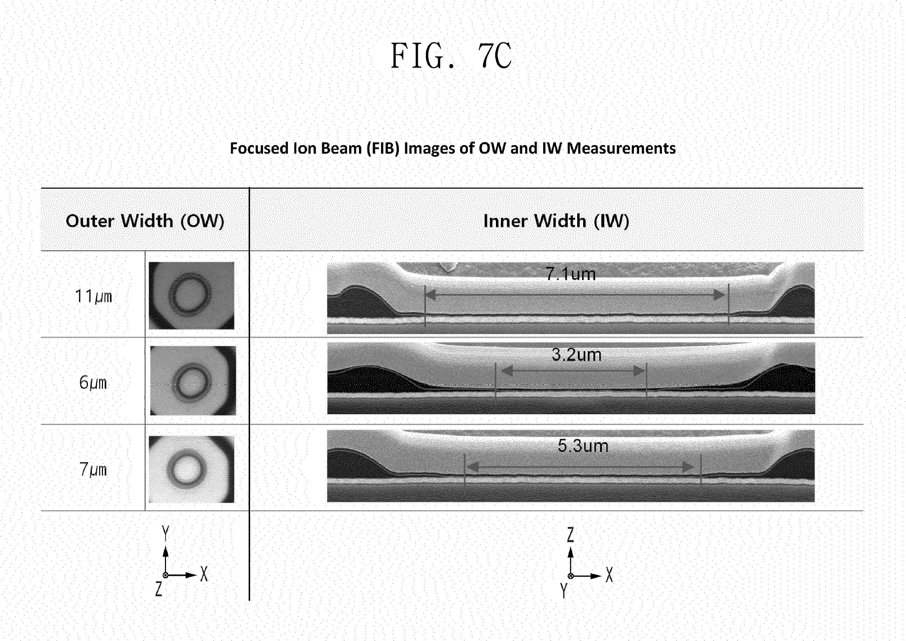

FIG. 7C depicts three focused ion beam (FIB) images of outer widths and inner widths associated with three different emission-layer opening of experimental examples, in accordance with one or more embodiments of the present disclosure.

Referring to FIG. 7C, in a first example, an outer width OW of about 11 micrometers ($\mu$m) corresponds to an inner width IW of about 7.1 micrometers ($\mu$m); in a second example, an outer width OW of about 6 micrometers ($\mu$m) corresponds to an inner width IW of about 3.2 micrometers ($\mu$m); and, in a third example, an outer width OW of about 7 micrometers ($\mu$m) corresponds to an inner width IW of about 5.3 micrometers ($\mu$m).

Based on measurements and/or calculations (e.g., based on simulations), it can be seen that the contact resistance is inversely related to the size of the emission-layer opening. For example, an outer width OW of about 0.8 micrometers ($\mu$m) may result in a contact resistance of about 1,500 ohms ($\Omega$); an outer width OW of about 1 micrometer ($\mu$m) may result in a contact resistance of about 980 ohms ($\Omega$); an outer width OW of about 5 micrometers ($\mu$m) may result in a contact resistance of about 39.2 ohms ($\Omega$); an outer width OW of about 10 micrometers ($\mu$m) may result in a contact resistance of about 9.8 ohms ($\Omega$); and an outer width OW of about 30 micrometers ($\mu$m) may result in a contact resistance of about 1.1 ohms ($\Omega$). Contact resistance may be determined (e.g., may be calculated) based on assuming a square area having a length and a width that are both equal to the outer width OW. In one or more embodiments, contact resistance may be in a range between about 1 ohm ($\Omega$) and about 1,000 ohms ($\Omega$) per emission-layer opening.

**Parameter 3 (which corresponds to x3 of Equation 1 below): Hole-Formation Interval and Hole Count**

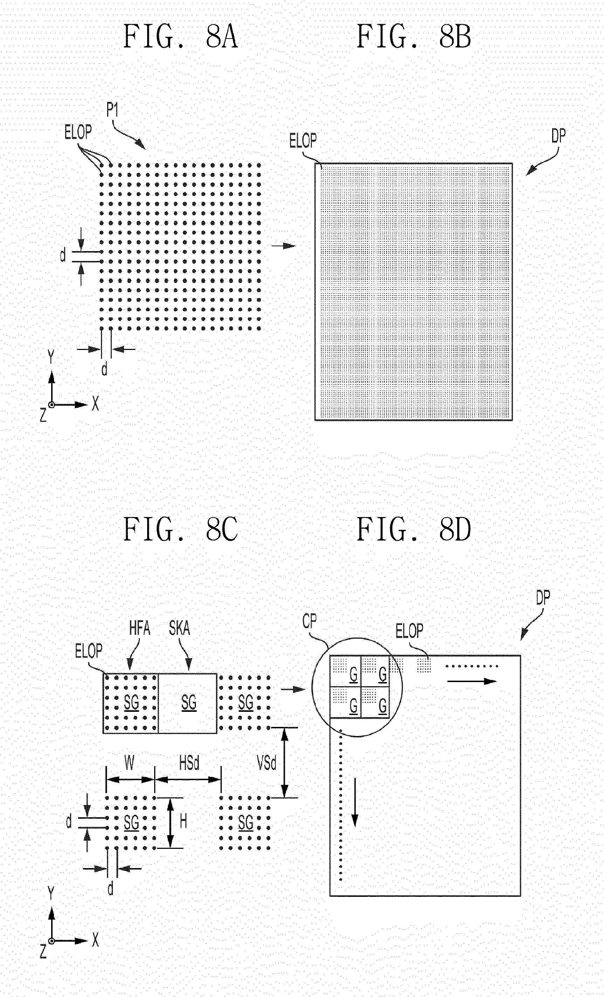

FIG. 8A and FIG. 8B are schematic diagrams depicting a display (e.g., a display device or a display panel) having holes drilled (e.g., laser drilled) at a substantially constant (or uniform) interval throughout a display area of the display, according to one or more embodiments of the present disclosure.

FIG. 8C and FIG. 8D are schematic diagrams depicting a display (e.g., a display device or a display panel) having holes drilled (e.g., laser drilled) according to a pattern (e.g., a chess pattern) associated with subgroups of pixel electrode sets, according to one or more embodiments of the present disclosure.

Hole formation-interval (e.g., pitch) conditions (e.g., LD hole spacing conditions) and hole count affect IR-drop. Observing a given distance (e.g., a maximum distance) between adjacent emission-layer openings ELOP may reduce or minimize the occurrence of IR-drops while reducing or minimizing the fabrication time in forming the emission-layer openings ELOP. However, as a spacing between nearest neighboring emission-layer openings ELOP increases, it is more difficult to reduce an IR-drop across the display panel, and also a risk of burning the common electrode CME at the emission-layer openings ELOP increases.

Referring to FIG. 8A and 8B, emission-layer openings ELOP may be formed across the display panel DP (e.g., across the entire display panel DP). In one or more embodiments, the emission-layer openings ELOP may be formed at a constant interval (e.g., a constant pitch or a uniform pitch) throughout the entire display panel DP in a first pattern P1 (e.g., a constant-pitch pattern or a uniform pitch pattern). For example, in the first pattern P1, each emission-layer opening ELOP may be spaced from an adjacent (e.g., from a neighboring) emission-layer opening ELOP (e.g., a nearest emission-layer opening ELOP) by a distance d (e.g., an interval) that is substantially constant across the display panel DP (e.g., across the entire display panel DP). The distance d may be referred to as the hole formation interval (also referred to as a "pitch" in mm or an "LD interval" in mm). The LD interval may also be referred to in terms of emission-layer openings per pixel. For example, in one or more embodiments, the LD interval of the first pattern P1 may be in a range of one emission-layer opening ELOP per pixel (1x1) to one emission-layer opening ELOP per (72x72) pixels (i.e., one per 72 pixels in each of horizontal and vertical directions). In other embodiments, there may be a different number of emission-layer openings in horizontal and vertical directions. By way of example, there may be one emission-layer opening per (2x2) pixels, (3x3) pixels, (4x4) pixels, (5x5) pixels, (6x6) pixels, (7x7) pixels, (8x6) pixels, (9x9) pixels, (10x12) pixels, or any other suitable number of pixels as a person of ordinary skill in the art would appreciate. Also, the number of pixels between emission-layer openings in horizontal and vertical directions may be different from each other. By reducing the number of emission-layer openings ELOP in comparison to the number of pixels, the production time for each display panel DP may be decreased and, thus, takt time may be improved. By way of example, in a 65-inch television, the distance d (e.g., the interval) between nearest emission-layer openings ELOP may be in a range of about 1.1 mm (or about 1.116 mm) to about 20 mm, and the number of emission-layer openings ELOP may be in a range of about 57,000 to about 920,000 (or about 57,600 to about 921,600).

Referring to FIGS. 8C and 8D, in one or more embodiments, the emission-layer openings ELOP may be formed across the display panel DP in (or based on) a chess pattern CP. For example, the display panel DP may be divided into hole-forming areas HFA and skip areas SKA. The hole-forming areas HFA and the skip areas SKA may be formed in groups G. The groups G may be formed into an alternating pattern, similar to a pattern of squares on a chess board. The hole-forming areas HFA may include emission-layer openings ELOP formed at a substantially constant pitch as discussed above with respect to the distance d between neighboring emission-layer openings ELOP. The skip areas SKA may not have emission-layer openings ELOP formed therethrough. One hole-forming area HFA may correspond to one subgroup SG of pixel electrode sets (or pixels). One skip area SKA may correspond to another subgroup SG of pixel electrode sets (or pixels). The subgroups SG of pixel electrode sets in each group G may be arranged in a matrix (e.g., may be arranged in rows and columns of the pixel electrode sets). Within each hole-forming area HFA, each emission-layer opening ELOP may be spaced from an adjacent (e.g., from a neighboring) emission-layer opening ELOP (e.g., a nearest emission-layer opening ELOP) by a distance d that is substantially constant (e.g., substantially uniform) across the hole-forming area HFA. Each hole-forming area HFA may have a hole-forming area width W in a horizontal direction (e.g., in the X direction) from a left-most emission-layer opening ELOP of the hole-forming area HFA to a right-most emission-layer opening ELOP of the hole-forming area HFA. The emission-layer openings in one hole-forming area HFA may be referred to as a subset of the emission-layer openings. Each hole-forming area HFA may have a hole-forming area height H in a vertical direction (e.g., in the Y direction) from a top-most emission-layer opening ELOP of the hole-forming area HFA to a bottom-most emission-layer opening ELOP of the hole-forming area HFA. Each hole-forming area HFA may be separated from a nearest neighboring (e.g., adjacent) hole-forming area HFA by a horizonal separation distance HSd from a right-most emission-layer opening ELOP of one hole-forming area HFA to a nearest neighboring left-most emission-layer opening ELOP of the nearest neighboring hole-forming area HFA. Each hole-forming area HFA may be separated from a nearest neighboring hole-forming area HFA by a vertical separation distance VSd from a bottom-most emission-layer opening ELOP of one hole-forming area HFA to a nearest neighboring top-most emission-layer opening ELOP of the nearest neighboring hole-forming area HFA. According to one or more embodiments, the width W may be about 5.58 mm, and the horizontal separation distance HSd may be about 5.58 mm. However, the present disclosure is not limited thereto. In other embodiments, W and HSd may be different from 5.58 mm, and may be different from each other.

According to one or more embodiments, the width W of the hole-forming area may be the same or different from the height H of the hole-forming area. Further, the distance d between the neighboring (e.g., adjacent) emission-layer openings ELOP in the horizontal and vertical directions may be the same or different from each other. In addition, not all pixel electrode sets in the hole-forming area may have a corresponding emission-layer opening ELOP. For example, in each hole-forming area, the emission-layer openings ELOP are formed in horizontal and vertical directions such that an interval between two emission-layer openings is greater than an interval between two adjacent pixels (or pixel electrode sets), for example, by a factor of, but not limited to, 2, 3, 4, 5, 6, 7, 8, 9, 10, 11, 12, 13, 14, 15, 16, and/or the like. Further, dimensions of the hole-forming area HFA in horizontal and vertical directions may be different from each other, and a distance between neighboring (e.g., adjacent) emission layer openings ELOP in the horizontal and vertical directions may be different from each other.

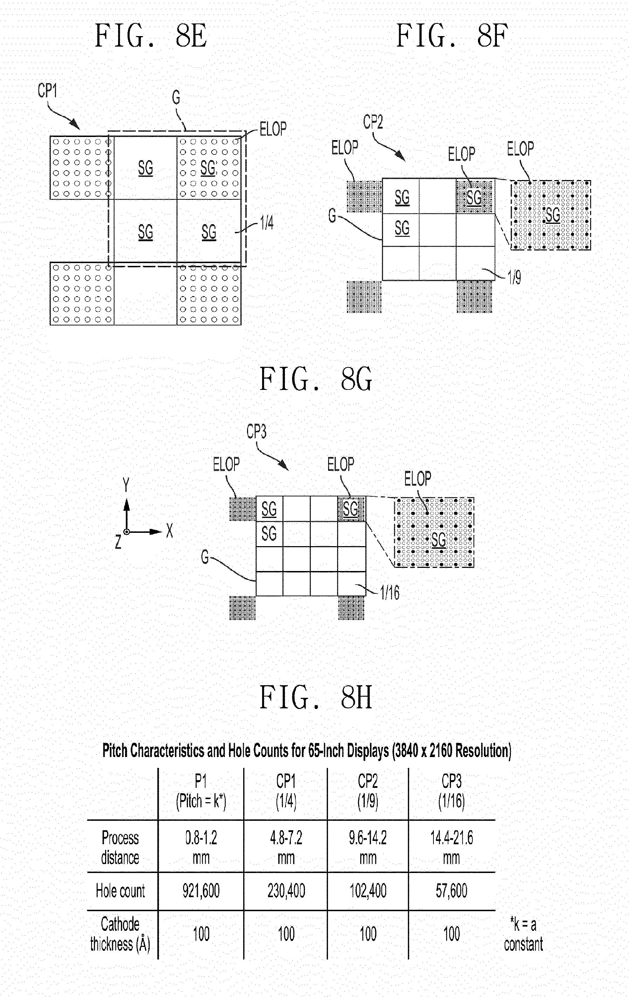

FIG. 8E, FIG. 8F, and FIG. 8G depict variations of the pattern (e.g., chess pattern) associated with subgroups of pixel electrode sets, according to one or more embodiments of the present disclosure.

Referring to FIG. 8E, in one or more embodiments, the chess pattern may be a first chess pattern CP1 that is a 1/4 chess pattern, wherein each group G includes four subgroups SG with only one of the subgroups SG corresponding to a hole-forming area HFA. Based on the first chess pattern CP1, a total number of the emission-layer openings ELOP may be 25%, or less, of a total number of pixels (or pixel electrode sets) in the display panel DP.

Referring to FIG. 8F, in one or more embodiments, the chess pattern may be a second chess pattern CP2 that is a 1/9 chess pattern, wherein each group G includes nine subgroups SG with only one of the subgroups SG corresponding to a hole-forming area HFA. Based on the second chess pattern CP2, a total number of the emission-layer openings ELOP may be less than the total number of emission-layer openings of the first chess pattern CP1. Further, not every pixel in the subgroup SG in a hole forming area may have a corresponding emission-layer opening ELOP. For example, based on the second chess pattern CP2, a total number of the emission-layer openings ELOP may be about 11.1% or less of the total number of pixels (or pixel electrode sets) in the display panel DP.

Referring to FIG. 8G, in one or more embodiments, the chess pattern may be a third chess pattern CP3 that is a 1/16 chess pattern, wherein each group G includes 16 subgroups SG with only one of the subgroups SG corresponding to a hole-forming area HFA. Based on the third chess pattern CP3, a total number of the emission-layer openings ELOP may be less than the total number of emission-layer openings of the first chess pattern CP1. Based on the third chess pattern CP3, a total number of the emission-layer openings ELOP may be less than the total number of emission-layer openings of the second chess pattern CP2. Further, not every pixel in the subgroup SG in a hole forming area may have a corresponding emission-layer opening ELOP. For example, based on the third chess pattern CP3, a total number of the emission-layer openings ELOP may be about 6.25% or less of the total number of pixels (or pixel electrode sets) in the display panel DP.

A person of ordinary skill in the art should understand that the present disclosure is not limited to the examples depicted with 4, 9, and 16 subgroups SG per group G. For example, a number of subgroups SG per group G could be 25, 32, 64, or any other suitable number of subgroups per group G as one of ordinary skill in the art would appreciate. Further, a pitch of the emission-layer openings ELOP in each subgroup SG may be the same as or greater than a pitch of the pixels in each subgroup SG.

FIG. 8H is a chart of pixel and hole parameters corresponding to a 65-inch display, according to one or more embodiments of the present disclosure.

Referring to FIG. 8H, a display panel (e.g., included in a 65-inch television) may have a resolution of 3840 x 2160 (e.g., may have 8,294,400 pixels (or pixel electrode sets)). Implementing the first pattern P1 on such a 65-inch display with a constant pitch (k) may result in a hole count (e.g., a number of emission-layer openings ELOP) of about 921,600. In other words, the display panel may have one emission-layer opening per 3x3 or 9 pixels (e.g., pixel electrode sets). In this particular embodiment, the number of holes (e.g., emission-layer openings) is 921,600, however, the present disclosure is not limited thereto. By way of example, the process distance during manufacturing can be between about 0.8 mm to about 1.2 mm.

Implementing the first chess pattern CP1 on the 65-inch display panel may result in a hole count (e.g., a number of emission-layer openings ELOP) of about 230,400 (e.g., one emission-layer opening per 3x3 or 9 pixels in each subgroup of a Group of pixels (or pixel electrode sets)), wherein the Group includes 4 subgroups to realize a one-quarter (¼) chess pattern. In this particular embodiment, the number of holes (e.g., emission-layer openings) is 230,400, however, the present disclosure is not limited thereto. By way of example, the process distance during manufacturing can be between about 4.8 mm to about 7.2 mm.

Implementing the second chess pattern CP2 on the 65-inch display panel may result in a hole count (e.g., a number of emission-layer openings ELOP) of about 102,400 (e.g., one emission-layer opening per 3x3 or 9 pixels in each subgroup of a group of pixels (or pixel electrode sets)), wherein the group includes 9 subgroups to realize a one-ninth (1/9) chess pattern. In this particular embodiment, the number of holes (e.g., emission-layer openings) is 102,400, however, the present disclosure is not limited thereto. By way of example, the process distance during manufacturing can be between about 9.6 mm to about 14.2 mm.

Implementing the third chess pattern CP3 on the 65-inch display panel may result in a hole count (e.g., a number of emission-layer openings ELOP) of about 57,600 (e.g., about one emission-layer opening per 3x3 or 9 pixels in each subgroup of a group of pixels (or pixel electrode sets)), wherein the group includes 16 subgroups to realize a one-sixteenth (1/16) chess pattern. In this particular embodiment, the number of holes (e.g., emission-layer openings) is 57,600, however, the present disclosure is not limited thereto. By way of example, the process distance during manufacturing can be between about 14.4 mm to about 21.6 mm.

According to one or more embodiments, the plurality of pixel electrode sets PES, each of the pixel electrode sets PES including a plurality of pixel electrodes to realize a full color pixel, are organized into a plurality of groups G of pixel electrode sets. Each of the plurality of groups G of the pixel electrode sets PES includes a plurality of subgroups SG of pixel electrode sets, and only one of the subgroups SG in one of the groups G has corresponding ones of the emission-layer openings ELOP. By way of example, each pixel electrode set PES may include pixel electrodes PE that respectively correspond to red (R), green (G), and blue (B) subpixels, but the present disclosure is not limited thereto.

According to one or more embodiments, the subgroups SG in the plurality of groups G of pixel electrode sets having corresponding ones of the emission-layer openings define hole-forming areas HFA, and wherein a width W of one of the hole-forming areas HFA is equal to a distance HSd between two adjacent ones of the hole-forming areas HFA. According to one or more embodiments, a number of the plurality of subgroups in one of the groups of pixel electrode sets is in a range of 4 to 64 (e.g., 4, 9, 16, 25, 36, 49, or 64), but the present disclosure is not limited thereto. In other embodiments, the number of the plurality of subgroups in one of the groups of pixel electrode sets may be any suitable number greater than or equal to 64 (e.g., in a range of 64 to 1,000). According to one or more embodiments, the plurality of groups (G) of pixel electrode sets are arranged in a matrix. According to one or more embodiments, a ratio between a total number of pixel electrode sets PES and a total number of emission-layer openings ELOP in one of the subgroups is in a range of 1 to 64 (1, 4, 9, 16, 25, 36, 49 or 64), but the present disclosure is not limited thereto. In other embodiments, the ratio between the total number of pixel electrode sets PES and the total number of emission-layer openings ELOP in one of the subgroups may be any suitable number greater than or equal to 64 (e.g., in a range of 65 to 1,000). According to one or more embodiments, the plurality of subgroups of pixel electrode sets in each of the plurality of groups are arranged in a matrix.

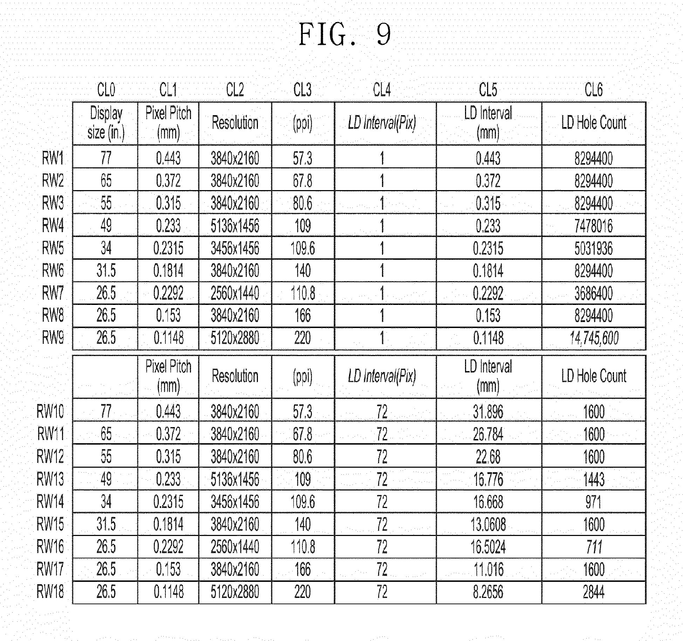

FIG. 9 is a chart of pixel and hole parameters corresponding to different sizes and types of displays, according to one or more embodiments of the present disclosure.

Referring to FIG. 9, rows RW1 to RW9 include data for display sizes (e.g., standard display sizes) of 77 inches to 26.5 inches associated with a pitch of one emission-layer opening per pixel (see column CL4, which indicates an LD interval of one for rows RW1 to RW9). Rows RW10 to RW18 include data for display sizes of 77 inches to 26.5 inches associated with a pitch of one emission-layer opening per 72 pixels (see column CL4, which indicates an LD interval of 72 for rows RW10 to RW18).

Referring to rows RW1 and RW10, a 77-inch display having a pixel pitch of about 0.443 mm (see column CL1), a resolution of 3840 x 2160 (e.g., 8,294,400 total pixels) (see column CL2), and about 57.3 pixels per inch (ppi) (see column CL3), may have: (i) an emission-layer opening interval of about 0.443 mm (see column CL5) and an emission-layer opening count of about 8,294,400 (see column CL6), in one or more embodiments, based on a pitch of one emission-layer opening per pixel (see column CL4); and (ii) an emission-layer opening interval of about 31.896 mm (see column CL5) and an emission-layer opening count of about 1,600 (see column CL6), in one or more embodiments, based on a pitch of one emission-layer opening per 72 pixels (see column CL4).

Referring to rows RW2 and RW11, a 65-inch display having a pixel pitch of about 0.372 mm (see column CL1), a resolution of 3840 x 2160 (e.g., 8,294,400 total pixels) (see column CL2), and about 67.8 pixels per inch (ppi) (see column CL3), may have: (i) an emission-layer opening interval of about 0.372 mm (see column CL5) and an emission-layer opening count of about 8,294,400 (see column CL6), in one or more embodiments, based on a pitch of one emission-layer opening per pixel (see column CL4); and (ii) an emission-layer opening interval of about 26.784 mm (see column CL5) and an emission-layer opening count of about 1,600 (see column CL6), in one or more embodiments, based on a pitch of one emission-layer opening per 72 pixels (see column CL4).

Referring to rows RW3 and RW12, a 55-inch display having a pixel pitch of about 0.315 mm (see column CL1), a resolution of 3840 x 2160 (e.g., 8,294,400 total pixels) (see column CL2), and about 80.6 pixels per inch (ppi) (see column CL3), may have: (i) an emission-layer opening interval of about 0.315 mm (see column CL5) and an emission-layer opening count of about 8,294,400 (see column CL6), in one or more embodiments, based on a pitch of one emission-layer opening per pixel (see column CL4); and (ii) an emission-layer opening interval of about 22.68 mm (see column CL5) and an emission-layer opening count of about 1,600 (see column CL6), in one or more embodiments, based on a pitch of one emission-layer opening per 72 pixels (see column CL4).

Referring to rows RW4 and RW13, a 49-inch display having a pixel pitch of about 0.233 mm (see column CL1), a resolution of 5136 x 1456 (e.g., 7,478,016 total pixels) (see column CL2), and about 109 pixels per inch (ppi) (see column CL3), may have: (i) an emission-layer opening interval of about 0.233 mm (see column CL5) and an emission-layer opening count of about 7,478,016 (see column CL6), in one or more embodiments, based on a pitch of one emission-layer opening per pixel (see column CL4); and (ii) an emission-layer opening interval of about 16.776 mm (see column CL5) and an emission-layer opening count of about 1,443 (see column CL6), in one or more embodiments, based on a pitch of one emission-layer opening per 72 pixels (see column CL4).

Referring to rows RW5 and RW14, a 34-inch display having a pixel pitch of about 0.2315 mm (see column CL1), a resolution of 3456 x 1456 (e.g., 5,031,936 total pixels) (see column CL2), and about 109.6 pixels per inch (ppi) (see column CL3), may have: (i) an emission-layer opening interval of about 0.2315 mm (see column CL5) and an emission-layer opening count of about 5,031,936 (see column CL6), in one or more embodiments, based on a pitch of one emission-layer opening per pixel (see column CL4); and (ii) an emission-layer opening interval of about 16.668 mm (see column CL5) and an emission-layer opening count of about 971 (see column CL6), in one or more embodiments, based on a pitch of one emission-layer opening per 72 pixels (see column CL4).

Referring to rows RW6 and RW15, a 31.5-inch display having a pixel pitch of about 0.1814 mm (see column CL1), a resolution of 3840 x 2160 (e.g., 8,294,400 total pixels) (see column CL2), and about 140 pixels per inch (ppi) (see column CL3), may have: (i) an emission-layer opening interval of about 0.1814 mm (see column CL5) and an emission-layer opening count of about 8,294,400 (see column CL6), in one or more embodiments, based on a pitch of one emission-layer opening per pixel (see column CL4); and (ii) an emission-layer opening interval of about 13.0608 mm (see column CL5) and an emission-layer opening count of about 1,600 (see column CL6), in one or more embodiments, based on a pitch of one emission-layer opening per 72 pixels (see column CL4).

Referring to rows RW7 and RW16, a 26.5-inch display having a pixel pitch of about 0.2292 mm (see column CL1), a resolution of 2560 x 1440 (e.g., 3,686,400 total pixels) (see column CL2), and about 110.8 pixels per inch (ppi) (see column CL3), may have: (i) an emission-layer opening interval of about 0.2292 mm (see column CL5) and an emission-layer opening count of about 3,686,400 (see column CL6), in one or more embodiments, based on a pitch of one emission-layer opening per pixel (see column CL4); and (ii) an emission-layer opening interval of about 16.5024 mm (see column CL5) and an emission-layer opening count of about 711 (see column CL6), in one or more embodiments, based on a pitch of one emission-layer opening per 72 pixels (see column CL4).

Referring to rows RW8 and RW17, a 26.5-inch display having a pixel pitch of about 0.153 mm (see column CL1), a resolution of 3840 x 2160 (e.g., 8,294,400 total pixels) (see column CL2), and about 166 pixels per inch (ppi) (see column CL3), may have: (i) an emission-layer opening interval of about 0.153 mm (see column CL5) and an emission-layer opening count of about 8,294,400 (see column CL6), in one or more embodiments, based on a pitch of one emission-layer opening per pixel (see column CL4); and (ii) an emission-layer opening interval of about 11.016 mm (see column CL5) and an emission-layer opening count of about 1600 (see column CL6), in one or more embodiments, based on a pitch of one emission-layer opening per 72 pixels (see column CL4).

Referring to rows RW9 and RW18, a 26.5-inch display having a pixel pitch of about 0.1148 mm (see column CL1), a resolution of 5120 x 2880 (e.g., 14,745,600 total pixels) (see column CL2), and about 220 pixels per inch (ppi) (see column CL3), may have: (i) an emission-layer opening interval of about 0.1148 mm (see column CL5) and an emission-layer opening count of about 14,745,600 (see column CL6), in one or more embodiments, based on a pitch of one emission-layer opening per pixel (see column CL4); and (ii) an emission-layer opening interval of about 8.2656 mm (see column CL5) and an emission-layer opening count of about 2844 (see column CL6), in one or more embodiments, based on a pitch of one emission-layer opening per 72 pixels (see column CL4).

By way of example, the total number of emission-layer openings may be in a range of about 700 (or about 711, interval of 72 pixels) to about 3,700,000 (or 3,686,400, interval of 1 pixel) in a 2560 x 1440 television. For another example, the total number of emission-layer openings may be to in a range of about 2,800 (or about 2,844, interval of 72 pixels) to about 14,750,000 (14,745,600, interval of 1 pixel) in a 5120 x 2880 television. Therefore, in various embodiments of the present disclosure, the total number of openings is in a range of about 700 to 14,750,000 or in any suitable sub-range thereof. Also, in a 5120 x 2880 television, when the interval between adjacent emission-layer openings is 2 pixels (i.e., one emission layer opening per 2 pixels in both horizontal and vertical directions), there are 25% as many emission-layer opening as there are pixels, such that the number of emission-layer openings is 3,686,400, which is 25% of the total number of pixels of 14,745,600. Of course, the number of emission-layer openings in various embodiments will vary based on the television size (i.e., horizontal and vertical resolutions) and the interval between pixels. Further, the number of emission-layer openings may vary depending on the number of sub-groups in each group when the emission-layer openings are arranged in a chess patterned manner, and also the ratio between the number of emission-layer openings and the number of pixels (or pixel electrode sets) in each subgroup.

In one or more embodiments, the display device corresponds to a 65" (65-inch) television (including a 65" (65-inch) display panel), and the total number of the emission-layer openings is in a range of 57,000 to 920,000 (e.g., in a range of from 57,600 to 921,600). In one or more embodiments, a ratio between the total number of the pixels (or pixel electrode sets) and the total number of emission-layer openings is in a range of 4 to 5,184 (i.e., 2x2 to 72x72). In one or more embodiments, a ratio between the total number of the emission-layer openings and the total number of the pixels (or the pixel electrode sets) is in a range of 1/144 to 1/9 (e.g., in a range of 57,600 to 921,600 emission-layer openings in a display having a resolution of 3840 x 2160).

According to one or more embodiments, a largest width of one of the emission-layer openings is in a range of about 1 micrometer ($\mu$m) to about 30 micrometers ($\mu$m). In one or more embodiments, the largest width of the one of the emission-layer openings is at least about 3 micrometers ($\mu$m). In one or more embodiments, the largest width of the one of the emission-layer openings is in a range of about 4 micrometers ($\mu$m) to about 7 micrometers ($\mu$m). In one or more embodiments, the largest width of the one of the emission-layer openings is in a range of about 4 micrometers ($\mu$m) to about 5 micrometers ($\mu$m). In one or more embodiments, the largest width of the one of the emission-layer openings in a range of about 3 micrometers ($\mu$m) to about 20 micrometers ($\mu$m). Here, the largest width refers to the largest dimension of the emission-layer opening where the emission layer has been completely removed (or ablated). For example, the largest width is a diameter if the shape of the emission-layer opening is a circle.

**Parameter 4 (which corresponds to x4 of Equation 1 below): Backplane Wire (or Wiring) Resistance**

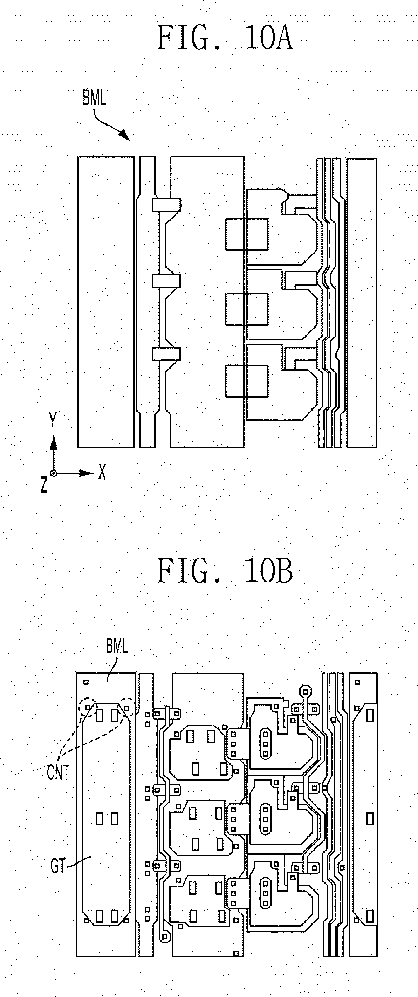

FIGS. 10A-10E depict schematic top views of layers of a display device, according to one or more embodiments of the present disclosure.

Backplane wire resistance (e.g., power source voltage wiring resistance) conditions affect IR-drop. For example, observing a resistance range for common-voltage lines CVL connected to the common electrode CME may reduce or minimize the occurrence of IR-drops. BP wire resistance may be determined (e.g., may be approximated) and/or modified based on wire materials and wire thicknesses as well as the number of layers of wires used.

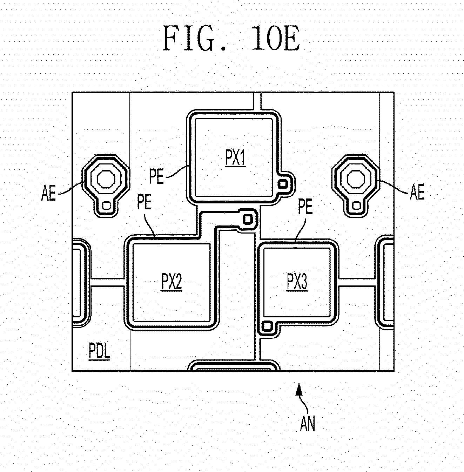

Referring to FIGS. 10A-10E, the backplane (BP) wire resistance may be determined (e.g., approximated) and/or modified based on configuration and conductive materials, which provide a conductive path from a backplane-metal layer BML (e.g., see FIG. 10A) to auxiliary electrodes AE (e.g., see FIG. 10E).

Referring to FIG. 10A, a display panel may include the backplane-metal layer BML. In one or more embodiments, the backplane-metal layer BML may pass a voltage from a power source voltage ELVSS to a common voltage line CVL for connecting to the common electrode CME (e.g., see FIG. 2). Therefore, the driving current flows in the pixel (or the subpixel) from the pixel electrode to the common electrode, and then to the common voltage line CVL and/or the backplane-metal layer BML. In one or more embodiments, the backplane-metal layer BML may include Ti and/or Cu. However, the present disclosure is not limited thereto, and the backplane-metal layer BML may include any suitable metal and/or material known to a person of ordinary skill in the art.

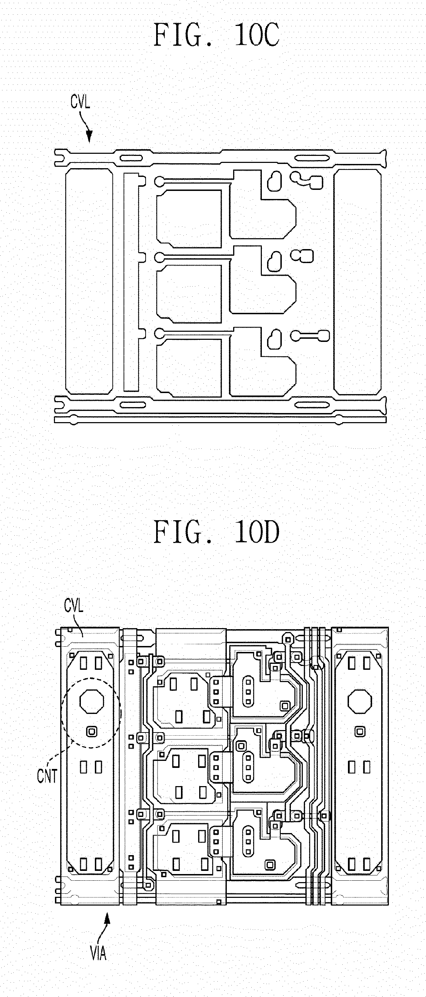

Referring to FIG. 10B, a gate-electrode layer GT may be located above (e.g., may overlap with) the backplane-metal layer BML. In one or more embodiments, the gate-electrode layer GT may be located on a same layer as a gate electrode of a transistor (e.g., a thin film transistor (TFT)) of the display device. The gate-electrode layer GT may be electrically insulated from (e.g., not electrically connected to) the gate electrode of the transistor. The backplane-metal layer BML may be provided with contacts (e.g., electrical contacts) CNT for connecting (e.g., electrically connecting) the backplane-metal layer BML to one or more other layers at a location or locations not overlapping the gate-electrode layer GT. By way of example, the contacts CNT may be used to electrically connect the backplane-metal layer BML to the common voltage line CVL (shown in FIG. 10C and 10D, for example). In one or more embodiments, the gate-electrode layer GT may include Ti and/or Cu. However, the present disclosure is not limited thereto, and the gate-electrode layer GT may include any suitable metal and/or material known to a person of ordinary skill in the art.

Referring to FIG. 10C, the gate-electrode layer GT may be connected to the common voltage line CVL (e.g., at a source-drain layer S/D). For example, the gate-electrode layer GT may be electrically connected to the common voltage line CVL through the contacts CNT shown in FIG. 10B. In one or more embodiments, the common voltage line CVL may be located at a same layer as a source and/or drain electrode of the transistor. The common voltage line CVL may be electrically insulated from (e.g., not electrically connected to) the source and/or drain electrode of the transistor. In one or more embodiments, the common voltage line CVL may receive the power source voltage ELVSS from the backplane-metal layer BML. In one or more embodiments, the common voltage line CVL may receive the power source voltage ELVSS from the gate-electrode layer GT. However, the present disclosure is not limited thereto, and the common voltage line CVL may receive the power source voltage ELVSS from any other suitable interface, for example, through one or more pads connected (e.g., electrically connected) directly to the common voltage line CVL. In one or more embodiments, the driving current that flows from the pixel electrode through the emission layer to the common electrode passes through the common voltage line CVL to the pad and/or the backplane-metal layer (BML). In one or more embodiments, common voltage line CVL may include Ti, Cu, and/or ITO. However, the present disclosure is not limited thereto, and the common voltage line CVL may include any suitable metal and/or material known to a person of ordinary skill in the art. For example, the common voltage line CVL may include a plurality of layers of metals.

Referring to FIG. 10D, the common voltage line CVL may be covered by a via layer VIA. The via layer VIA may include an insulation layer for insulating the common voltage line CVL from conductive components above the common voltage line CVL. The via layer VIA may also serve as a planarization layer, providing a substantially flat plane above the components it covers. In one or more embodiments, the via layer VIA may have a thickness of about 3.0 micrometers ($\mu$m). However, the present disclosure is not limited thereto, and the via layer VIA may have any suitable thickness known to a person of ordinary skill in the art.

Referring to FIG. 10E, an anode layer AN may be formed above the via layer VIA. The anode layer AN may include pixel electrodes PE and the auxiliary electrodes AE. FIG. 10E illustrates a set of three subpixels in each pixel (i.e., a set of three pixel electrodes PE (or a pixel electrode set PES) in each pixel), however, the present disclosure is not limited thereto. The pixel electrodes PE may be formed below a portion of the emission layer in a region of the pixel openings for one or more pixels (e.g., openings for one or more sub-pixels PX1-PX3). The auxiliary electrodes AE may be provided adjacent to, spaced from, and in (or at) a same layer as the pixel electrodes PE. The auxiliary electrodes AE may be electrically insulated from (e.g., not electrically connected to) the pixel electrodes PE. In one or more embodiments, the anode layer AN may include ITO and/or Ag. However, the present disclosure is not limited thereto, and the anode layer AN may include any suitable metal and/or material known to a person of ordinary skill in the art. A pixel defining layer PDL may be formed above the anode layer AN. The pixel defining layer PDL may define the shapes of the sub-pixels PX1-PX3.

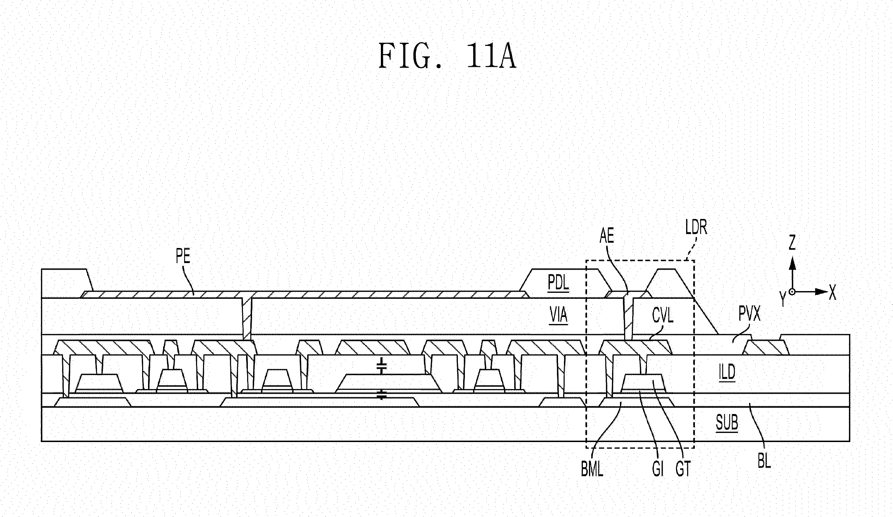

FIG. 11A is a schematic cross-sectional view of a display device including a common voltage line in (or at) one layer, according to one or more embodiments of the present disclosure.

Referring to FIG. 11A, in one or more embodiments, a laser drill region LDR may include a substrate SUB, a backplane-metal layer BML, a buffer layer BL, a gate insulation layer GI, a gate-electrode layer GT, an interlayer-insulation layer ILD, a common voltage line CVL, a passivation layer PVX, a via layer VIA, an auxiliary electrode AE, and a pixel defining layer PDL. The backplane-metal layer BML may include a backplane-metal line that extends in the same direction as the common voltage line CVL, and may partially or fully overlap with the common voltage line CVL. The backplane-metal line and the common voltage line CVL may be electrically connected with each other via one or more openings in the interlayer-insulation layer, and may together be referred to as an auxiliary line or an auxiliary voltage line.

In FIG. 11A, a common electrode or an emission layer are not shown, but a display device according to one or more embodiments would include both the common electrode and the emission layer as well as other suitable layers as a person of ordinary skill in the art would appreciate. The substrate SUB may include a pad (e.g., the pad may be formed on or in the substrate SUB). The pad may be formed at an interface between a source of a power source voltage ELVSS and the backplane-metal layer BML, however, the present disclosure is not limited thereto. By way of example, pads or pads may be directly connected to the common voltage lines CVL according to one or more embodiments. The buffer layer BL and the gate insulation layer GI may cover the backplane-metal layer BML. The buffer layer BL and the gate insulation layer GI may provide planarization and/or insulation functions (e.g., for the components of the backplane-metal layer BML and/or the components of the gate-electrode layer GT). In one or more embodiments, the buffer layer BL may include silicon nitride (SiNx) and/or silicon oxide (SiOx). However, the present disclosure is not limited thereto, and the buffer layer BL may include any suitable material (e.g., any suitable insulating material) known to a person of ordinary skill in the art. In one or more embodiments, the gate insulation layer GI may include SiOx. However, the present disclosure is not limited thereto, and the gate insulation layer GI may include any suitable material (e.g., any suitable insulating material) known to a person of ordinary skill in the art. The interlayer-insulation layer ILD may cover the gate-electrode layer GT. The interlayer-insulation layer ILD may provide planarization and/or insulation functions (e.g., for the components of the gate-electrode layer GT). In one or more embodiments, the interlayer-insulation layer ILD may include silicon oxy-nitride (SiON). However, the present disclosure is not limited thereto, and the interlayer-insulation layer ILD may include any suitable material known to a person of ordinary skill in the art. The passivation layer PVX may cover the common voltage line CVL and may provide planarization and/or insulation functions (e.g., for the components of a source-drain layer S/D). In one or more embodiments, the passivation layer PVX may include SiNx. However, the present disclosure is not limited thereto, and the passivation layer PVX may include any suitable material (e.g., any suitable insulating material) known to a person of ordinary skill in the art.

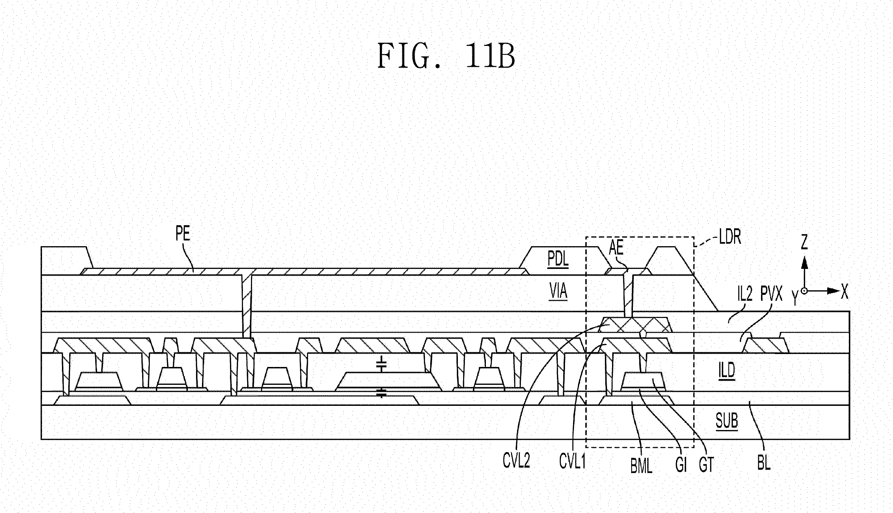

FIG. 11B is a schematic cross-sectional view of a display device including common voltage lines in (or at) two layers, according to one or more embodiments of the present disclosure.

Referring to FIG. 11B, in one or more embodiments, the laser drill region LDR may include the same layers and components of FIG. 11A and one or more additional layers. For example, the common voltage line CVL of FIG. 11A may correspond to a first common voltage line CVL1 of FIG. 11B, which is electrically connected to the backplane-metal layer BML. In addition to the first common voltage line CVL1, the one or more additional layers may include a second common voltage line CVL2 and a second insulation layer IL2. In one or more embodiments, the second common voltage line CVL2 may be located above (e.g., may overlap at least partially or fully with in a thickness direction of the substrate SUB) and extend in the same direction as the first common voltage line CVL1. In one or more embodiments, the second common voltage line CVL2 may be connected to the first common voltage line CVL1 via one or more openings in the passivation layer PVX. In one or more embodiments, the second insulation layer IL2 may cover the second common voltage line CVL2. The second insulation layer IL2 may provide planarization and/or insulation functions (e.g., for the second common voltage line CVL2). In one or more embodiments, the auxiliary electrode AE is connected to the second common voltage line CVL2 through an opening (e.g., a contact hole) in the via layer VIA. According to one or more embodiments, the backplane-metal lines BML may partially or fully overlap with, and may be electrically connected to, the first and second common voltage lines CVL1 and CVL2. The backplane-metal lines BML and the first and second common voltage lines CVL1 and CVL2 may together be referred to as auxiliary lines or auxiliary voltage lines.

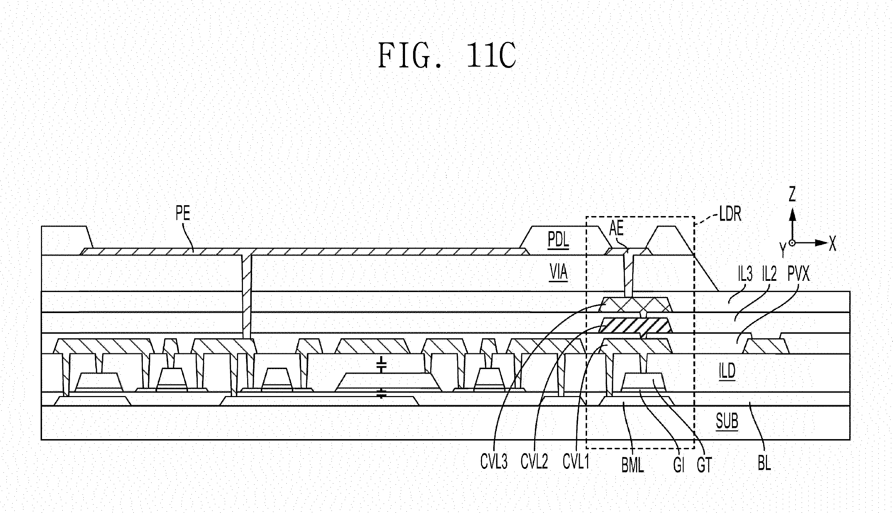

FIG. 11C is a schematic cross-sectional view of a display device including common voltage lines in (or at) three layers, a first common voltage line being connected to the backplane-metal layer BML, according to one or more embodiments of the present disclosure.

Referring to FIG. 11C, in one or more embodiments, the laser drill region LDR may include the same layers and components of FIG. 11B and one or more additional layers. For example, in addition to the first common voltage line CVL1 and the second common voltage line CVL2, the one or more additional layers may include a third common voltage line CVL3 and a third insulation layer IL3. For example, the display device of such embodiments may have a triple layer line (e.g., triplex wiring) that at least partially (or fully) overlap each other in a thickness direction of the substrate SUB and extend in the same direction. In one or more embodiments, the third common voltage line CVL3 may be located above (e.g., may overlap with) the second common voltage line CVL2. In one or more embodiments, the third common voltage line CVL3 may be connected to the second common voltage line CVL2 via an opening (e.g., a contact hole) in the second insulation layer IL2. In one or more embodiments, the third insulation layer IL3 may cover the third common voltage line CVL3. The third insulation layer IL3 may provide planarization and/or insulation functions (e.g., for the third common voltage line CVL3). In one or more embodiments, the auxiliary electrode AE is connected to the third common voltage line CVL3 through an opening (e.g., a contact hole) in the via layer VIA. According to one or more embodiments, the backplane-metal lines BML may partially or fully overlap with, and may be electrically connected to, the first, second, and third common voltage lines CVL1, CVL2, and CVL3. The backplane-metal lines BML and the first, second, and third common voltage lines CVL1, CVL2, and CVL 3 may together be referred to as auxiliary lines or auxiliary voltage lines.

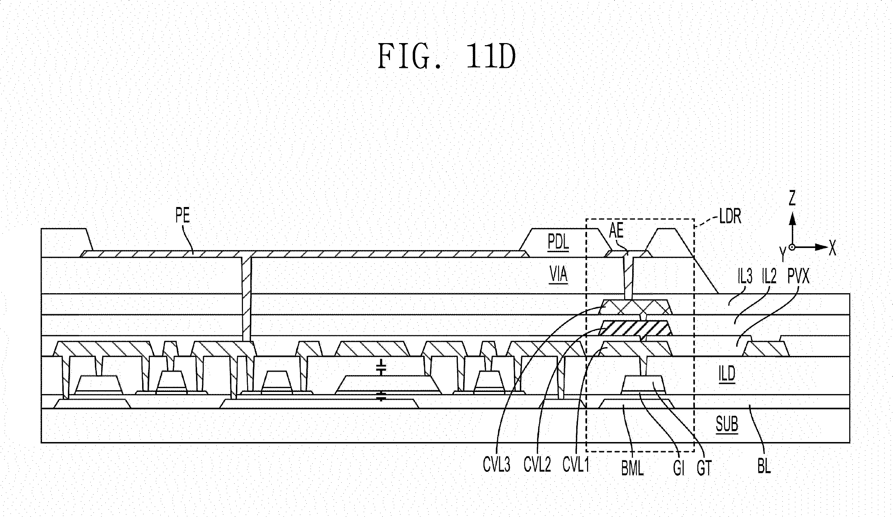

FIG. 11D is a schematic cross-sectional view of a display device including common voltage lines on three layers according to one or more embodiments of the present disclosure. In the embodiment of FIG. 11D, one or more of the common voltage lines CVL1, CVL2 and CVL3 may be directly coupled to a voltage source for the ELVSS voltage via one or more pads at either or both ends of one or more selected from among the first, second, and third common voltage lines CVL1, CVL2, and CVL3. The common voltage lines CVL1, CVL2 and CVL3 may at least partially or fully overlap each other in a thickness direction of the substrate SUB, and may extend in the same direction. According to one or more embodiments, the first, second, and third common voltage lines CVL1, CVL2, and CVL3 that are electrically connected with each other through one or more insulation layers may together be referred to as auxiliary lines or auxiliary voltage lines.

Referring to FIG. 11D, in one or more embodiments, the laser drill region LDR may include the same layers and components as FIG. 11C (e.g., the display device may have a triple layer line); however, in embodiments associated with FIG. 11D the first common voltage line CVL1 may not be connected to (e.g., may be disconnected from) the backplane-metal layer BML. For example, in one or more embodiments, the first common voltage line CVL1 may receive the common voltage from a different path (e.g., a different interface) than the backplane-metal layer BML. By way of example, one or more of the common voltage lines CVL1, CVL2, and/or CVL3 may be electrically connected to a pad or pads at one or both ends thereof, and are configured to receive a voltage (e.g., an ELVSS voltage) from an external power source. However, the present disclosure is not limited thereto. The common voltage lines CVL1, CVL2, and CVL3 may be electrically connected to one or more pads for the driving current to flow therethrough and/or to the backplane-metal layer BML.

According to one or more embodiments, a display device (or a display panel) includes: a substrate SUB; a plurality of auxiliary voltage lines on the substrate SUB, a resistance of one of the auxiliary voltage lines from one end to an opposite end of the display device being in a range of about 0.003 ohms ($\Omega$) to about 0.4 ohms ($\Omega$); a plurality of connection electrodes AE on the plurality of auxiliary voltage lines, at least one of the plurality of connection electrodes AE being electrically connected to a corresponding one of the plurality of auxiliary voltage lines; a plurality of pixel electrode sets PES spaced from the plurality of connection electrodes AE, each of the pixel electrode sets PES including a first pixel electrode, a second pixel electrode, and a third pixel electrode to realize a full color pixel; an emission layer EL on the plurality of connection electrodes AE and the plurality of pixel electrode sets PES, the emission layer EL having a plurality of emission-layer openings ELOP; and a common electrode CME on the emission layer EL, and electrically connected to the plurality of connection electrodes AE through the plurality of emission-layer openings ELOP. The resistance of the one of the auxiliary voltage lines may, for example, be in a range of about 0.03 ohms ($\Omega$) to about 0.4 ohms ($\Omega$).

According to one or more embodiments, the plurality of auxiliary voltage lines includes a plurality of first common voltage lines CVL1 and a plurality of backplane- metal lines BML extending in a same direction as the plurality of first common voltage lines CVL1, one of the plurality of backplane metal lines BML being electrically connected to a corresponding one of the plurality of first common voltage lines CVL1 via openings in a first insulation layer ILD located therebetween.

According to one or more embodiments, the plurality of auxiliary voltage lines includes a plurality of second common voltage lines CVL2 located between the plurality of first common voltages lines CVL1 and the plurality of common electrodes AE in a thickness direction of the substrate SUB, one of the plurality of second common voltage lines CVL2 being electrically connected to a corresponding one of the plurality of first common voltage lines CVL1 via openings in a second insulation layer PVX located therebetween.

According to one or more embodiments, one of the plurality of auxiliary voltage lines includes a plurality of overlapping common voltages lines CVL1, CVL2, CVL3 spaced from each other in a thickness direction of the substrate, the display device further including an insulation layer between two adjacent ones of the plurality of overlapping common voltage lines in the thickness direction, the two adjacent ones of the plurality of overlapping common voltage lines being electrically connected with each other via opening in the insulation layer. According to one or more embodiments, the plurality of overlapping common voltage lines includes at least three overlapping common voltage lines that are overlapped with and electrically connected with each other in the thickness direction of the substrate SUB. While FIGS. 11B, 11C, and 11D illustrate embodiments in which the pixel electrode PE is directly connected to a connection electrode at a same layer as the common voltage line CVL or the first common voltage line CVL1, the present invention is not limited thereto. In other embodiments, several layers of connection electrodes may be utilized to connect (i.e., electrically connect) the pixel electrode PE to a bottom-most connection electrode connected to a source or a drain of a transistor (e.g., a driving transistor) through multiple contact holes, similar to the common voltage lines CVL1, CVL2, and/or CVL3.

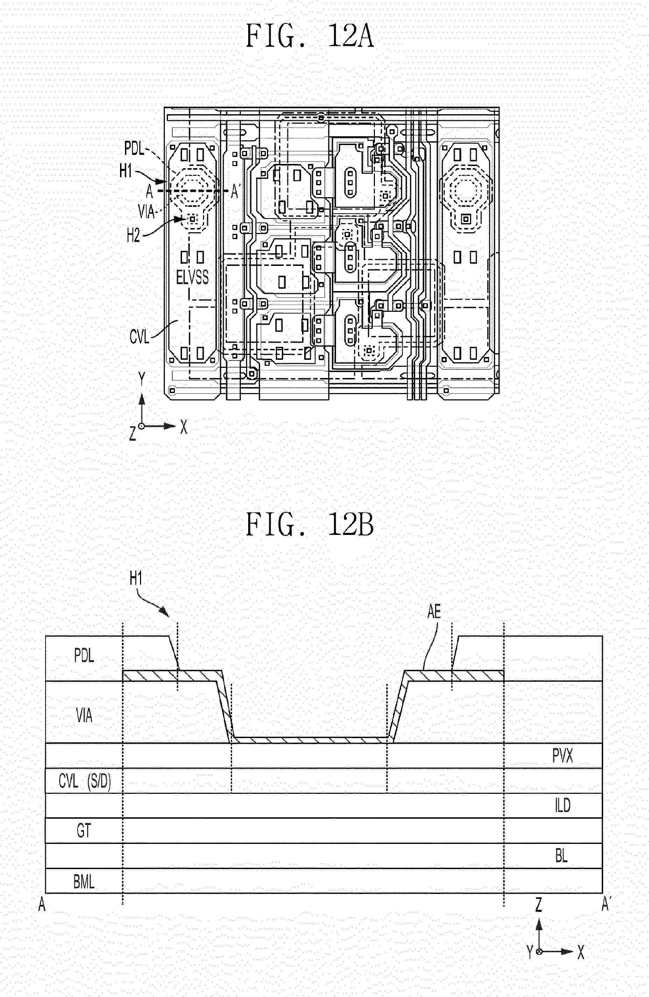

FIG. 12A is a schematic top plan view of some of the layers of a display device, according to one or more embodiments of the present disclosure.

FIG. 12B is a schematic cross-sectional view of some of the layers of the display device shown in FIG. 12A taken along the line A-A', according to one or more embodiments of the present disclosure.

Referring to FIGS. 12A and 12B, in one or more embodiments, a first hole H1 and a second hole H2 may be formed in the pixel defining layer PDL and/or in the via layer VIA to allow the power source voltage ELVSS, from the common voltage line CVL, to be provided to an auxiliary electrode AE. In one or more embodiments, the common voltage line CVL may be formed below the pixel defining layer PDL, below the via layer VIA, and below the auxiliary electrode AE.

FIG. 13A is a schematic top plan view of the layers of a display device, according to one or more embodiments of the present disclosure.

FIG. 13B is a schematic cross-sectional view of some of the layers of the display device shown in FIG. 13A taken along the line B-B', according to one or more embodiments of the present disclosure.

Referring to FIGS. 13A and 13B, the second hole H2 may extend deeper through a thickness direction Th of the display device than the first hole H1. For example, in one or more embodiments, the second hole H2 may be formed through a passivation layer PVX, such that the common voltage line CVL below the passivation layer PVX is exposed through the second hole H2.

As discussed above, the materials and thickness of the layer may impact the IR-drop of the display panel DP. In one or more embodiments, the anode layer AN may be formed of a combination (e.g., may be formed of a layered structure) of ITO/Ag/ITO having respective thicknesses of 100 angstroms (Å) / 850 angstroms (Å) / 100 angstroms (Å) to have a sheet resistance of about 0.4 ohms per square (Ω/□). In one or more embodiments, the anode layer AN may be formed of a combination (e.g., may be formed of a layered structure) of ITO/Ag/ITO having respective thicknesses of 150 angstroms (Å) / 1,000 angstroms (Å) / 150 angstroms (Å) to have a sheet resistance of about 0.4 ohms per square (Ω/□).

In one or more embodiments, the common voltage line CVL (e.g., the S/D layer) may be formed of a combination (e.g., may be formed of a layered structure) of Ti/Cu/Ti having respective thicknesses of 200 angstroms (Å) / 6000 angstroms (Å) / 550 angstroms (Å) to have a sheet resistance of about 0.038 ohms per square (Ω/□). In one or more embodiments, the common voltage line CVL (e.g., the S/D layer) may be formed of a combination (e.g., may be formed of a layered structure) of Ti/Cu/ITO having respective thicknesses of 200 angstroms (Å) / 6000 angstroms (Å) / 550 angstroms (Å) to have a sheet resistance of about 0.038 ohms per square (Ω/□).

In one or more embodiments, the backplane-metal layer BML may be formed of a combination (e.g., may be formed of a layered structure) of Ti/Cu having respective thicknesses of 200 angstroms (Å) / 6000 angstroms (Å) to have a sheet resistance of about 0.038 ohms per square (Ω/□).

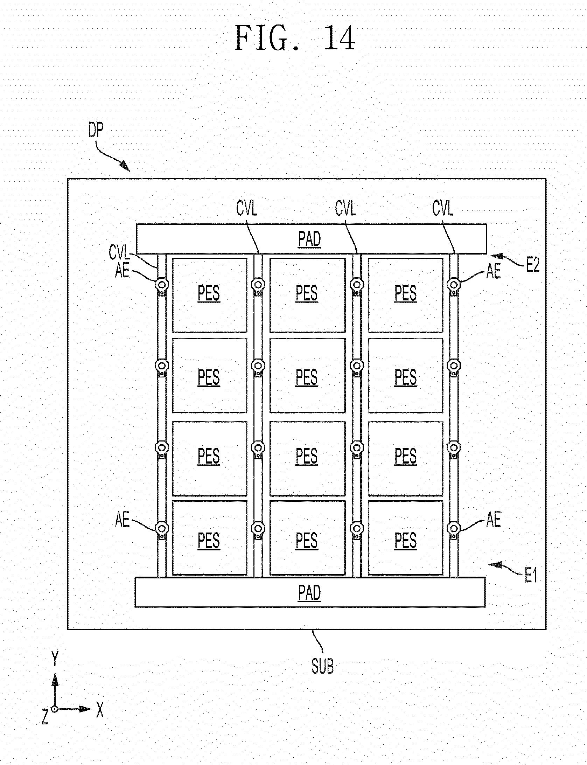

FIG. 14 is a schematic diagram depicting components of a display panel associated with measuring backplane wiring resistance, according to one or more embodiments of the present disclosure.

Referring to FIG. 14, the backplane wiring resistance (e.g., BP resistance of BP wiring resistance) of the display panel DP according to one or more embodiments may be in the range of about 0.03 ohms (Ω) to about 0.40 ohms (Ω). For example, the backplane wiring resistance may be in a range of about 0.03 ohms (Ω) to about 0.40 ohms (Ω). There are multiple alternate systems and methods that can be used for measurement of the backplane wiring resistance as a person of ordinary skill in the art would appreciate. Further, a person of ordinary skill in the art, without undue experimentation, should be able to devise a system and/or a method for measuring and/or determining the backplane wiring resistance in a display device (or a display panel). Therefore, embodiments of the present disclosure do not require and are not associated with any particular method or system for backplane wiring resistance measurement.

The display panel DP may include a substrate SUB. A pad PAD may be located on the substrate SUB, wherein a power source voltage ELVSS is received by the display panel DP. The pad PAD may be located at a first end E1 of the display panel DP. The pad PAD may be connected at the first end E1 to one or more common voltage lines CVL. The common voltage lines CVL may be connected to one or more auxiliary electrodes AE. The auxiliary electrodes AE may be associated with one or more pixel-electrode sets PES. According to one or more embodiments of the present disclosure, the backplane wiring resistance may be measured on one of the common voltage lines CVL from the first end E1, wherein the common voltage line CVL is connected to the pad PAD, to an opposite end of the common voltage line CVL at a second end E2 (e.g., an opposite end of the display panel DP). For example, the first end E1 and the second end E2 correspond to opposite ends of the display panel DP.

In one or more embodiments, an 83-inch display (e.g., an 83-inch 4K display) may have a backplane wiring resistance of about 0.1 ohms (Ω). In one or more embodiments, a 26.5-inch display (e.g., a 26.5-inch 5K display) may have a backplane wiring resistance of about 0.37 ohms (Ω). In one or more embodiments, a common voltage line CVL may include a double layer line or a triple layer line (e.g., triplex wiring). In one or more embodiments, a backplane wiring resistance may be about 0.03 ohms (Ω) when the common voltage line CVL includes three layers.

According to one or more embodiments, a resistance of one of the common voltage lines is in a range of about 0.003 ohms (Ω) to about 0.4 (Ω). A person of ordinary skill in the art would understand how to measure the resistance of the common voltage line. By way of example, the range of about 0.003 ohms (Ω) to about 0.4 (Ω) may be measured from one end (e.g., connected to a pad) to an opposite end (e.g., connected to another pad) of the common voltage line. According to one or more embodiments, one of the common voltage lines (e.g., CVL, CVL1, CVL2, and/or CVL3 of FIGS. 11A-11D) includes at least one of Ag, Mg, Ti, Al, Cu, ITO, and/or a combination thereof.

According to one or more embodiments, a display device (or a display panel DP) includes: a substrate SUB (e.g., a base substrate BS); a plurality of common voltage lines CVL on the substrate SUB; a plurality of connection electrodes AE (e.g., a plurality of auxiliary electrodes AE) on the plurality of common voltage lines CVL, at least one of the plurality of connection electrodes AE being electrically connected to a corresponding one of the plurality of common voltage lines CVL; a plurality of pixel electrode sets PES spaced from the plurality of connection electrodes AE, each of the pixel electrode sets PES including a first pixel electrode, a second pixel electrode, and a third pixel electrode to realize a full color pixel; an emission layer EL on the plurality of connection electrodes AE and the plurality of pixel electrode sets PES, the emission layer EL having a plurality of emission-layer openings ELOP, each emission-layer opening of the plurality of emission-layer openings corresponding to a different respective one of the plurality of connection electrodes AE, a total number of the emission-layer openings ELOP being 25% or less of a total number of the pixel electrode sets PES; and a common electrode CME on the emission layer EL, and electrically connected to the connection electrodes through the plurality of emission-layer openings.

According to one or more embodiments, a display device (or a display panel DP) includes: a substrate SUB (or a base substrate BS); a plurality of common voltage lines CVL on the substrate SUB; a plurality of connection electrodes AE (e.g., a plurality of auxiliary electrodes AE) on the plurality of common voltage lines CVL, at least one of the plurality of connection electrodes AE being electrically connected to a corresponding one of the plurality of common voltage lines CVL; a plurality of pixel electrode sets PES spaced from the plurality of connection electrodes AE, each of the pixel electrode sets PES including a first pixel electrode PE, a second pixel electrode PE, and a third pixel electrode PE to realize a full color pixel; an emission layer EL on the plurality of connection electrodes AE and the plurality of pixel electrode sets PES, the emission layer having a plurality of emission-layer openings ELOP, a largest width of one of the emission-layer openings being in a range of about 1 μm to about 30 μm; and a common electrode CME on the emission layer EL, and electrically connected to the connection electrodes AE through the plurality of emission-layer openings ELOP.

According to one or more embodiments, a display device (or a display panel DP) includes: a substrate SUB (e.g., a base substrate BS); a plurality of common voltage lines CVL on the substrate SUB; a plurality of connection electrodes AE on the plurality of common voltage lines CVL, at least one of the plurality of connection electrodes AE being electrically connected to a corresponding one of the plurality of common voltage lines CVL; a plurality of pixel electrode sets PES spaced from the plurality of connection electrodes AE, each of the pixel electrode sets PES including a first pixel electrode PE, a second pixel electrode PE, and a third pixel electrode PE to realize a full color pixel; an emission layer EL on the plurality of connection electrodes AE and the plurality of pixel electrode sets PES, the emission layer EL having a plurality of emission-layer openings ELOP; and a common electrode CME (e.g., a cathode electrode) on the emission layer EL, and electrically connected to the connection electrodes AE through the plurality of emission-layer openings ELOP. The common electrode CME has a thickness in a range of about 60 angstroms (Å) to about 140 angstroms (Å).

**The Relationship Between the Four Parameters and IR-Drop**

FIG. 15 is a graph depicting an IR-drop scatter plot, according to one or more embodiments of the present disclosure.

FIG. 16 is a table for determining a relationship between the four parameters and the IR-drop in a display panel, according to one or more embodiments of the present disclosure.

An IR-drop associated with a given display panel may be determined (e.g., approximated) and/or modified based on an equation, or equations, expressing the relationship between the four parameters. By way of example, the equation or equations may be derived by fitting simulation results to a polynomial having a number of constants and four parameters. The equation, or equations, may be used to determine whether a given combination of the four parameters may result in an IR-drop that is acceptable for a given application. For example, a given combination of parameters may be selected for implementation based on determining that it will result in an IR-drop that is less than a specific voltage below which luminosity irregularities are unlikely to occur.

Referring to FIG. 15, the IR-drop scatter plot shows a distribution of IR-drop (e.g., a voltage drop) values in units of volts (V) based on IR-drop values generated through one or more simulations and IR-drop values calculated utilizing an equation (e.g., a polynomial equation, Equation 1 shown below) derived from the generated IR-drop values. In the IR-drop scatter plot of FIG. 15, the x-axis (i.e., the horizontal axis or y) represents the generated IR-drop values generated through simulation, and the y-axis (i.e., the vertical axis or y fit) represents the calculated IR-drop values output from the equation derived from the generated IR-drop values. The equation represents the generated IR-drop values such that the calculated IR-drop values fit or substantially fit the generated IR-drop values. As can be seen in the IR-drop scatter plot of FIG. 15, $R^2 = 0.9996$, which means that the calculated IR-drop values nearly perfectly fit with the generated IR-drop values.

FIG. 16 illustrates a table of IR-drop values generated through simulation according to one or more embodiments of the present disclosure. The generated IR-drop values were used to derive Equation 1 below. In Equation 1, "1μ" may equate to "$1*10^{-6}$" in one or more embodiments.

$$\text{IR-drop[V]} = ((2.083 * x4) - (7.1e^{-03} * x3) - (4.94e^{-05} * x2) + (1.758e^{-05} * x2 * x3) + (4.3e^{-03} * x1 * x4) + 0.266 + (3.544e^{-04} * x3^2) - (0.18 * x4^2)) * I/(1\mu * \text{Horizontal Resolution} * \text{Vertical Resolution}) \qquad \text{[Equation 1]}$$

During the one or more simulations to generate the IR-drop values, a current per pixel (e.g., a pixel including a red (R) subpixel, a green (G) subpixel, and a blue (B) subpixel) was set to 1 micro amp (1μA). Therefore, in Equation 1, 1μ * Horizontal Resolution * Vertical Resolution is used as a denominator to normalize the IR-drop values. By way of example, the Horizontal Resolution may be 3840, which is a number of pixels in each row (i.e., in a horizontal direction) and the Vertical Resolution may be 2160, which is a number of pixels in each column (i.e., in a vertical direction). Of course, values represented in the denominator may be different in other embodiments or simulations where the amount of current per pixel used, the number of pixels in each row, and/or the number of pixels in each column, may be different.

In addition, while Equation 1 includes a number of constants (i.e., 2.083, $7.1e^{-03}$, $4.94e^{-05}$, $1.758e^{-05}$, $4.3e^{-03}$, 0.266, $3.544e^{-04}$, 0.18) and 4 parameters, x1, x2, x3, and x4, the present disclosure is not limited thereto, and other constants and/or other combinations with parameters x1, x2, x3, and x4 may be utilized to derive a polynomial that can calculate (and output) calculated IR-drop values that have a similar, same or better fit with the generated IR-drop values generated through simulation.

As can be seen in Equation 1 above, the simulation-generated IR-drop values across the display panel were used to generate Equation 1 based on 4 parameters, x1, x2, x3, and x4. Here, x1 corresponds to the resistance of the laser drill hole (i.e., the laser drill opening) contact LD CNT Res. in units of ohms (Ω); x2 corresponds to a sheet resistance of the common electrode (i.e., the cathode electrode) Cathode Rs in units of ohms/□ (Ω/□); x3 corresponds to an interval between the laser drill holes (i.e., laser drill openings) LD Interval in terms of number of pixels corresponding to adjacent laser drill holes; and x4 corresponds to a backplane resistance BP Res. in units of ohms (Ω), in which the backplane resistance is defined as a resistance (e.g., a measured resistance) from a pad connected to one end of a common voltage line at one side of the display panel to an opposite end of the common voltage line at an opposite side of the display panel.

In the above Equation 1, I is an ELVSS panel current in units of amps (A). Because IR-drop simulation was performed with the unit pixel EL current set to 1 μA in a panel having a Horizontal Resolution and a Vertical Resolution, the IR-drop values were calculated by multiplying with the measured ELVSS panel current I, and dividing by 1μ as well as the Horizontal Resolution (e.g., the number of pixels in the horizontal direction) and the Vertical Resolution (e.g., the number of pixels in the vertical direction) of the display panel. The constants and combinations of the parameters in Equation 1 have been derived through experiments, calculations and/or simulations. While certain constants and a combination of parameters have been used for Equation 1, the present disclosure is not limited thereto. In other embodiments of the present disclosure, different constants may be applied, and different combinations of the parameters may be applied to maintain a suitable emission transmittivity of the light emitting elements while controlling the IR-drop of the common electrode to reduce or prevent mura with the goal of realizing a top emission display panel having a LRU of at least about 70%. In one or more embodiments, the LRU of about 60% may be acceptable, and in other embodiments, the LRU of more than about 70% (e.g., 80% or more) may be desired or required.

Referring still to FIG. 16, a table of IR-drop values (generated through one or more simulations, i.e., Design of Experiment) is divided into two regions, Region 1 and Region 2. As can be seen in FIG. 16, Region 1 is where the generated IR-drop values are acceptable, and Region 2 is where the generated IR-drop value are possibly not acceptable.

The simulation was performed with different combinations of values for x1, x2, x3, and x4. By way of example, as can be seen in the table of FIG. 16, values of 5, 100, 200, 500, and 1,000 ohms (Ω) were used for the parameter x1: LD CNT Res. (i.e., laser drill opening contact resistance); values of 5, 30, and 50 ohms/□ (Ω/□) were used for the parameter x2: Cathode Rs. (i.e., sheet resistance of the common electrode (i.e., the cathode electrode)); values of 1, 3, 6, 12 and 18 were used for the parameter x3: LD Interval (i.e., a number of pixels corresponding to an interval between two adjacent laser drill openings); and values of 0.1, 0.2, 0.3, and 0.4 ohms (Ω) were used for the parameter x4 BP Res. (i.e., the backplane resistance or the resistance of a common voltage line from one end connected to a pad at one end of a display panel to an opposite end of the common voltage line located at an opposite end of the display panel).

As can be seen in the table of FIG. 16, as long as the parameter x4 BP Res. is 0.3 ohms (Ω) or 0.4 ohms (Ω), the IR-drop values fall within Region 2, which is a region in which the IR-drop is possibly not acceptable to realize a desired (or suitable) quality display panel (i.e., a display panel having an LRU of at least 70%). Meanwhile, when the parameter x4 BP Res is 0.1 ohms (Ω), all generated IR-drop values fall within Region 1 regardless of the values of other parameters, and when the parameter x4 BP Res.is 0.2 ohms (Ω), most generated IR-drop values fall within Region 1. As such, x4 BP Res. appears to be the most critical parameter when one or more simulations were used to generate the IR-drop values. However, the present disclosure is not limited thereto, and depending on the constants and combinations of parameters used, other parameters may have more weight (e.g., may become more significant) in generating the IR-drop values.

By way of example, when x1 is 5 ohms (Ω), x2 is 5 ohms/□ (Ω/□), and x4 is 0.1 ohms (Ω), the generated IR-drop values vary based on the applied values for the parameter x3. Here, when the values of the parameter x3 LD interval are 3, 6, and 12, respectively, the respective generated IR-drop values are 0.4568 volts (V), 0.4570 volts (V), and 0.4579 volts (V). By way of another example, when x1 is 5 ohms (Ω), x3 is 12, and x4 is 0.1 ohms (Ω), the generated IR-drop values vary based on the applied values for the parameter x2. Here, when the values of the parameter x2 is 5, 30, and 50 ohms/□ (Ω/□), respectively, the respective generated IR-drop values are 0.4579 volts (V), 0.4633 volts (V), and 0.4646 volts (V).

According to one or more embodiments of the present disclosure, a method of manufacturing a display panel is provided, in which values of the parameters x1: LD CNT Res., x2: Cathode Rs., x3: LD Interval, and x4 BP Res. in Equation 1 are adjusted to realize an acceptable (i.e., desired or suitable) IR-drop value (to be within Region 1) to achieve an LRU of at least 70% (or any other desired or suitable LRU %), As shown in the table of FIG. 16, the IR-drop value range is from about 0.4567 volts (V) (when x1 is 5 ohms (Ω), x2 is 5 ohms/□ (Ω/□), x3 is 1, and x4 is 0.1 ohms (Ω)) to about 0.7920 volts (V) (when x1 is 1,000 ohms (Ω), x2 is 5 ohms/□ (Ω/□), x3 is 12, and x4 is 0.2 ohms (Ω)), which is in a range of about 0.45 volts (V) to about 0.80 volts (V). In one or more embodiments, a display panel is manufactured using the method in which the generated IR-drop value range is calculated to be in a range of about 0.4567 volts (V) to about 0.7920 volts (V) (or in a range of about 0.45 volts (V) to about 0.80 volts (V)). In one or more embodiments, the IR-drop value may be in a range of about 0.40 volts (V) to about 0.80 volts (V), of about 0.50 volts (V) to about 0.75 volts (V), or of about 0.60 volts (V) to about 0.70 volts (V). A person of ordinary skill in the art will be able to measure an IR-drop associated with (or across) a display panel using a suitable method known to those skilled in the art, or can devise a suitable IR-drop measuring method without undue experimentation.

A display device includes: a substrate SUB (or a base substrate BS); a plurality of common voltage lines CVL on the substrate; a plurality of connection electrodes AE on the plurality of common voltage lines CVL, at least one of the plurality of connection electrodes being electrically connected to a corresponding one of the plurality of common voltage lines; a plurality of pixel electrode sets PES spaced from the plurality of connection electrodes AE, each of the pixel electrode sets PES including a first pixel electrode PE, a second pixel electrode PE, and a third pixel electrode PE to realize a full color pixel; an emission layer EL on the plurality of connection electrodes AE and the plurality of pixel electrode sets PES, the emission layer EL having a plurality of openings ELOP; and a common electrode CME on the emission layer EL, and electrically connected to the connection electrodes AE through the plurality of openings ELOP. An IR-drop of the display device is less than or equal to about 0.80.

According to one or more embodiments, the IR-drop of the display device may be in a range of about 0.45 volts to about 0.80 volts; may be in a range of about 0.50 volts to about 0.75 volts; may be in a range of about 0.55 volts to about 0.70 volts; may be in a range of about 0.45 volts to about 0.55 volts; may be in a range of about 0.50 volts to about 0.60 volts; or may be in a range of about 0.4567 to about 0.7920 volts.

According to one or more embodiments, the IR-drop may conform to an output of an equation, where IR-drop = $((2.083 * x4) - (7.1e^{-03} * x3) - (4.94e^{-05} * x2) + (1.758e^{-05} * x2 * x3) + (4.3e^{-03} * x1 * x4) + 0.266 + (3.544e^{-04} * x3^2) - (0.18 * x4^2)) * I / (1\mu * \text{Horizontal Resolution} * \text{Vertical Resolution})$, wherein: I is a panel current; x1 is a resistance through one of the plurality of emission layer openings ELOP; x2 is a sheet resistance of the common electrode CME; x3 is an interval between nearest ones of the plurality of emission layer openings ELOP; and x4 is a resistance of one of the common voltage lines CVL.

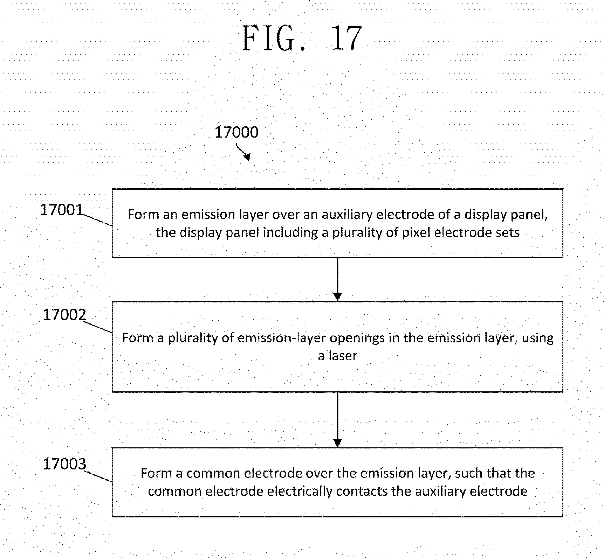

FIG. 17 depicts example operations of a method for manufacturing a display panel, according to one or more embodiments of the present disclosure.

According to one or more embodiments of the present disclosure, a method 17000 may include one or more of the following operations. An emission layer EL may be formed over an auxiliary electrode AE of a display device (or a display panel DP). The emission layer may include one or more layers, and may be deposited using vapor deposition, for example. The display panel (or the display panel DP) may include a plurality of pixel electrode sets PES (operation 17001). A plurality of emission-layer openings ELOP may be formed in the emission layer EL, using a laser (operation 17002). In one or more embodiments, the plurality of emission-layer openings ELOP may be spaced according to an interval (e.g., an interval of one emission-layer opening ELOP per four, or more, pixel electrode sets). However, the present disclosure is not limited thereto. In one or more embodiments, for example, there may be one emission-layer opening ELOP per pixel (e.g., per pixel electrode set). A common electrode CME may be formed over the emission layer EL (operation 17003). The common electrode CME may contact (e.g., may electrically contact) the auxiliary electrode AE (operation 17003).

In other embodiments, intervals between the emission-layer openings may be varied as shown and described herein, and/or one or more chess patterns may be formed of the emission-layer openings as shown and described herein.

As discussed above in reference to FIGS. 15 and 16, according to one or more embodiments of the present disclosure, a display device (or a display panel) having an acceptable IR-drop is realized. There are multiple alternate systems and methods that can be used for measurement of IR-drop as a person of ordinary skill in the art would appreciate. Further, a person of ordinary skill in the art, without undue experimentation, should be able to devise a system and/or a method for measuring and/or determining IR-drop in a display device (or a display panel). Therefore, embodiments of the present disclosure do not require and are not associated with any particular method or system for IR-drop measurement.

By way of an example, IR-drop may be measured by measuring a saturation ELVDD to confirm a Max Load (maximum load) voltage and a Min Load (minimum load) voltage. By way of example, the Max Load voltage may be the saturation operation voltage (e.g., the saturation ELVDD) under the Max Load condition, and the Min Load voltage may be the saturation operation voltage (e.g., the saturation ELVDD) under the Min Load condition, but are not limited thereto. For example, an IR-drop may be defined by the below Equation 2:

$$\text{IR-drop} = \text{Max Load voltage} - \text{Min Load voltage} \quad [\text{Equation 2}]$$

The process/procedure outlined below is one current example, and may be changed or improved, and setting conditions and/or parameters such as operation voltage (e.g., ELVDD) measuring intervals may be different in other examples, or may be updated. As such, the below process/procedure is merely one example, and the present disclosure is not limited thereto.

By way of example, a saturated operation voltage (e.g., saturated ELVDD) may be measured (or determined) by sweeping the operation voltage (e.g., ELVDD) and determining the value of the operation voltage (e.g., ELVDD) at which a change in reference to color coordinates (e.g., CIEx) is 0.002 or a change in reference to luminance is 1%. As for a measurement condition, the color coordinates and/or luminance may be measured with a measurement pattern at a center of a display panel. The size of the measurement pattern may be 80x80 (80 pixels by 80 pixels), and measurements may be taken while varying the gray levels of the measurement pattern from 0 to 255 by an interval of 4 gray levels.

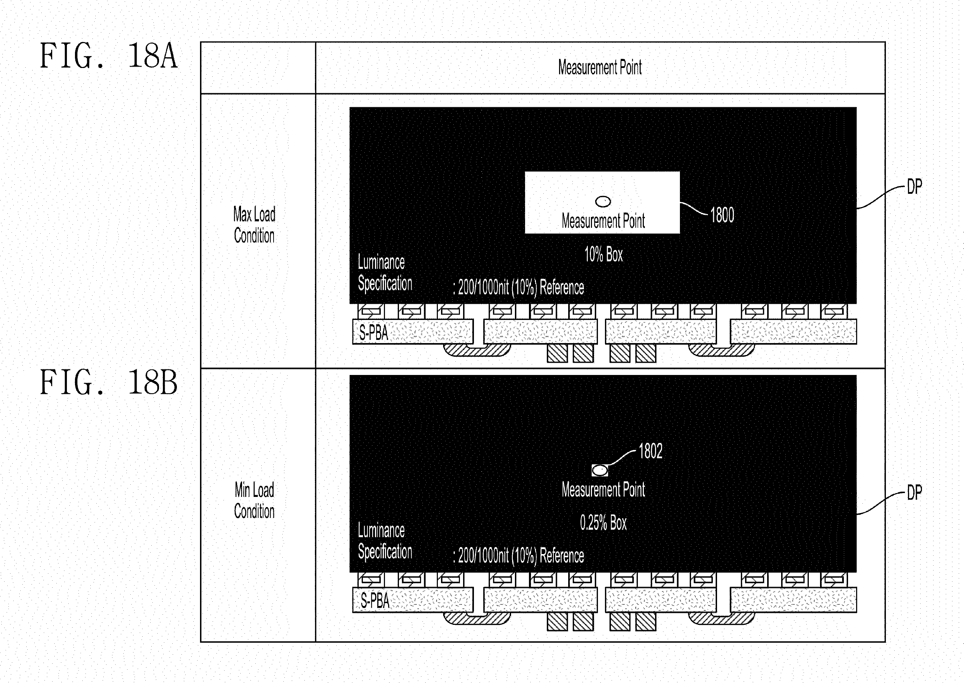

FIG. 18A and FIG. 18B illustrate display panels configured for measuring luminance and/or color coordinates to determine IR-drop, according to one or more embodiments of the present disclosure.

As can be seen in FIG. 18A, for measuring luminance in a Max Load condition, a load box 1800 may be located at a central region of the display panel DP, and a center pattern (e.g., only the center pattern) may be varied by an interval of 4 gray levels to measure luminance. For example, the load box 1800 may have a 10% load, and may have a fixed pattern of 255 gray levels.

As can be seen in FIG. 18B. for measuring luminance in a Min Load condition, a load box 1802 may be located at a central region of the display panel DP, and a center pattern (e.g., only the center pattern) may be varied by an interval of 4 gray levels to measure luminance. For example, the load box 1802 may have a 0.25% load, and may be fixed at black (e.g., 0 gray level).

By way of example, the saturation operation voltage (e.g., the saturation ELVDD) may be determined by a graph of delta ($\Delta$) Luminance / delta ($\Delta$) Gray.

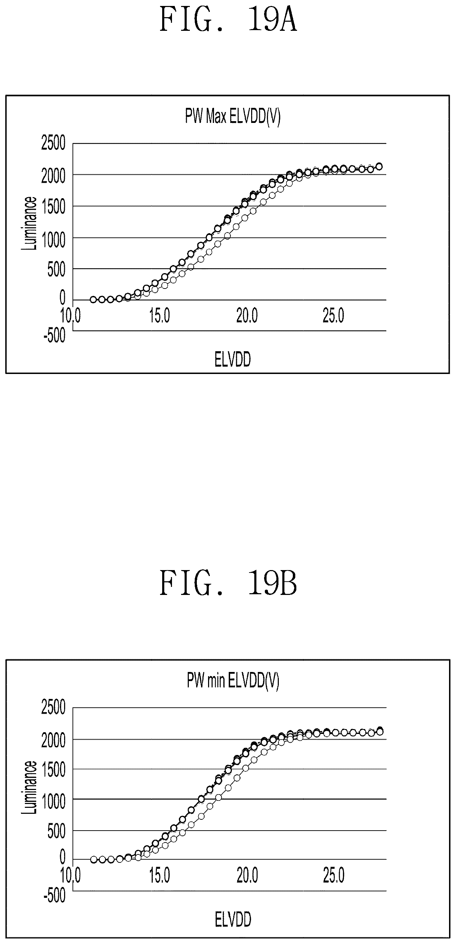

FIGS. 19A and 19B are graphs of luminance with respect to ELVDD, according to one or more embodiments of the present disclosure. As can be seen in FIGS. 19A and 19B, a luminance (e.g., a target luminance) of 2,000 nits may correspond to a saturation operation voltage (e.g., a saturation ELVDD) in a range of about 23 volts to 24 volts.

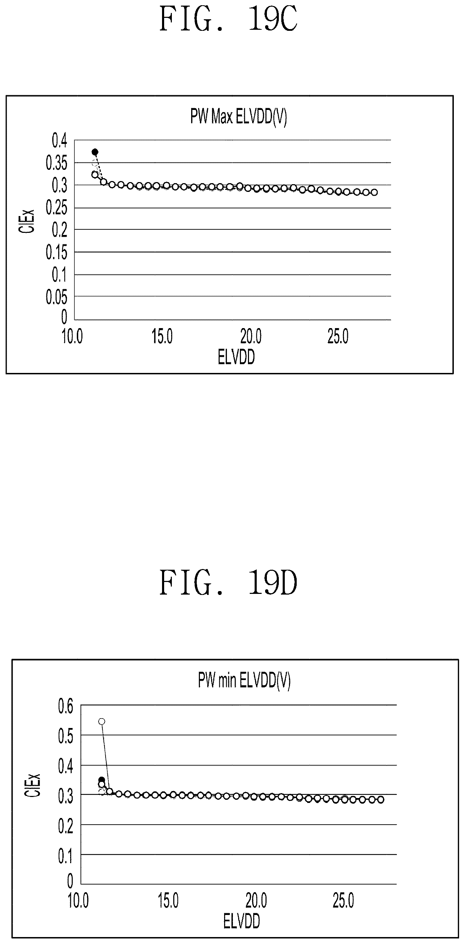

FIGS. 19C and 19D are graphs of color coordinate values (e.g., CIEx) with respect to ELVDD, according to one or more embodiments of the present disclosure. As can be seen in FIGS. 19C and 19D, the color coordinate value is just below 0.3 when the operation voltage (e.g., ELVDD) is in a range of about 23 volts to 24 volts.

As discussed above, a display panel having a LRU of less than 70% may exhibit irregularities (e.g., mura), such as a stain (e.g., a discoloration). There are multiple alternate systems and methods that can be used for measurement of LRU as a person of ordinary skill in the art would appreciate. Further, a person of ordinary skill in the art, without undue experimentation, should be able to devise a system and/or a method for measuring and/or determining LRU in a display device (or a display panel). Therefore, embodiments of the present disclosure do not require and are not associated with any particular method or system for LRU measurement.

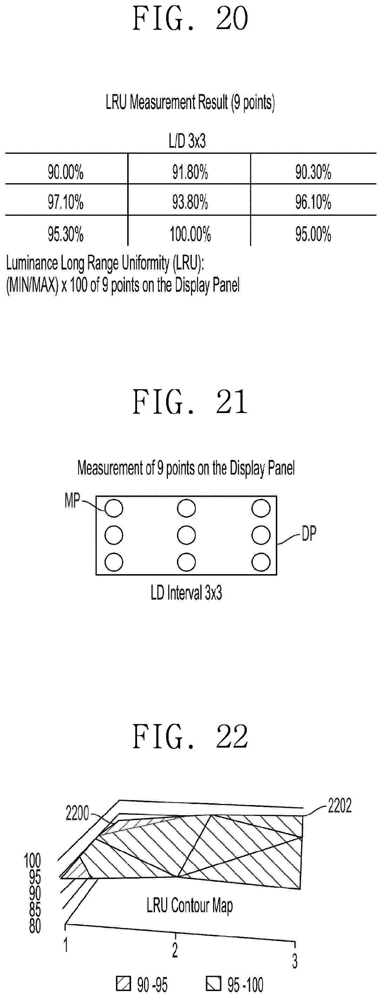

FIG. 20 is a table of results from luminance measurements taken at 9 points on a display panel to determine Long Range Uniformity (LRU), according to one or more embodiments of the present disclosure. For example, the display panel used for the measurements in the table of FIG. 20 may have laser drill hole (i.e., LD hole) intervals of 3x3, however, the present disclosure is not limited thereto. The values shown in the table are 90.00%, 91.80%, 90.30%, 97.10%, 93.80%, 96.10%, 95.30%, 100.00%, and 95.00%. The luminance LRU is calculated by Equation 3 below.

$$LRU = MIN/MAX * 100 \qquad \text{[Equation 3]}$$

FIG. 21 is a schematic diagram of a display panel showing 9 points where the luminance measurements of FIG. 20 are taken, according to one or more embodiments of the present disclosure. The display panel DP is shown in FIG. 21 as having 9 measuring points MP. However, an example LRU measuring method is not limited thereto. By way of example, 4x4 (=16), 5x5 (=25), 6x6 (=36) or 7x7 (=49) measuring points may be used instead, without being limited thereto, for measuring LRU.

FIG. 22 is a contour map of luminance measurements, according to one or more embodiments of the present disclosure. The contour map of FIG. 22 shows relatively lower luminance regions 2200 and relatively higher luminance regions 2202.

While embodiments of the present disclosure have been described in connection with what are presently considered to be practical embodiments, it is to be understood that the present disclosure is not limited to the disclosed embodiments. On the contrary, it is intended to cover various modifications and equivalent arrangements included within the spirit of the appended claims.

Embodiments are set out in the following clauses:

Clause 1. A display device comprising:

a substrate;
a plurality of common voltage lines on the substrate;
a plurality of connection electrodes on the plurality of common voltage lines, at least one of the plurality of connection electrodes being electrically connected to a corresponding one of the plurality of common voltage lines;
a plurality of pixel electrode sets spaced from the plurality of connection electrodes, each of the pixel electrode sets comprising a first pixel electrode, a second pixel electrode, and a third pixel electrode to realize a full color pixel;

an emission layer on the plurality of connection electrodes and the plurality of pixel electrode sets, the emission layer having a plurality of openings, each of the plurality of openings corresponding to a different respective one of the plurality of connection electrodes, a total number of the openings being 25% or less of a total number of the pixel electrode sets; and

a common electrode on the emission layer, and electrically connected to the connection electrodes through the plurality of openings.

Clause 2. The display device of clause 1, wherein the plurality of openings comprises laser drilled holes.

Clause 3. The display device of clause 1 or clause 2, wherein the total number of the openings is in a range of 700 to 3,700,000.

Clause 4. The display device of any of clauses 1 to 3, wherein the total number of the openings is in a range of 57,000 to 920,000.

Clause 5. The display device of any preceding clause, wherein a distance between nearest ones of the openings is in a range of about 1.1 mm to about 20 mm.

Clause 6. The display device of any preceding clause,

wherein the plurality of pixel electrode sets comprises a plurality of groups of pixel electrode sets, each of the plurality of groups of pixel electrode sets comprising a plurality of subgroups of pixel electrode sets, and

wherein only one of the plurality of subgroups in one of the plurality of groups has corresponding ones of the openings.

Clause 7. The display device of clause 6, wherein the subgroups in the plurality of groups of pixel electrode sets having corresponding ones of the openings define hole-forming areas, and wherein a width of one of the hole-forming areas is equal to a distance between two nearest ones of the hole-forming areas.

Clause 8. The display device of clause 6 or clause 7, wherein a number of the plurality of subgroups in one of the groups of pixel electrode sets is in a range of 4 to 64.

Clause 9. The display device of any of clauses 6 to 8, wherein a ratio between a total number of pixel electrode sets and a total number of openings in the one of the plurality of subgroups is in a range of 1 to 64.

Clause 10. The display device of any of clauses 6 to 9, wherein the plurality of groups of pixel electrode sets are arranged in a matrix.

Clause 11. The display device of clause 10, wherein the plurality of subgroups of the pixel electrode sets in each of the plurality of groups are arranged in a matrix.

Clause 12. The display device of any preceding clause,

wherein the display device comprises a 65-inch display panel, and
wherein the total number of the openings is in a range of 57,000 to 920,000.

Clause 13. The display device of any preceding clause, wherein a ratio between the total number of the pixel electrode sets and the total number of the openings is in a range of 4 to 5,184.

Clause 14. The display device of any of clauses 1 to 13, wherein a ratio between the total number of the openings and the total number of the pixel electrode sets is in a range of 1/144 to 1/9.

Clause 15. The display device of any preceding clause, wherein a largest width of one of the openings is in a range of about 1 $\mu$m to about 30 $\mu$m.

Clause 16. The display device of clause 15, wherein the largest width of the one of the openings is at least about 3 $\mu$m.

Clause 17. The display device of clause 16, wherein the largest width of the one of the openings is in a range of about 4 μm to about 7 μm.

Clause 18. The display device of clause 17, wherein the largest width of the one of the openings is in a range of about 4 μm to about 5 μm.

Clause 19. The display device of clause 16, wherein the largest width of the one of the openings is in a range of about 3 μm to about 20 μm.

Clause 20. The display device of any preceding clause, wherein a contact resistance of one of the openings is in a range of about 1 $\Omega$ to about 1,000 $\Omega$.

Clause 21. The display device of any preceding clause, wherein a thickness of the common electrode is in a range of about 40 Å to about 200 Å.

Clause 22. The display device of clause 21, wherein a thickness of the common electrode is in a range of about 50 Å to about 140 Å.

Clause 23. The display device of clause 22, wherein the common electrode comprises Yb Ag:Mg.

Clause 24. The display device of clause 23, wherein the common electrode has a sheet resistance of about 9.7 $\Omega/\square$ to about 50 $\Omega/\square$.

Clause 25. The display device of clause 24, wherein the common electrode has a thickness in a range of about 40 Å to about 140 Å.

Clause 26. The display device of any preceding clause, wherein the common electrode has a sheet resistance of less than about 32 $\Omega/\square$.

Clause 27. The display device of any preceding clause, wherein a resistance of one of the common voltage lines from one end to an opposite end is in a range of about 0.03 $\Omega$ to about 0.4 $\Omega$.

Clause 28. The display device of any preceding clause, wherein one of the common voltage lines comprises a plurality of layers of metals.

Clause 29. A display device comprising:

a substrate;
a plurality of common voltage lines on the substrate;
a plurality of connection electrodes on the plurality of common voltage lines, at least one of the plurality of connection electrodes being electrically connected to a corresponding one of the plurality of common voltage lines;
a plurality of pixel electrode sets spaced from the plurality of connection electrodes, each of the pixel electrode sets comprising a first pixel electrode, a second pixel electrode, and a third pixel electrode to realize a full color pixel;
an emission layer on the plurality of connection electrodes and the plurality of pixel electrode sets, the emission layer having a plurality of openings; and
a common electrode on the emission layer, and electrically connected to the connection electrodes through the plurality of openings,
wherein an IR-drop of the display device is less than or equal to about 0.80 volts.

Clause 30. The display device of clause 29, wherein the IR-drop of the display device is in a range of about 0.40 volts to about 0.80 volts.

Clause 31. The display device of clause 29 or clause 30, wherein the IR-drop of the display device is in a range of about 0.4567 volts to about 0.7920 volts.

Clause 32. The display device of any of clauses 29 to 31, wherein the IR-drop of the display device is in a range of about 0.50 volts to about 0.75 volts.

Clause 33. The display device of any of clauses 29 to 32, wherein the IR-drop of the display device is in a range of about 0.60 volts to about 0.70 volts.

Clause 34. The display device of any of clauses 29 to 33, wherein the IR-drop conforms with an output of an equation, where IR-drop = $((2.083 * x4) - (7.1e^{-03} * x3) - (4.94e^{-05} * x2) + (1.758e^{-05} * x2 * x3) + (4.3e^{-03} * x1 * x4) + 0.266 + (3.544e^{-04} * x3^2) - (0.18 * x4^2)) * I / ( 1\mu * Horizontal Resolution * Vertical Resolution)$, and wherein:

I is a panel current;
x1 is a resistance through one of the plurality of openings;
x2 is a sheet resistance of the common electrode;
x3 is an interval between nearest ones of the plurality of openings; and
x4 is a resistance of one of the common voltage lines.

Clause 35. A display device comprising:

a substrate;
a plurality of common voltage lines on the substrate;
a plurality of connection electrodes on the plurality of common voltage lines, at least one of the plurality of connection electrodes being electrically connected to a corresponding one of the plurality of common voltage lines;
a plurality of pixel electrode sets spaced from the plurality of connection electrodes, each of the pixel electrode sets comprising a first pixel electrode, a second pixel electrode, and a third pixel electrode to realize a full color pixel;
an emission layer on the plurality of connection electrodes and the plurality of pixel electrode sets, the emission layer having a plurality of openings, a largest width of one of the openings being in a range of about 1 $\mu$m to about 30 $\mu$m; and
a common electrode on the emission layer, and electrically connected to the connection electrodes through the plurality of openings.

Clause 36. The display device of clause 35, wherein the plurality of openings comprises laser drilled holes.

Clause 37. The display device of clause 35 or clause 36, wherein the largest width of the one of the openings is at least about 3 $\mu$m.

Clause 38. The display device of clause 37, wherein the largest width of the one of the openings is in a range of about 4 $\mu$m to about 7 $\mu$m.

Clause 39. The display device of clause 38, wherein the largest width of the one of the openings is in a range of about 4 $\mu$m to about 5 $\mu$m.

Clause 40. The display device of clause 37, wherein the largest width of the one of the openings is in a range of about 3 $\mu$m to about 20 $\mu$m.

Clause 41. A display device comprising:

a substrate;
a plurality of common voltage lines on the substrate;
a plurality of connection electrodes on the plurality of common voltage lines, at least one of the plurality of connection electrodes being electrically connected to a corresponding one of the plurality of common voltage lines;
a plurality of pixel electrode sets spaced from the plurality of connection electrodes, each of the pixel electrode sets comprising a first pixel electrode, a second pixel electrode, and a third pixel electrode to realize a full color pixel;
an emission layer on the plurality of connection electrodes and the plurality of pixel electrode sets, the emission layer having a plurality of openings; and

a common electrode on the emission layer, and electrically connected to the connection electrodes through the plurality of openings, the common electrode having a thickness in a range of about 60 Å to about 140 Å.

Clause 42. The display device of clause 41, wherein a thickness of the common electrode is in a range of about 70 Å to about 140 Å.

Clause 43. The display device of clause 41 or clause 42, wherein the common electrode has a sheet resistance of about 9.7 Ω/□ to about 50 Ω/□.

Clause 44. The display device of any of clauses 41 to 43, wherein the common electrode has a sheet resistance of less than about 32 Ω/□.

Clause 45. A display device comprising:

a substrate;
a plurality of auxiliary voltage lines on the substrate, a resistance of one of the auxiliary voltage lines from one end to an opposite end of the display device being in a range of about 0.003 Ω to about 0.4 Ω;
a plurality of connection electrodes on the plurality of auxiliary voltage lines, at least one of the plurality of connection electrodes being electrically connected to a corresponding one of the plurality of auxiliary voltage lines;
a plurality of pixel electrode sets spaced from the plurality of connection electrodes, each of the pixel electrode sets comprising a first pixel electrode, a second pixel electrode, and a third pixel electrode to realize a full color pixel;
an emission layer on the plurality of connection electrodes and the plurality of pixel electrode sets, the emission layer having a plurality of openings; and
a common electrode on the emission layer, and electrically connected to the plurality of connection electrodes through the plurality of openings.

Clause 46. The display device of clause 45, wherein the resistance of the one of the auxiliary voltage lines is in a range of about 0.03 Ω to about 0.4 Ω.

Clause 47. The display device of clause 45 or clause 46, wherein the plurality of auxiliary voltage lines comprises a plurality of first common voltage lines and a plurality of backplane metal lines extending in a same direction as the plurality of first common voltage lines, one of the plurality of backplane metal lines being electrically connected to a corresponding one of the plurality of first common voltage lines via openings in a first insulation layer located therebetween.

Clause 48. The display device of clause 47, wherein the plurality of auxiliary voltage lines further comprises a plurality of second common voltage lines located between the plurality of first common voltages lines and the plurality of connection electrodes in a thickness direction of the substrate, one of the plurality of second common voltage lines being electrically connected to a corresponding one of the plurality of first common voltage lines via openings in a second insulation layer located therebetween.

Clause 49. The display device of any of clauses 45 to 48, wherein one of the plurality of auxiliary voltage lines comprises a plurality of overlapping common voltage lines spaced from each other in a thickness direction of the substrate, the display device further comprising an insulation layer between two adjacent ones of the plurality of overlapping common voltage lines in the thickness direction, the two adjacent ones of the plurality of overlapping common voltage lines being electrically connected with each other via openings in the insulation layer.

Clause 50. The display device of clause 49, wherein the plurality of overlapping common voltage lines comprises at least three overlapping common voltage lines that are overlapped with and electrically connected with each other in the thickness direction of the substrate.

**Claims**

1. A display device comprising:

a substrate;

a plurality of common voltage lines on the substrate;

a plurality of connection electrodes on the plurality of common voltage lines, at least one of the plurality of connection electrodes being electrically connected to a corresponding one of the plurality of common voltage lines;

a plurality of pixel electrode sets spaced from the plurality of connection electrodes, each of the pixel electrode sets comprising a first pixel electrode, a second pixel electrode, and a third pixel electrode to realize a full color pixel;

an emission layer on the plurality of connection electrodes and the plurality of pixel electrode sets, the emission layer having a plurality of openings, each of the plurality of openings corresponding to a different respective one of the plurality of connection electrodes, a total number of the openings being 25% or less of a total number of the pixel electrode sets; and

a common electrode on the emission layer, and electrically connected to the connection electrodes through the plurality of openings.

2. The display device of claim 1, wherein:

(i) the plurality of openings comprises laser drilled holes; and/or

(ii) the total number of the openings is in a range of 700 to 3,700,000, or the total number of the openings is in a range of 57,000 to 920,000; and/or

(iii) a distance between nearest ones of the openings is in a range of about 1.1 mm to about 20 mm.

3. The display device of claim 1 or claim 2,

wherein the plurality of pixel electrode sets comprises a plurality of groups of pixel electrode sets, each of the plurality of groups of pixel electrode sets comprising a plurality of subgroups of pixel electrode sets, and

wherein only one of the plurality of subgroups in one of the plurality of groups has corresponding ones of the openings; optionally wherein:

(i) the subgroups in the plurality of groups of pixel electrode sets having corresponding ones of the openings define hole-forming areas, and wherein a width of one of the hole-forming areas is equal to a distance between two nearest ones of the hole-forming areas; and/or

(ii) a number of the plurality of subgroups in one of the groups of pixel electrode sets is in a range of 4 to 64; and/or

(iii) a ratio between a total number of pixel electrode sets and a total number of openings in the one of the plurality of subgroups is in a range of 1 to 64; and/or

(iv) the plurality of groups of pixel electrode sets are arranged in a matrix, further optionally wherein the plurality of subgroups of the pixel electrode sets in each of the plurality of groups are arranged in a matrix.

4. The display device of any preceding claim, wherein:

(i) the display device comprises a 65-inch display panel, and

wherein the total number of the openings is in a range of 57,000 to 920,000; and/or

(ii) a ratio between the total number of the pixel electrode sets and the total number of the openings is in a range of 4 to 5,184; and/or

(iii) a ratio between the total number of the openings and the total number of the pixel electrode sets is in a range of 1/144 to 1/9; and/or

(iv) a largest width of one of the openings is in a range of about 1 $\mu$m to about 30 $\mu$m, optionally wherein the largest width of the one of the openings is at least about 3 $\mu$m, further optionally wherein the largest width of the one of the openings is in a range of about 3 $\mu$m to about 20 $\mu$m, further optionally wherein the largest width of the one of the openings is in a range of about 4 $\mu$m to about 7 $\mu$m, further optionally wherein the largest width of the one of the openings is in a range of about 4 $\mu$m to about 5 $\mu$m.

5. The display device of any preceding claim, wherein:

(i) a contact resistance of one of the openings is in a range of about 1 $\Omega$ to about 1,000 $\Omega$; and/or

(ii) a thickness of the common electrode is in a range of about 40 Å to about 200 Å; optionally wherein a thickness of the common electrode is in a range of about 40 Å to about 140 Å; further optionally wherein the common electrode comprises Yb Ag:Mg, further optionally wherein the common electrode has a sheet resistance of about 9.7 $\Omega/\square$ to about 50 $\Omega/\square$, further optionally wherein the common electrode has a thickness in a range of about 50 Å to about 140 Å.

6.  The display device of any preceding claim, wherein:

> (i) the common electrode has a sheet resistance of less than about 32 $\Omega/\square$; and/or
> (ii) a resistance of one of the common voltage lines from one end to an opposite end is in a range of about 0.03 $\Omega$ to about 0.4 $\Omega$; and/or
> (iii) one of the common voltage lines comprises a plurality of layers of metals.

7.  A display device comprising:

> a substrate;
> a plurality of common voltage lines on the substrate;
> a plurality of connection electrodes on the plurality of common voltage lines, at least one of the plurality of connection electrodes being electrically connected to a corresponding one of the plurality of common voltage lines;
> a plurality of pixel electrode sets spaced from the plurality of connection electrodes, each of the pixel electrode sets comprising a first pixel electrode, a second pixel electrode, and a third pixel electrode to realize a full color pixel;
> an emission layer on the plurality of connection electrodes and the plurality of pixel electrode sets, the emission layer having a plurality of openings; and
> a common electrode on the emission layer, and electrically connected to the connection electrodes through the plurality of openings,
> wherein an IR-drop of the display device is less than or equal to about 0.80 volts.

8.  The display device of claim 7, wherein:

> (i) the IR-drop of the display device is in a range of about 0.40 volts to about 0.80 volts, or the IR-drop of the display device is in a range of about 0.4567 volts to about 0.7920 volts, or the IR-drop of the display device is in a range of about 0.50 volts to about 0.75 volts, or the IR-drop of the display device is in a range of about 0.60 volts to about 0.70 volts; and/or
> (ii) the IR-drop conforms with an output of an equation, where IR-drop = $((2.083 * x4) - (7.1e^{-03} * x3) - (4.94e^{-05} * x2) + (1.758e^{-05} * x2 * x3) + (4.3e^{-03} * x1 * x4) + 0.266 + (3.544e^{-04} * x3^2) - (0.18 * x4^2)) * I / (1\mu * \text{Horizontal Resolution} * \text{Vertical Resolution})$, and

> wherein:

> I is a panel current;
> x1 is a resistance through one of the plurality of openings;
> x2 is a sheet resistance of the common electrode;
> x3 is an interval between nearest ones of the plurality of openings; and
> x4 is a resistance of one of the common voltage lines.

9.  A display device comprising:

> a substrate;
> a plurality of common voltage lines on the substrate;
> a plurality of connection electrodes on the plurality of common voltage lines, at least one of the plurality of connection electrodes being electrically connected to a corresponding one of the plurality of common voltage lines;
> a plurality of pixel electrode sets spaced from the plurality of connection electrodes, each of the pixel electrode sets comprising a first pixel electrode, a second pixel electrode, and a third pixel electrode to realize a full color pixel;
> an emission layer on the plurality of connection electrodes and the plurality of pixel electrode sets, the emission layer having a plurality of openings, a largest width of one of the openings being in a range of about 1 $\mu$m to about 30 $\mu$m; and

a common electrode on the emission layer, and electrically connected to the connection electrodes through the plurality of openings.

10. The display device of claim 9, wherein:

(i) the plurality of openings comprises laser drilled holes; and/or
(ii) the largest width of the one of the openings is at least about 3 $\mu$m, optionally wherein the largest width of the one of the openings is in a range of about 3 $\mu$m to about 20 $\mu$m, optionally wherein the largest width of the one of the openings is in a range of about 4 $\mu$m to about 7 $\mu$m, optionally wherein the largest width of the one of the openings is in a range of about 4 $\mu$m to about 5 $\mu$m.

11. A display device comprising:

a substrate;
a plurality of common voltage lines on the substrate;
a plurality of connection electrodes on the plurality of common voltage lines, at least one of the plurality of connection electrodes being electrically connected to a corresponding one of the plurality of common voltage lines;
a plurality of pixel electrode sets spaced from the plurality of connection electrodes, each of the pixel electrode sets comprising a first pixel electrode, a second pixel electrode, and a third pixel electrode to realize a full color pixel;
an emission layer on the plurality of connection electrodes and the plurality of pixel electrode sets, the emission layer having a plurality of openings; and
a common electrode on the emission layer, and electrically connected to the connection electrodes through the plurality of openings, the common electrode having a thickness in a range of about 60 Å to about 140 Å.

12. The display device of claim 11, wherein:

(i) a thickness of the common electrode is in a range of about 70 Å to about 140 Å; and/or
(ii) the common electrode has a sheet resistance of about 9.7 $\Omega/\square$ to about 50 $\Omega/\square$; and/or
(iii) the common electrode has a sheet resistance of less than about 32 $\Omega/\square$.

13. A display device comprising:

a substrate;
a plurality of auxiliary voltage lines on the substrate, a resistance of one of the auxiliary voltage lines from one end to an opposite end of the display device being in a range of about 0.003 $\Omega$ to about 0.4 $\Omega$;
a plurality of connection electrodes on the plurality of auxiliary voltage lines, at least one of the plurality of connection electrodes being electrically connected to a corresponding one of the plurality of auxiliary voltage lines;
a plurality of pixel electrode sets spaced from the plurality of connection electrodes, each of the pixel electrode sets comprising a first pixel electrode, a second pixel electrode, and a third pixel electrode to realize a full color pixel;
an emission layer on the plurality of connection electrodes and the plurality of pixel electrode sets, the emission layer having a plurality of openings; and
a common electrode on the emission layer, and electrically connected to the plurality of connection electrodes through the plurality of openings.

14. The display device of claim 13, wherein:

(i) the resistance of the one of the auxiliary voltage lines is in a range of about 0.03 $\Omega$ to about 0.4 $\Omega$; and/or
(ii) the plurality of auxiliary voltage lines comprises a plurality of first common voltage lines and a plurality of backplane metal lines extending in a same direction as the plurality of first common voltage lines, one of the plurality of backplane metal lines being electrically connected to a corresponding one of the plurality of first common voltage lines via openings in a first insulation layer located therebetween, optionally wherein:
the plurality of auxiliary voltage lines further comprises a plurality of second common voltage lines located between the plurality of first common voltages lines and the plurality of connection electrodes in a thickness direction of the substrate, one of the plurality of second common voltage lines being electrically connected to a corresponding one of the plurality of first common voltage lines via openings in a second insulation layer located therebetween.

15. The display device of claim 13 or claim 14, wherein one of the plurality of auxiliary voltage lines comprises a plurality of overlapping common voltages lines spaced from each other in a thickness direction of the substrate, the display device further comprising an insulation layer between two adjacent ones of the plurality of overlapping common voltage lines in the thickness direction, the two adjacent ones of the plurality of overlapping common voltage lines being electrically connected with each other via openings in the insulation layer, optionally wherein:
the plurality of overlapping common voltage lines comprises at least three overlapping common voltage lines that are overlapped with and electrically connected with each other in the thickness direction of the substrate.

# FIG. 1A

# FIG. 1B

FIG. 2

FIG. 3A  FIG. 3B  FIG. 3C  FIG. 3D

| | Cathode Sheet Res. [Ω/□] | LD Contact Res.[Ω] | LD Interval [Pix.] | BP wire resistance [Ω/Pix] |
|---|---|---|---|---|
| IR-drop | | | | |

y-axis
x-axis

EP 4 598 319 A2

FIG. 4A          FIG. 4B          FIG. 4C          FIG. 4D

| Cathode Sheet Res. [Ω/□] | LD Contact Res.[Ω] | LD Interval [Pix.] | BP wire resistance [Ω/Pix] |
|---|---|---|---|

IR-drop Normalized

# FIG. 5A

Yb Ag:Mg ┄┄┄┄

Common Electrode Sheet Resistance(Ω/□) vs Common Electrode Thickness (Å)

# FIG. 5B

|  |  | Efficiency | | | |
|---|---|---|---|---|---|
|  |  | Red | Green | Blue | White |
| Common Electrode Thickness (Å) | 60 | 6.9 | 27.6 | 84.7 | 12.9 |
|  | 80 | 9.4 | 31.2 | 92.2 | 15.4 |
|  | 100 | 10.1 | 32.9 | 95.0 | 16.2 |

# FIG. 5C

# FIG. 5D

# FIG. 6A

**Common Electrode Sheet Resistance for Different Materials and Thicknesses**

# FIG. 6B

**Common Electrode Sheet Resistance for Different Materials and Thicknesses**

# FIG. 7A

OW

R1

R2

R3

ELOP (IW)

R4

Y
Z⊙ → X

# FIG. 7B

R4   R1   R2   ELOP (R3)

CME

CME

CME

EL

EL

AE

IW

OW

Z
Y⊗ → X

FIG. 7C

Focused Ion Beam (FIB) Images of OW and IW Measurements

Inner Width (IW)

7.1um

3.2um

5.3um

Outer Width (OW)

11 μm

6 μm

7 μm

FIG. 8A

FIG. 8B

FIG. 8C

FIG. 8D

# FIG. 8E

# FIG. 8F

# FIG. 8G

# FIG. 8H

**Pitch Characteristics and Hole Counts for 65-Inch Displays (3840 x 2160 Resolution)**

|  | P1<br>(Pitch = k*) | CP1<br>(1/4) | CP2<br>(1/9) | CP3<br>(1/16) |
|---|---|---|---|---|
| Process distance | 0.8-1.2 mm | 4.8-7.2 mm | 9.6-14.2 mm | 14.4-21.6 mm |
| Hole count | 921,600 | 230,400 | 102,400 | 57,600 |
| Cathode thickness (Å) | 100 | 100 | 100 | 100 | *k = a constant |

# FIG. 9

| | CL0 | CL1 | CL2 | CL3 | CL4 | CL5 | CL6 |
|---|---|---|---|---|---|---|---|
| | Display size (in.) | Pixel Pitch (mm) | Resolution | (poi) | LD interval(Pix) | LD Interval (mm) | LD Hole Count |
| RW1 | 77 | 0.443 | 3840x2160 | 57.3 | 1 | 0.443 | 8294400 |
| RW2 | 65 | 0.372 | 3840x2160 | 67.8 | 1 | 0.372 | 8294400 |
| RW3 | 55 | 0.315 | 3840x2160 | 80.6 | 1 | 0.315 | 8294400 |
| RW4 | 49 | 0.233 | 5136x1456 | 109 | 1 | 0.233 | 7478016 |
| RW5 | 34 | 0.2315 | 3456x1456 | 109.6 | 1 | 0.2315 | 5031936 |
| RW6 | 31.5 | 0.1814 | 3840x2160 | 140 | 1 | 0.1814 | 8294400 |
| RW7 | 26.5 | 0.2292 | 2560x1440 | 110.8 | 1 | 0.2292 | 3686400 |
| RW8 | 26.5 | 0.153 | 3840x2160 | 166 | 1 | 0.153 | 8294400 |
| RW9 | 26.5 | 0.1148 | 5120x2880 | 220 | 1 | 0.1148 | 14,745,600 |
| | | Pixel Pitch (mm) | Resolution | (poi) | LD interval(Pix) | LD Interval (mm) | LD Hole Count |
| RW10 | 77 | 0.443 | 3840x2160 | 57.3 | 72 | 31.896 | 1600 |
| RW11 | 65 | 0.372 | 3840x2160 | 67.8 | 72 | 26.784 | 1600 |
| RW12 | 55 | 0.315 | 3840x2160 | 80.6 | 72 | 22.68 | 1600 |
| RW13 | 49 | 0.233 | 5136x1456 | 109 | 72 | 16.776 | 1443 |
| RW14 | 34 | 0.2315 | 3456x1456 | 109.6 | 72 | 16.668 | 971 |
| RW15 | 31.5 | 0.1814 | 3840x2160 | 140 | 72 | 13.0608 | 1600 |
| RW16 | 26.5 | 0.2292 | 2560x1440 | 110.8 | 72 | 16.5024 | 711 |
| RW17 | 26.5 | 0.153 | 3840x2160 | 166 | 72 | 11.016 | 1600 |
| RW18 | 26.5 | 0.1148 | 5120x2880 | 220 | 72 | 8.2656 | 2844 |

FIG. 10A

BML

FIG. 10B

BML

CNT

GT

# FIG. 10C

CVL

# FIG. 10D

CVL

CNT

VIA

# FIG. 10E

# FIG. 11A

EP 4 598 319 A2

# FIG. 11B

FIG. 11C

# FIG. 11D

EP 4 598 319 A2

# FIG. 12A

# FIG. 12B

# FIG. 13A

H2          H1

B - - - - - - - - - - - - - - - - - - - - - - - - - - B'

Z⊙→Y
↓
X

# FIG. 13B

H2          H1          AE          PDL

PVX

CVL

Th

Z
↑
X⊙→Y

# FIG. 14

# FIG. 15

IR-drop[V] =
$$(2.083*x4 - 7.1e\text{-}3*x3 - 4.94e\text{-}05*x2 + 1.758e\text{-}05*x2*x3 + 4.3e\text{-}03*x1*x4 + 0.266 + 3.544e\text{-}04*x3^2 - 0.18*x4^2) * I /$$
(1μ *Horizontal Resolution* Vertical Resolution)

I: Pannel Current [A]
*Because IR drop was calculated with 1uA as the Unit Pixel EL Current, the calculation can be made with the measured ELVSS Panel Current(I), and dividing by 1u, Horizontal Resolution and Vertical Resolution

# FIG. 16

| x1: LD CNT Res. [Ω] | x2: Cathode Rs. [Ω/□] | 0.1 | | | | | 0.2 | | | | | 0.3 | | | | | 0.4 | | | | | x4: BP Res. [Ω] |
|---|---|---|---|---|---|---|---|---|---|---|---|---|---|---|---|---|---|---|---|---|---|---|
| | | 1 | 3 | 6 | 12 | 18 | 1 | 3 | 6 | 12 | 18 | 1 | 3 | 6 | 12 | 18 | 1 | 3 | 6 | 12 | 18 | x3: LD Interval [Pix] |
| 5 | 5 | 0.4567 | 0.4568 | 0.4570 | 0.4579 | 0.4593 | 0.6646 | 0.6647 | 0.6649 | 0.6656 | 0.6670 | 0.8636 | 0.8636 | 0.8638 | 0.8645 | 0.8659 | 1.0547 | 1.0548 | 1.0550 | 1.0557 | 1.0571 | |
| | 30 | 0.4612 | 0.4613 | 0.4617 | 0.4633 | 0.4676 | 0.6793 | 0.6795 | 0.6799 | 0.6814 | 0.6857 | 0.8949 | 0.8951 | 0.8954 | 0.8970 | 0.9016 | 1.1087 | 1.1088 | 1.1092 | 1.1108 | 1.1154 | |
| | 50 | 0.4615 | 0.4617 | 0.4623 | 0.4646 | 0.4712 | 0.6806 | 0.6807 | 0.6813 | 0.6836 | 0.6904 | 0.8976 | 0.8977 | 0.8983 | 0.9006 | 0.9076 | 1.1133 | 1.1135 | 1.1140 | 1.1163 | 1.1235 | |
| 100 | 5 | 0.4568 | 0.4578 | 0.4606 | 0.4712 | 0.4889 | 0.6647 | 0.6656 | 0.6682 | 0.6784 | 0.6954 | 0.8637 | 0.8645 | 0.8670 | 0.8768 | 0.8933 | 1.0548 | 1.0556 | 1.0580 | 1.0675 | 1.0834 | |
| | 30 | 0.4613 | 0.4622 | 0.4651 | 0.4769 | 0.4982 | 0.6794 | 0.6803 | 0.6832 | 0.6950 | 0.7161 | 0.8950 | 0.8959 | 0.8988 | 0.9105 | 0.9317 | 1.1088 | 1.1096 | 1.1125 | 1.1241 | 1.1454 | |
| | 50 | 0.4616 | 0.4626 | 0.4657 | 0.4782 | 0.5019 | 0.6807 | 0.6816 | 0.6847 | 0.6972 | 0.7209 | 0.8977 | 0.8986 | 0.9017 | 0.9141 | 0.9380 | 1.1134 | 1.1143 | 1.1174 | 1.1298 | 1.1538 | |
| 200 | 5 | 0.4570 | 0.4587 | 0.4641 | 0.4850 | 0.5193 | 0.6648 | 0.6664 | 0.6716 | 0.6917 | 0.7247 | 0.8638 | 0.8653 | 0.8702 | 0.8895 | 0.9215 | 1.0549 | 1.0564 | 1.0611 | 1.0798 | 1.1107 | |
| | 30 | 0.4614 | 0.4631 | 0.4687 | 0.4912 | 0.5304 | 0.6795 | 0.6812 | 0.6868 | 0.7092 | 0.7481 | 0.8951 | 0.8968 | 0.9023 | 0.9246 | 0.9635 | 1.1089 | 1.1105 | 1.1160 | 1.1381 | 1.1769 | |
| | 50 | 0.4617 | 0.4635 | 0.4693 | 0.4926 | 0.5341 | 0.6808 | 0.6825 | 0.6883 | 0.7114 | 0.7531 | 0.8978 | 0.8995 | 0.9053 | 0.9283 | 0.9700 | 1.1135 | 1.1152 | 1.1210 | 1.1440 | 1.1857 | |
| 500 | 5 | 0.4573 | 0.4614 | 0.4745 | 0.5254 | 0.6050 | 0.6651 | 0.6690 | 0.6816 | 0.7305 | 0.8072 | 0.8641 | 0.8677 | 0.8798 | 0.9271 | 1.0010 | 1.0552 | 1.0587 | 1.0704 | 1.1160 | 1.1874 | |
| | 30 | 0.4617 | 0.4702 | 0.4795 | 0.5341 | 0.6267 | 0.6798 | 0.6839 | 0.6707 | 0.7518 | 0.8439 | 0.8954 | 0.8994 | 0.9129 | 0.9669 | 1.0586 | 1.1092 | 1.1132 | 1.1266 | 1.1802 | 1.2714 | |
| | 50 | 0.4620 | 0.4662 | 0.4801 | 0.5356 | 0.6309 | 0.6811 | 0.6852 | 0.7168 | 0.7543 | 0.8495 | 0.8981 | 0.9022 | 0.9159 | 0.9710 | 1.0660 | 1.1138 | 1.1179 | 1.1316 | 1.1865 | 1.2813 | |
| 1000 | 5 | 0.4579 | 0.4658 | 0.4917 | 0.5892 | 0.7296 | 0.6657 | 0.6732 | 0.6832 | 0.7920 | 0.9273 | 0.8645 | 0.8718 | 0.8957 | 0.9864 | 1.1170 | 1.0557 | 1.0626 | 1.0857 | 1.1732 | 1.2995 | |
| | 30 | 0.4622 | 0.4702 | 0.4973 | 0.6055 | 0.7857 | 0.6803 | 0.6883 | 0.6863 | 0.8227 | 1.0018 | 0.8959 | 0.9039 | 0.9306 | 1.0373 | 1.2155 | 1.1097 | 1.1175 | 1.1441 | 1.2502 | 1.4273 | |
| | 50 | 0.4625 | 0.4707 | 0.4980 | 0.6073 | 0.7918 | 0.6816 | 0.6896 | 0.7168 | 0.8257 | 1.0097 | 0.8986 | 0.9066 | 0.9337 | 1.0421 | 1.2256 | 1.1143 | 1.1223 | 1.1493 | 1.2573 | 1.4402 | |

| Region 1 Acceptable IR DROP | Region 2 Possibly Unacceptable IR DROP |

EP 4 598 319 A2

# FIG. 17

17000

17001 — Form an emission layer over an auxiliary electrode of a display panel, the display panel including a plurality of pixel electrode sets

17002 — Form a plurality of emission-layer openings in the emission layer, using a laser

17003 — Form a common electrode over the emission layer, such that the common electrode electrically contacts the auxiliary electrode

FIG. 18A

FIG. 18B

EP 4 598 319 A2

# FIG. 19A

PW Max ELVDD(V)

# FIG. 19B

PW min ELVDD(V)

# FIG. 19C

# FIG. 19D

# FIG. 20

LRU Measurement Result (9 points)

| L/D 3x3 | | |
|---|---|---|
| 90.00% | 91.80% | 90.30% |
| 97.10% | 93.80% | 96.10% |
| 95.30% | 100.00% | 95.00% |

Luminance Long Range Uniformity (LRU):
(MIN/MAX) x 100 of 9 points on the Display Panel

# FIG. 21

Measurement of 9 points on the Display Panel

LD Interval 3x3

# FIG. 22